# EUROPEAN PATENT APPLICATION

(11) **EP 4 664 198 A2**
(43) Date of publication of application: **17.12.2025**
(21) Application number: 25181230.1
(22) Date of filing: 06.06.2025
(51) Int. Cl.: G03F 7/09, G03F 7/004

(54) **COMPOSITION FOR FORMING ORGANIC FILM, METHOD FOR FORMING ORGANIC FILM, PATTERN FORMING METHOD, AND POLYMER**

(30) Priority: 11.06.2024 JP 2024094234
(71) Applicant: SHIN-ETSU CHEMICAL CO., LTD., Tokyo 1000005 (JP)
(72) Inventor: Kori, Daisuke, Niigata (JP); Yamamoto, Yasuyuki, Niigata (JP)
(74) Representative: Schicker, Silvia

(57) **Abstract**

A composition for forming an organic film, containing: (A) a resin or compound for forming an organic film; (B) a polymer having a repeating unit of a partial structure (a1) represented by the following general formula (1); and (C) a solvent. This can provide a composition for forming an organic film, having excellent film-forming properties (in-plane uniformity) and embedding properties on a substrate (wafer), suppressing humps during an EBR step, and having excellent process tolerance when used as an organic underlayer film for a multi-layer resist, and to provide a method for forming an organic film and a pattern forming method using the composition. 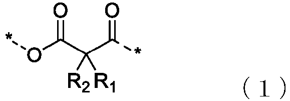 wherein R₁ and R₂ are hydrogen atoms or saturated or unsaturated organic groups having 1 to 20 carbon atoms, and have at least one fluorine-containing structure represented by the following general formula (2), at least one of R₁ and R₂ is an organic group that is not a hydrogen atom, and * represents an attachment point.

## Description

### TECHNICAL FIELD

As LSIs become more highly integrated and faster, pattern rules are becoming finer at a rapid pace. This is because 5G high-speed communications and artificial intelligence (AI) are becoming more widespread, and high-performance devices are needed to process these. The most advanced miniaturization technology is extreme ultraviolet (EUV) lithography with a wavelength of 13.5 nm, which is used to mass-produce 5 nm node devices. Further, the use of EUV lithography is being considered for next-generation 3 nm node and subsequent next-generation 2 nm node devices.

As resist patterns become thinner in this way, it becomes difficult to form patterns using the single-layer resist method, which is typically used as a method for forming resist patterns. As a method for processing fine patterns, it is known that a multi-layer resist method is superior, in which a pattern is formed by stacking films with different dry etching properties in order to form a pattern with a high aspect ratio on a stepped substrate. A three-layer resist method (Patent Document 1), which combines a photoresist layer made of an organic photosensitive polymer used in the single-layer resist method, an intermediate layer made of a silicon-based polymer or a silicon-based CVD film, and a underlayer made of an organic polymer, has been developed and put into practical use.

In this three-layer resist method, for example, an organic film made of novolac or the like is uniformly formed on the substrate to be processed as the resist underlayer film, a silicon-containing film is formed thereon as the resist intermediate film and a typical organic photoresist film is formed thereon as the resist upper layer film. When dry etching is performed with fluorine-based gas plasma, the organic resist upper layer film has a favorable etching selectivity to the silicon-containing resist intermediate film, and thus the resist pattern is transferred to the silicon-containing resist intermediate film by dry etching with fluorine-based gas plasma. According to this method, when a resist composition that is difficult to form a pattern with a sufficient film thickness for directly processing a substrate to be processed or a resist composition that does not have sufficient dry etching resistance for processing a substrate is used, a pattern can be transferred to a silicon-containing film, and then, performing pattern transfer using dry etching with oxygen-based gas plasma allows a novolac film pattern having sufficient dry etching resistance for processing to be obtained.

Many technologies for organic underlayer films such as those described above are already known (for example, Patent Document 2), but with the recent advances in miniaturization, there is an increasing need for excellent embedding properties in addition to dry etching properties. There is a need for organic underlayer film materials that allows uniform film formation even on the underlying substrate to be processed with complex shapes and materials, and that have embedding properties that allows the required pattern to be embedded without voids.

The organic underlayer film described above is formed using a coater/developer capable of performing processes such as spin coating step, EBR step, and baking step when manufacturing semiconductor substrates and the like. The EBR (Edge Bead Removal) step is a step in which a coating is formed on the substrate (wafer) by spin coating, and then the coating on the edge of the substrate is removed with a remover to prevent contamination of the substrate transfer arm of the coater/developer.

The remover used in the EBR step is a mixture of propylene glycol monomethyl ether acetate and propylene glycol monomethyl ether (30% by mass:70% by mass), which is widely used in the EBR step of resist films and resist underlayer films (silicon-containing intermediate films and organic underlayer films).

The remover used in the EBR step can cause the outer periphery of the organic underlayer film to become thicker (a hump). Humps can cause defects in the dry etching step used in substrate processing as described above, and thus there is a demand for organic underlayer films that suppress humps.

For resist materials used in photolithography using not only the organic underlayer film but also the organic photosensitive polymers described above, the solution is coated by the method such as spin coating in the same manner as the organic underlayer film, and then baked to evaporate the solvent to form a film. Like the organic underlayer film, the film thickness after baking must be uniform and flat, and the requirements for uniformity and flatness are becoming stricter every year.

### BACKGROUND ART

In recent years, there has been a demand for thicker resist films for 3D-NAND memory applications, which requires even greater flatness. As the film thickness increases, it becomes more difficult to achieve flatness within the film. On the other hand, as miniaturization progresses, the film thickness is becoming thinner, which increases the risk of pinhole defects and the like.

The examples of film materials using organic substances used in semiconductor processing materials are described as above, but for film-forming materials that do not use organic substances, obtaining a material that forms a film with in-plane uniformity in film thickness and without pinholes is a great industrial advantage.

In recent years, the health effects of perfluoroalkyl compounds (PFAS) have been pointed out, and there are moves to impose restrictions on the manufacturing and sale of PFAS compounds under the EU REACH. Perfluoroalkyl compounds have a wide range of uses, and because of their properties due to their structure, such as repelling water and oil, being resistant to heat and chemicals, and not absorbing light, the perfluoroalkyl compounds are used in a wide range of applications such as water repellents, surface treatment agents, emulsifiers, fire extinguishing agents, and coating agents, and thus there is an urgent need to develop alternative materials that do not have the PFAS structure.

As an example of the above-described material using a perfluoroalkyl compound, a surfactant having a fluoroalkyl group or a silicone chain is highly effective in reducing surface tension, and especially, fluoroalkyl group-based surfactants, which have a low risk of generating silicon-derived particles after dry ashing of the resist film, are widely used (Patent Document 3 and 4). Further, fluorine-based surfactants are used not only in resist materials, but also in topcoats formed on the top layer of the resist and in bottom antireflective films formed on the bottom layer of the resist (Patent Document 5).

In view of future tightening of regulations, it is necessary to use materials that do not fall under PFAS regulations. For example, surfactants having a trifluoromethoxy group or a pentafluorosulfanyl group and the use of these have been proposed as the surfactants described above (Patent Document 6). In addition, in the field of resist materials, resist materials using photoacid generators have also been proposed (Patent Document 7).

### CITATION LIST

### PATENT LITERATURE

Patent Document 1: JP 4355943 B
Patent Document 2: JP 2004-205685 A
Patent Document 3: JP H6-186735 A
Patent Document 4: JP H6-214380 A
Patent Document 5: JP 2010-139822 A
Patent Document 6: JP 2008-526792 A
Patent Document 7: WO 2023-223624 A1

### SUMMARY OF INVENTION

### TECHNICAL PROBLEM

The present invention has been made in consideration of the above circumstances, and an object thereof is to provide a composition for forming an organic film, the composition having excellent film-forming properties (in-plane uniformity) and embedding properties on a substrate (wafer), suppressing humps during the EBR step, and having excellent process tolerance when used as an organic underlayer film for a multilayer resist, and a method for forming an organic film, a pattern forming method using this composition, and a polymer.

### SOLUTION TO PROBLEM

In order to achieve the above object, the present invention provides
a composition for forming an organic film, containing:
   (A) a resin or compound for forming an organic film;
   (B) a polymer having a partial structure (a1) represented by the following general formula (1) as a repeating unit; and
   (c) a solvent, 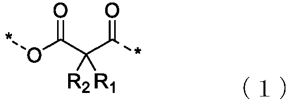
wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 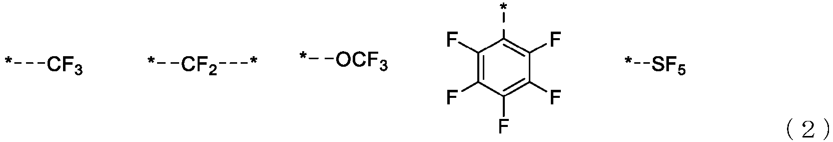
wherein * represents an attachment point.

When the composition for forming an organic film contains a polymer having such a partial structure in the repeating unit, the surfactant effect required for forming an organic film can be imparted by introducing a specific fluorine structure into the repeating unit of the polymer, and the film-forming properties at the time of coating can be improved. When an appropriate structure, such as pentafluorobenzene or a pentafluorosulfanyl group, is selected as the structure represented by R₁ and R₂ in the present invention, the structure does not belong to the PFAS classification and is therefore advantageous from the viewpoint of preventing environmental pollution, and can be expected to be a highly versatile material as a surfactant for organic films.

In addition, it is preferable that the repeating unit (a1) of the polymer (B) is a repeating unit represented by the following general formula (3) or (4): 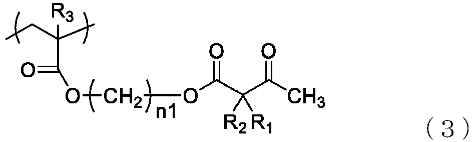
wherein R₁ and R₂ are as defined above, R₃ represents a hydrogen atom or a methyl group, and n1 represents an integer of 2 to 10, 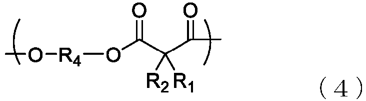
wherein R₁ and R₂ are as defined above, R₄ represents a divalent organic group having 2 to 30 carbon atoms, and may contain an ether bond, an ester bond, an amide bond, or a sulfide bond.

When the composition for forming an organic film contains a polymer having such a structure, the interaction of the fluorine structure can be enhanced by the action of the substituents R₁ and R₂ in the repeating unit, and favorable performance as a surfactant can be imparted, and thus the organic film-forming material of the present invention can provide an organic film-forming material with excellent film-forming properties when various polymers and compounds are used.

In addition, it is preferable that the polymer (B) is a copolymer having repeating units of the general formula (3) and the following general formula (5): 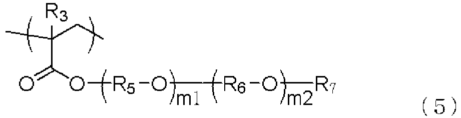 wherein R₃ is as defined above, R₅ and R₆ are each a straight-chain or branched divalent alkylene group having 1 to 4 carbon atoms, R₇ is a hydrogen atom, or an alkyl group having 1 to 4 carbon atoms, or a phenyl group, m1 is 0 to 23, m2 is 0 to 23, and 23 ≥ m1 + m2 ≥ 2.

As described above, the composition for forming an organic film according to the present invention is an organic film-forming material with excellent film-forming properties, and the material is formed into a copolymer containing a repeating unit having a linking group such as (5) above, whereby the repeating unit (5) contributes as a relaxation unit of an appropriate aggregation structure, allowing the surface activity to be adjusted. As a result, it is possible to provide an organic film-forming material that is applicable to a variety of film thicknesses (independent of solution concentration) and that achieve both embedding properties and film-forming properties.

In addition, it is preferable that the fluorine-containing organic group represented by R₁ or R₂ of the polymer (B) has at least one structure represented by any one of the following general formulae (6):

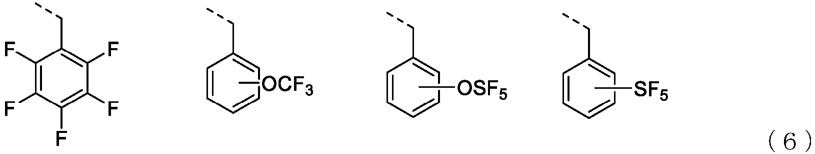

As described above, chemical substance management regarding PFAS regulations has been strengthened, and the fluorine atom, a pentasulfanyl group, and an aromatic group substituted with a pentasulfanyl group shown above do not belong to the PFAS classification in REACH. In addition, a difluoromethoxy group and an aromatic group substituted with fluorine atoms do not belong to the PFAS classification in OECD. Therefore, the composition for forming an organic film using the polymer of the present invention as a surfactant not only imparts excellent film-forming properties, but is also expected to be an environmentally harmonized material that is environmentally friendly.

Further, the weight average molecular weight of the polymer (B) is preferably 1500 to 30000.

Within this range of weight average molecular weight, it is possible to form an organic film with excellent film-forming properties and embedding properties. In addition, the contact angle of the film surface after film formation can be controlled within an appropriate range, allowing formation of an organic underlayer film suitable for use in a multilayer resist process.

Further, when the resin or compound for forming an organic film (A) has 100 parts by mass, the content of the polymer (B) is preferably 0.01 parts by mass to 5 parts by mass.

A composition for forming an organic film, containing the polymer in such a content is preferable because the formed organic film has more favorable in-plane uniformity.

In addition, the present invention provides a method for forming an organic film used in a process for manufacturing a semiconductor device, the method including spin-coating the above-described composition for forming an organic film on a body to be processed, and heat-treating the substrate on which the composition for forming an organic film has been coated at a temperature of 100°C or more and 600°C or less for a period of 10 to 600 seconds, thereby forming a cured film.

The composition for forming an organic film according to the present invention is particularly useful when embedding a pattern of a complex shape on a substrate to be processed by spin coating, forming an organic film with excellent in-plane uniformity, and removing the organic film at the edge while suppressing humps in the EBR step.

The present invention provides a pattern forming method, the method comprising: forming an organic film on a body to be processed using the above composition for forming an organic film; forming a silicon-containing resist intermediate film on the organic film using a silicon-containing resist material containing silicon atoms; forming a resist upper layer film on the silicon-containing resist intermediate film using a resist upper layer film material including a photoresist composition; forming a circuit pattern on the resist upper layer film; transferring a pattern by etching to the silicon-containing resist intermediate film using the resist upper layer film on which the circuit pattern is formed as a mask; transferring a pattern by etching to the organic film using the silicon-containing resist intermediate film in which the pattern is transferred as a mask; and further transferring a pattern by etching to the body to be processed using the organic film in which the pattern is transferred as a mask.

The composition for forming an organic film according to the present invention can be suitably used in the pattern forming method using a three-layer resist process using such a silicon-containing resist intermediate film.

In addition, the present invention provides a pattern forming method including: forming an organic film on a body to be processed using the above composition for forming an organic film; forming a silicon-containing resist intermediate film on the organic film using a silicon-containing resist material containing silicon atoms; forming an organic antireflective film or an adhesive film on the silicon-containing resist intermediate film; forming a resist upper layer film on the organic antireflective film or the adhesive film using a resist upper layer film material including a photoresist composition; forming a circuit pattern on the resist upper layer film; transfer a pattern by etching to the organic antireflective film or the adhesive film and the silicon-containing resist intermediate film using the resist upper layer film on which the circuit pattern is formed as a mask; transferring a pattern by etching to the organic film using the silicon-containing resist intermediate film in which the pattern is transferred as a mask; and further transferring a pattern by etching to the body to be processed using the organic film in which the pattern is transferred as a mask.

The composition for forming an organic film according to the present invention can be suitably used in the pattern forming method using a four-layer resist process using such a silicon-containing resist intermediate film and an organic antireflective film or adhesive film.

In addition, the present invention provides the pattern forming method including: forming an organic film on a body to be processed using the above composition for forming an organic film; forming an inorganic hard mask intermediate film selected from a silicon oxide film, a silicon nitride film, and a silicon oxide nitride film on the organic film; forming a resist upper layer film on the inorganic hard mask intermediate film using a resist upper layer film material including a photoresist composition; forming a circuit pattern on the resist upper layer film; transferring a pattern by etching to the inorganic hard mask intermediate film using the resist upper layer film on which the circuit pattern is formed as a mask; transferring a pattern by etching to the organic film using the inorganic hard mask intermediate film in which the pattern is transferred as a mask; and further transferring a pattern by etching to the body to be processed using the organic film in which the pattern is transferred as a mask.

The composition for forming an organic film according to the present invention can be suitably used in the pattern forming method using a three-layer resist process using such an inorganic hard mask intermediate film.

In addition, the present invention provides a pattern forming method including: forming an organic film on a body to be processed using the above composition for forming an organic film; forming an inorganic hard mask intermediate film selected from a silicon oxide film, a silicon nitride film, and a silicon oxide nitride film on the organic film; forming an organic antireflective film or an adhesive film on the inorganic hard mask intermediate film; forming a resist upper layer film on the organic antireflective film or the adhesive film using a resist upper layer film material including a photoresist composition; forming a circuit pattern on the resist upper layer film; transferring a pattern by etching to the organic antireflective film or the adhesive film and the inorganic hard mask intermediate film using the resist upper layer film in which the circuit pattern is formed as a mask; transferring a pattern by etching to the organic film using the inorganic hard mask intermediate film in which the pattern is transferred as a mask; and further transferring a pattern by etching to the body to be processed using the organic film in which the pattern is transferred as a mask.

The composition for forming an organic film according to the present invention can be suitably used in the pattern forming method using a four-layer resist process using such an inorganic hard mask intermediate film and an organic antireflective film or adhesive film.

Thus, the composition for forming an organic film according to the present invention can be suitably used in various methods for forming a pattern, such as a three-layer resist process using a silicon-containing resist intermediate film or an inorganic hard mask intermediate film, and a four-layer resist process using an organic antireflection film or an adhesive film in addition to these, and such a pattern forming method according to the present invention can transfer and form the circuit pattern of the resist upper layer film on the body to be processed with high precision.

In addition, the inorganic hard mask intermediate film is preferably formed by a CVD method or an ALD method.

In the pattern forming method according to the present invention, for example, an inorganic hard mask intermediate film can be formed by such a method.

In addition, in forming the circuit pattern, the circuit pattern can be formed by lithography using light having a wavelength of 10 nm or more and 300 nm or less, direct drawing by an electron beam, nanoimprinting, or a combination thereof.

In the pattern forming method according to the present invention, the circuit pattern can be formed by such a method.

In addition, in forming the circuit pattern, it is preferable to develop the circuit pattern by an alkali developer or an organic solvent.

In the pattern forming method according to the present invention, forming means and developing means of such a circuit pattern can be suitably used.

In addition, provided is the above pattern forming method, in which the body to be processed is a semiconductor device substrate, or the semiconductor device substrate on which any one of a metal film, a metal carbide film, a metal oxide film, a metal nitride film, a metal oxide carbide film, and a metal oxide nitride film is formed.

With the pattern forming method according to the present invention, a pattern can be formed by processing the body to be processed as described above.

There is provided a pattern forming method using, as the metal constituting the body to be processed, silicon, titanium, tungsten, hafnium, zirconium, chromium, germanium, copper, silver, gold, aluminum, indium, gallium, arsenic, palladium, iron, tantalum, iridium, molybdenum, or an alloy thereof.

In the pattern forming method according to the present invention, a pattern can be formed by using the above metal.

The present invention provides a polymer that has a partial structure (a1) represented by the following general formula (1) as a repeating unit: 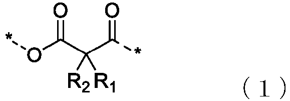
wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 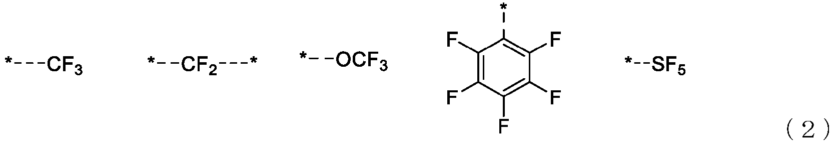
wherein * represents an attachment point.

The present invention provides a polymer in which the repeating unit (a1) of the polymer is a repeating unit represented by the following general formula (3) or (4): 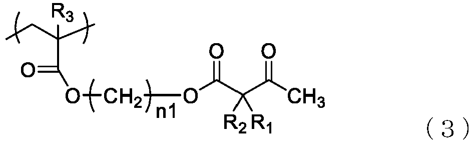
wherein R₁ and R₂ are as defined above, R₃ represents a hydrogen atom or a methyl group, and n1 represents an integer of 2 to 10, 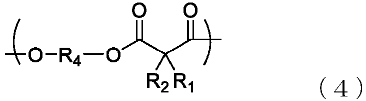
wherein R₁ and R₂ are as defined above, R₄ represents a divalent organic group having 2 to 30 carbon atoms, and may contain an ether bond, an ester bond, an amide bond, or a sulfide bond.

A polymer having such a structure can enhance the interaction due to an action of R₁ and R₂ including fluorine atoms that are the substituents in the repeating unit, and can impart favorable film-forming properties when the polymer of the present invention is used as a surfactant.

In this case, it is preferable that the polymer is a copolymer having the repeating units of the above general formula (3) and the following general formula (5). 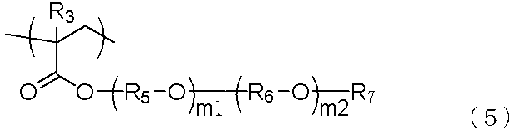 wherein R₃ is as defined above, R₅ and R₆ are each a liner-chain or branched divalent alkylene group having 1 to 4 carbon atoms, R₇ is a hydrogen atom, an alkyl group having 1 to 4 carbon atoms, or a phenyl group, m1 is 0 to 23, m2 is 0 to 23, and 23 ≥ m1 + m2 ≥ 2.

As described above, a copolymer including a repeating unit such as that shown in (5) functions as a unit that relaxes the aggregate structure of the a repeating unit containing a fluorine unit when the polymer of the present invention is used as a surfactant, and it can be expected to be a material that can form a film without depending on organic compounds or resins when the polymer of the present invention is used as a surfactant.

In addition, it is preferable that the fluorine-containing structure represented by R₁ or R₂ of the polymer has at least one structure of the following general formula (6).

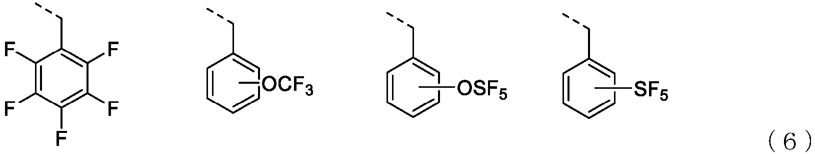

As described above, a polymer having a fluorine structure such as the above can be expected to be a material with low environmental impact. In particular, the polymer can be expected to be an environmentally harmonized material that can comply with recent PFAS regulations.

### ADVANTAGEOUS EFFECTS OF INVENTION

As described above, the present invention can provide the composition for forming an organic film, in which the film-forming properties (in-plane uniformity) and embedding properties on a substrate (wafer) are excellent, and the film-forming properties on an organic film when used as an organic underlayer film are excellent, and humps during the EBR step are suppressed. Further, the copolymer which is formed by combining specific units, allowing achievement of application to various organic film-forming materials. In particular, the composition for forming an organic film according to the present invention is excellent in film-forming properties, embedding properties, and hump suppression properties that occur during the EBR step, and is therefore extremely useful as an organic film material for use in a multilayer resist process, such as a two-layer resist process, a three-layer resist process using a silicon-containing resist intermediate film or an inorganic hard mask intermediate film, or a four-layer resist process using a silicon-containing resist intermediate film or an inorganic hard mask intermediate film and an organic antireflection film, or as a film-forming material for semiconductor device manufacturing, such as a photoresist material or a silicon-containing resist intermediate film material. Therefore, the organic film-forming method of the present invention can form an organic film with suppressed humps, thereby allowing efficient manufacturing of semiconductor elements and the like.

### BRIEF DESCRIPTION OF DRAWINGS

FIG. 1 is an example of a graph in which hump height was measured using a contact profiler in a composition for forming an organic film in which humps were suppressed;
FIG. 2 is an example of a graph in which hump height was measured using a contact profiler in a composition for forming an organic film in which humps were not suppressed;
FIG. 3 is an explanatory view of an example of a pattern forming method using the three-layer resist process of the present invention; and
FIG. 4 is an explanatory view of a method for evaluating embedding properties in the examples.

### DESCRIPTION OF EMBODIMENTS

The present invention will be described in more detail below. As described above, there has been a demand for a material that not only provides film-forming properties as an organic film material, but also has a surfactant effect with a low environmental impact in particular. In addition, there has been a demand for development of a composition for forming an organic film, in which the film-forming properties (in-plane uniformity) and embedding properties are excellent on a substrate (wafer) when the organic film material is used as an organic underlayer film material, and humps during the EBR step are suppressed.

Typically, when forming an organic film, the resin for forming the organic film and additives are dissolved in an organic solvent to form a composition, which is coated to a substrate on which structures, wiring, or the like are formed using a coater/developer, the composition is spread as the substrate rotates, and the composition at the edges is removed in the EBR step, after which the organic film is formed by baking. When the surfactant effect of the composition is insufficient, the surfactant will be unevenly distributed in the film, causing voids to be formed when embedding holes or trenches with significantly high aspect ratios, and when the resin for forming the organic film and additives have poor solubility in the remover used in the EBR step, humps are considered to be formed on the outer periphery of the organic film. The inventors further performed intensive research and found that blending a polymer having a specific repeating unit into a composition for forming an organic film results in a composition for forming an organic film in which the film-forming properties, high-level embedding properties, and hump suppression during the EBR step are excellent, and thus completed the present invention. In addition, by selecting a specific substituent structure, it is expected that the environmental impact is reduced, and the composition for forming an organic film is industrially useful.

That is, the present invention is a composition for forming an organic film, containing:
(A) a resin or compound for forming an organic film;
(B) a polymer having a repeating unit of the partial structure (a1) represented by the following general formula (1); and
(C) a solvent,

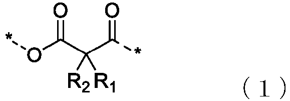

wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 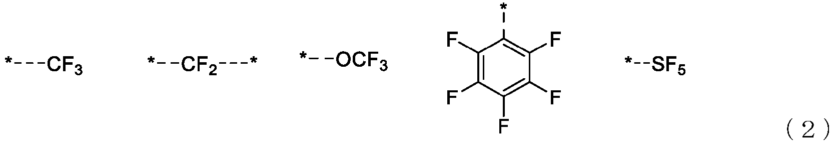
wherein * represents an attachment point.

In addition, the present invention is a polymer having a partial structure (a1) represented by the following general formula (1) as a repeating unit. 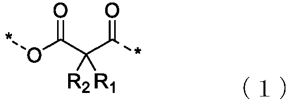
wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 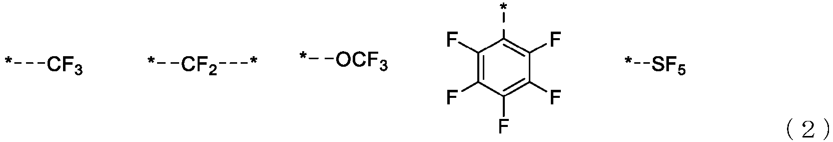
wherein * represents an attachment point.

The present invention will be described in detail below, but the present invention is not limited thereto.

### [Polymer (B)]

The polymer (B) of the present invention is a polymer having a partial structure (a1) represented by the following general formula (1) as a repeating unit: 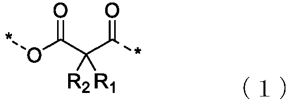
wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 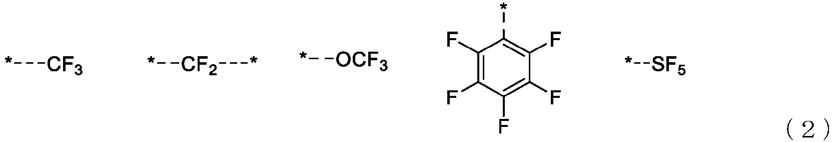
wherein * represents an attachment point.

The fluorine-containing substituents R₁ and R₂ included in the repeating units of the polymer (B) are preferably aromatic groups substituted with fluorine atoms, aromatic groups substituted with trifluoromethoxy groups, aromatic groups substituted with pentafluorosulfanyl groups, and aromatic groups substituted with pentafluorosulfanyloxy groups, as shown below.

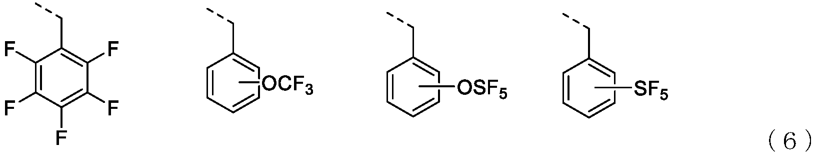

The above structure does not subject to under the PFAS regulations, and thus can be expected to be used as a polymer for organic film forming materials having a fluorine structure.

The repeating unit (a1) of the polymer (B) is preferably a repeating unit represented by the following general formula (3) or (4): 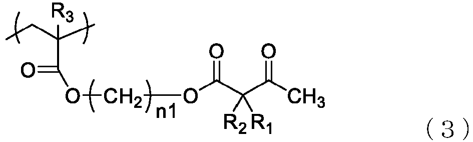
wherein R₁ and R₂ are as defined above, R₃ represents a hydrogen atom or a methyl group, and n1 represents an integer of 2 to 10, 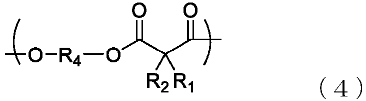
wherein R₁ and R₂ are as defined above, and R₄ represents a divalent organic group having 2 to 30 carbon atoms and may contain an ether bond, an ester bond, an amide bond, or a sulfide bond.

### [Polymer: Polymer (a1-1) having repeating unit represented by general formula (3)]

Monomers used to obtain polymer (a1-1) having a repeating unit represented by the general formula (3) include, but are not limited to, those shown below. In the following formula, R₁ is as defined above.

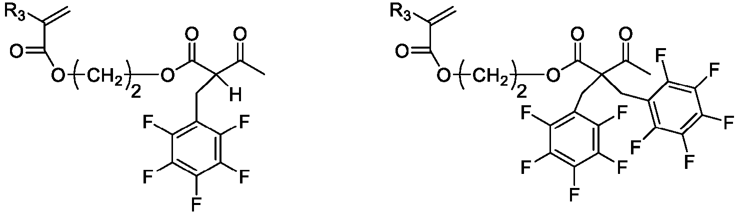

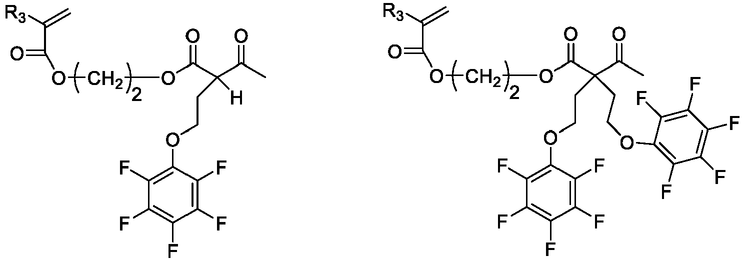

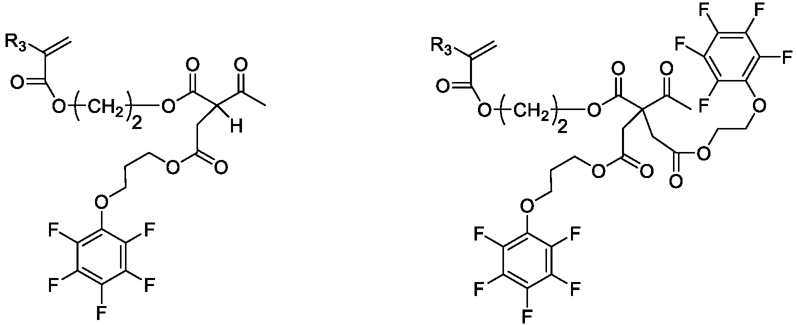

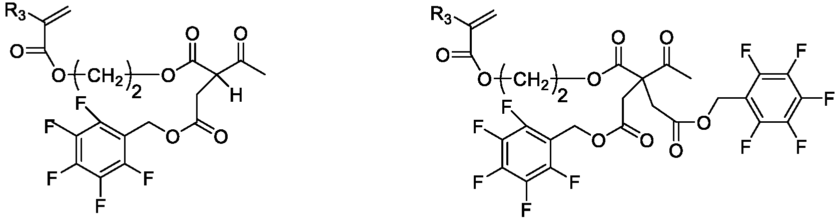

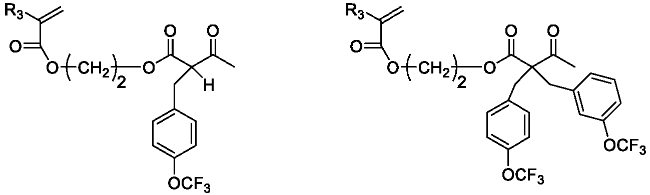

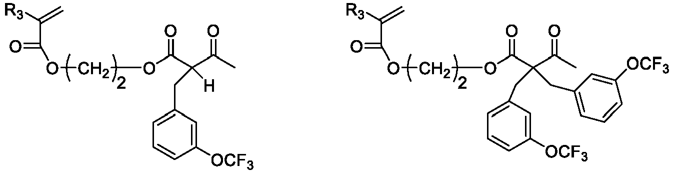

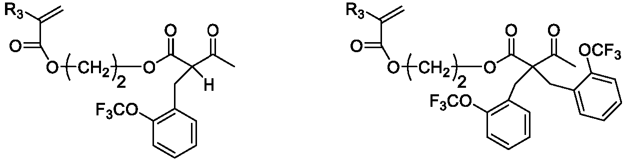

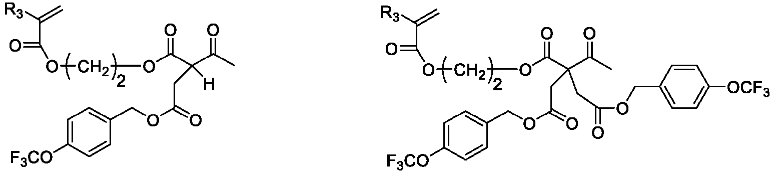

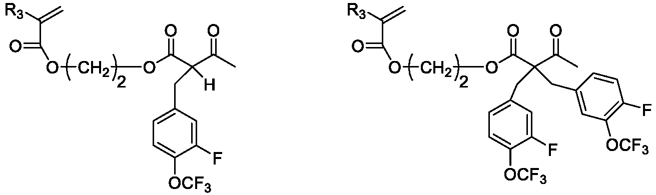

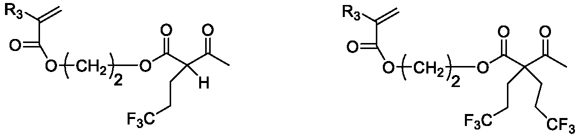

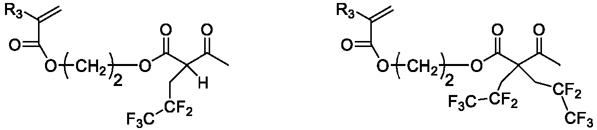

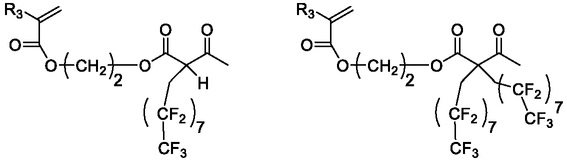

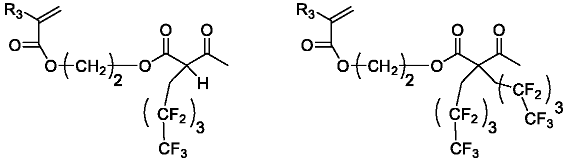

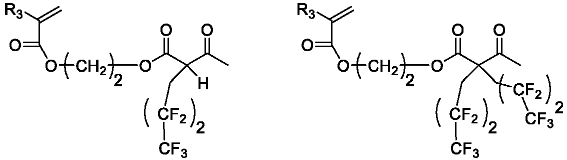

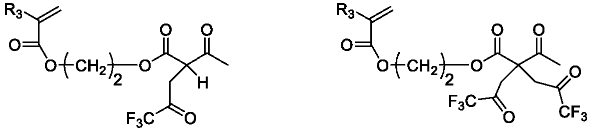

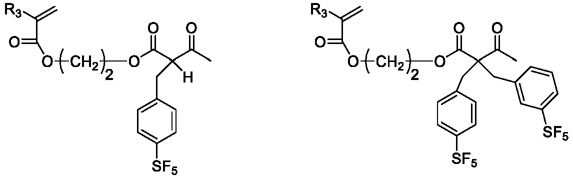

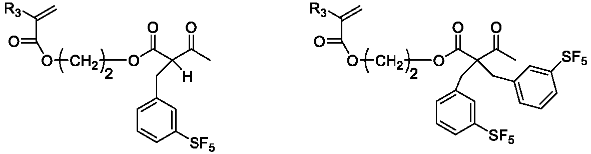

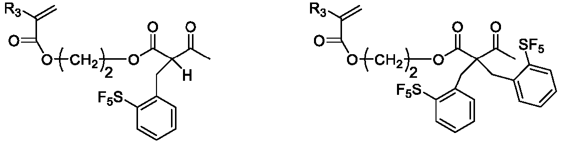

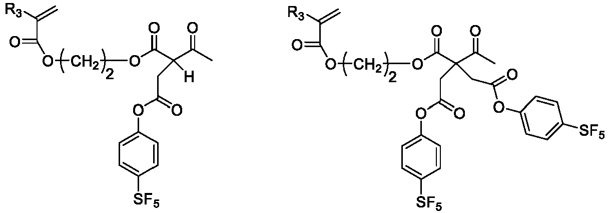

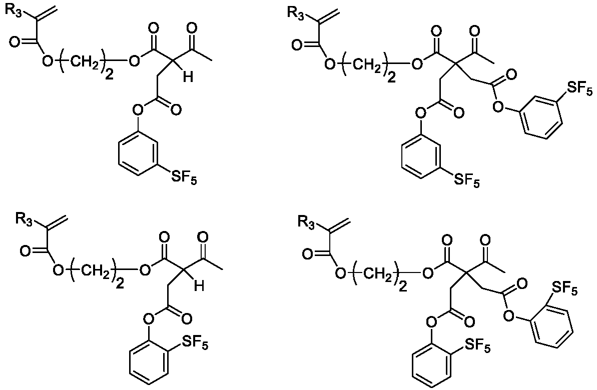

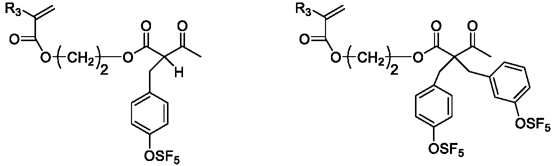

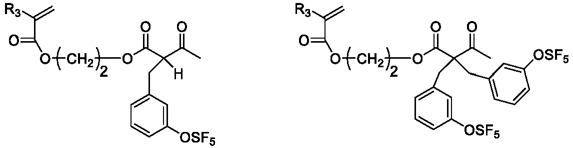

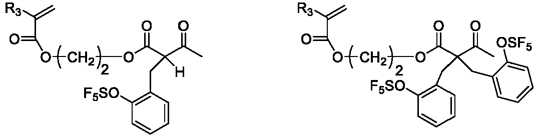

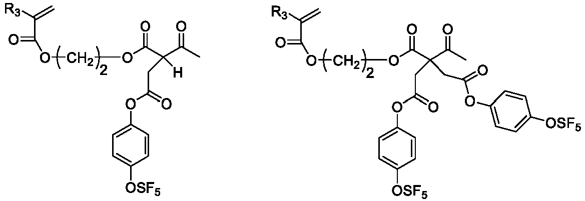

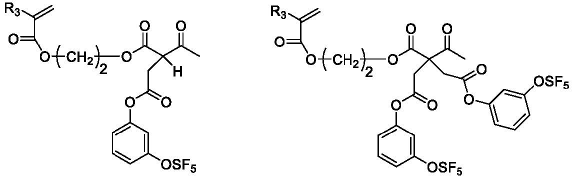

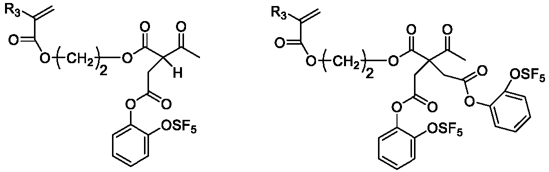

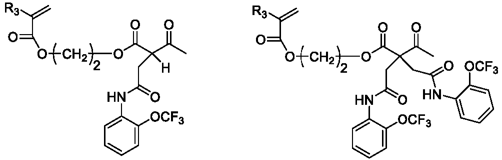

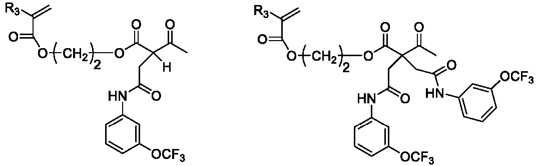

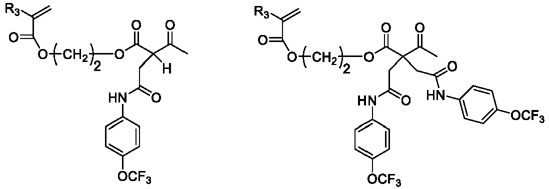

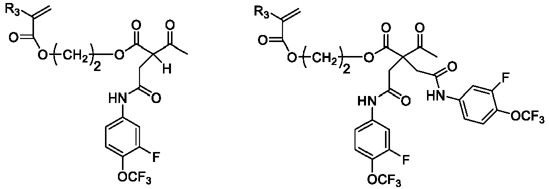

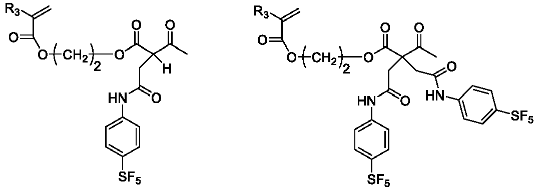

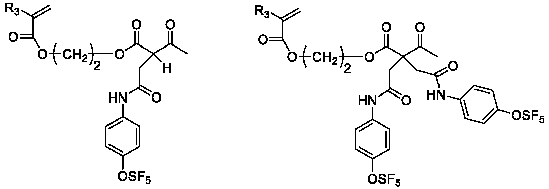

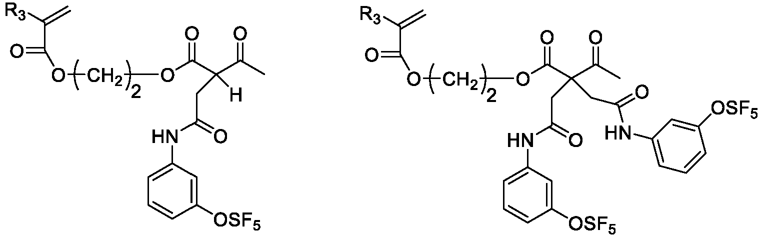

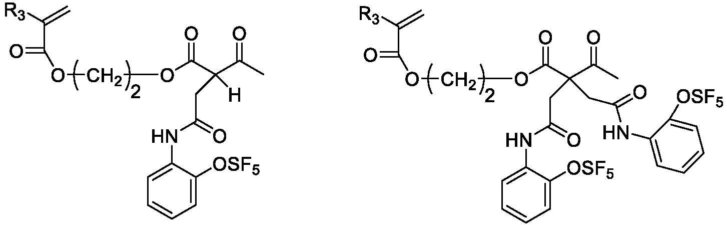

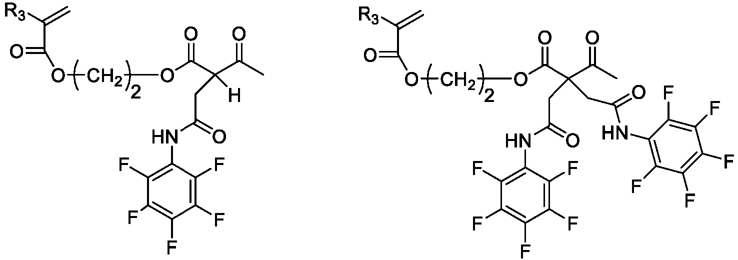

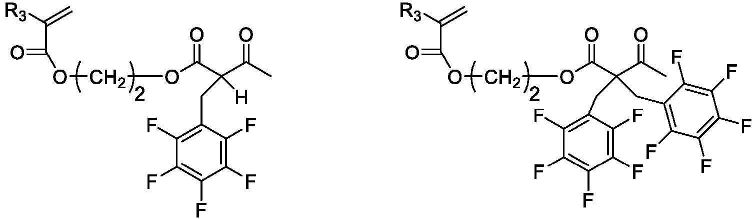

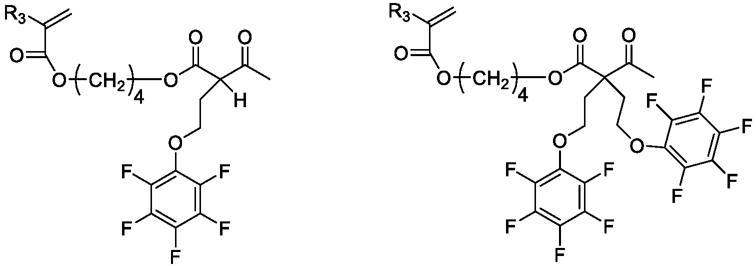

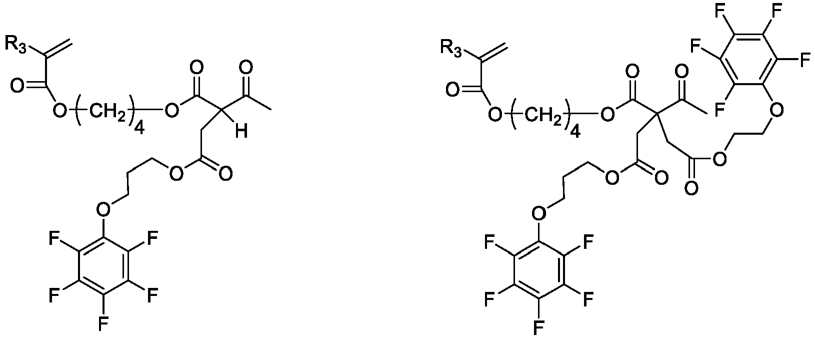

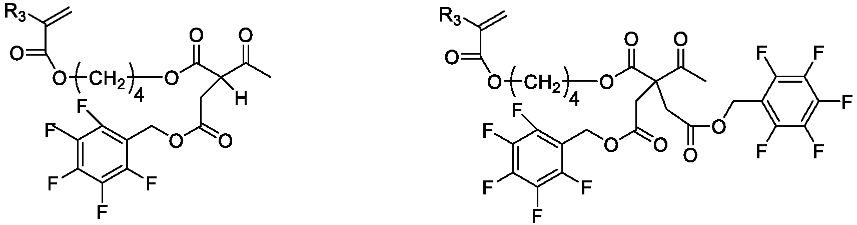

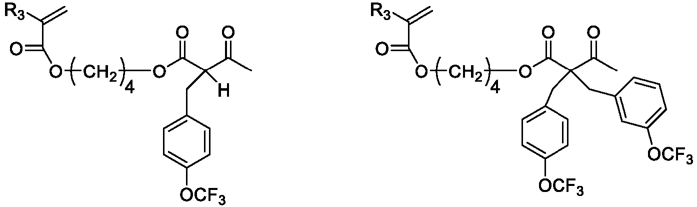

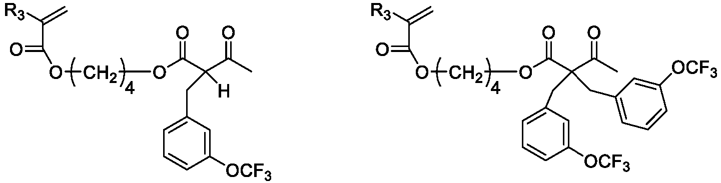

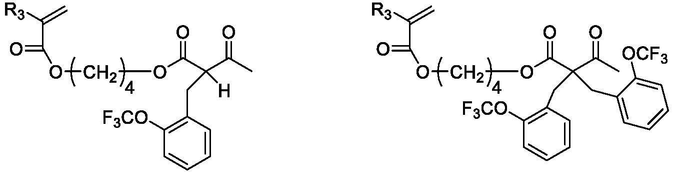

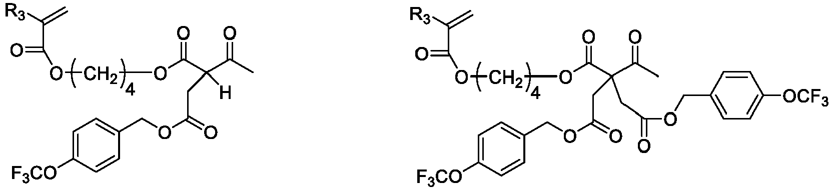

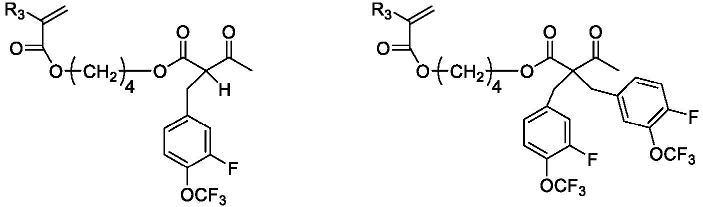

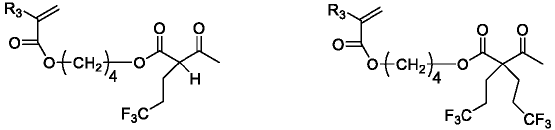

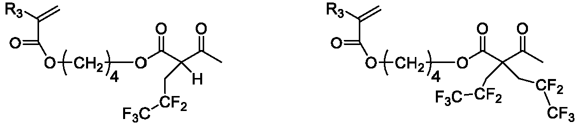

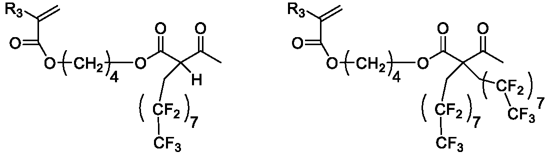

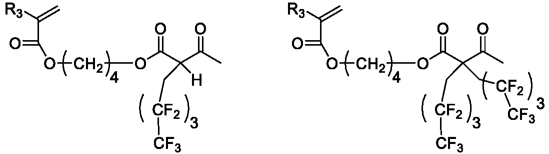

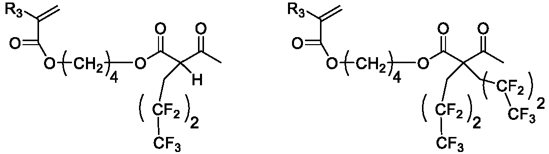

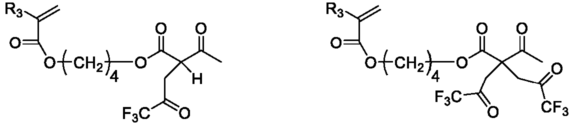

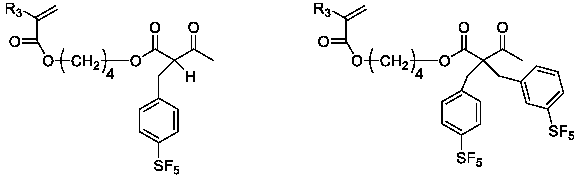

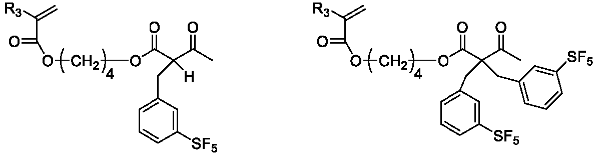

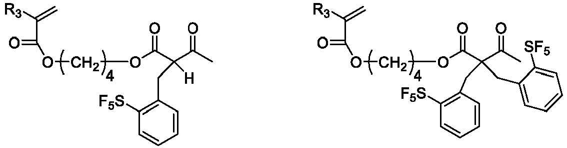

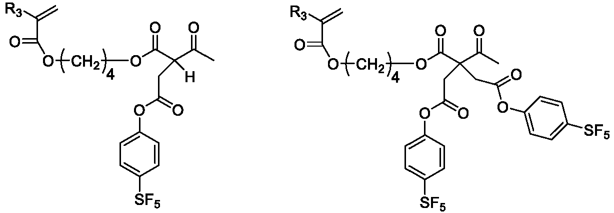

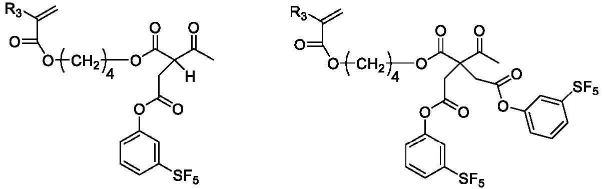

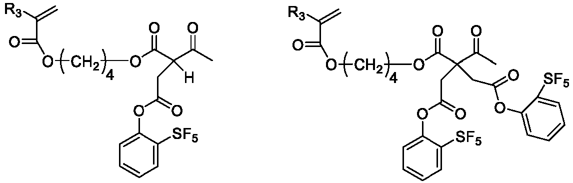

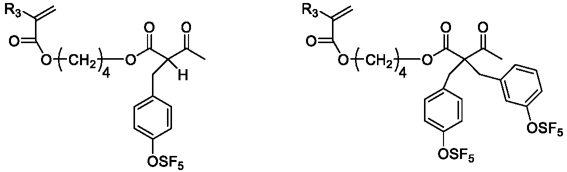

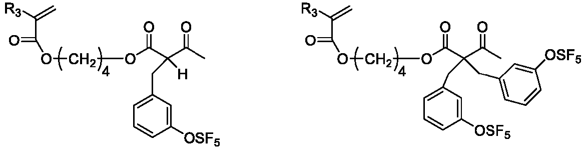

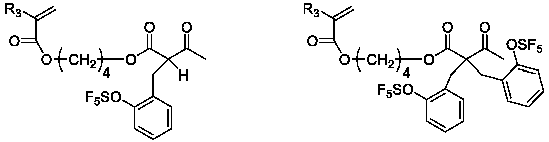

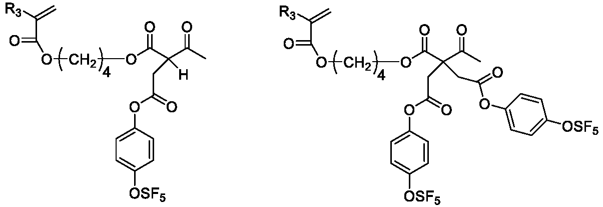

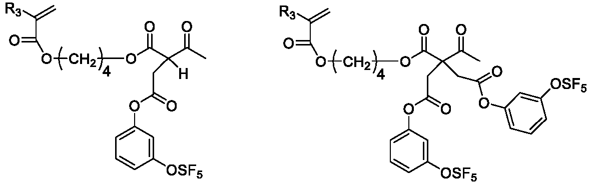

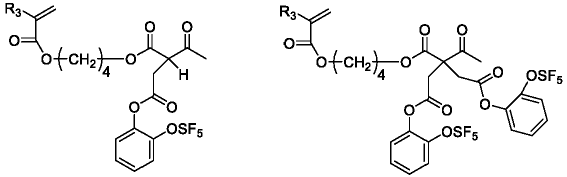

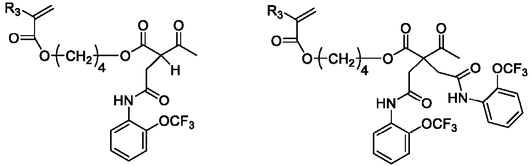

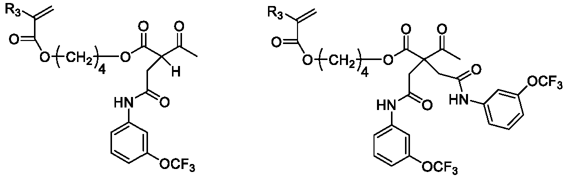

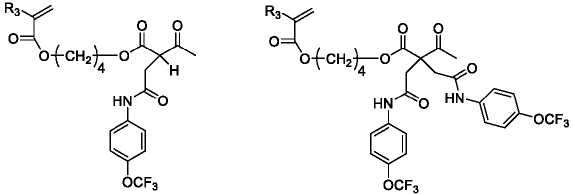

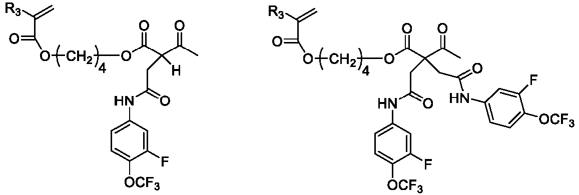

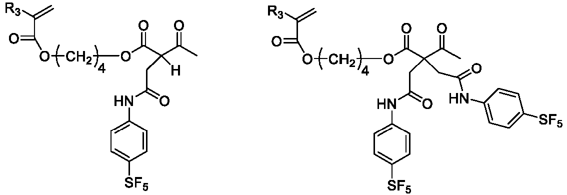

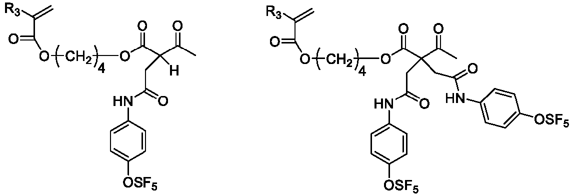

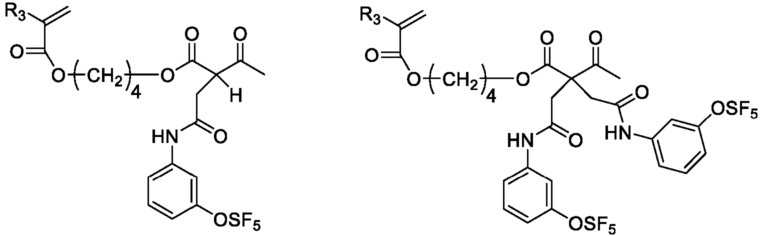

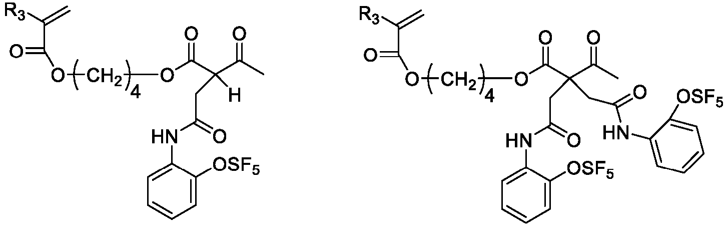

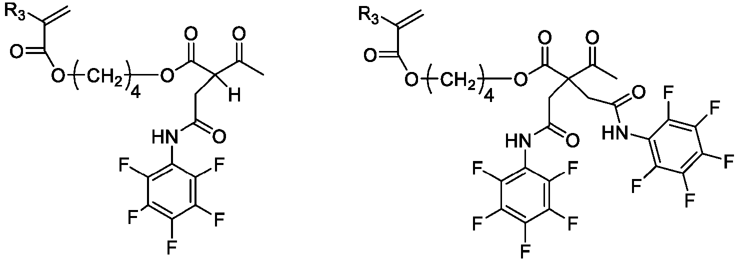

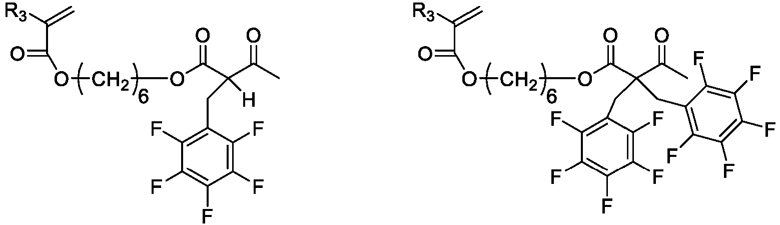

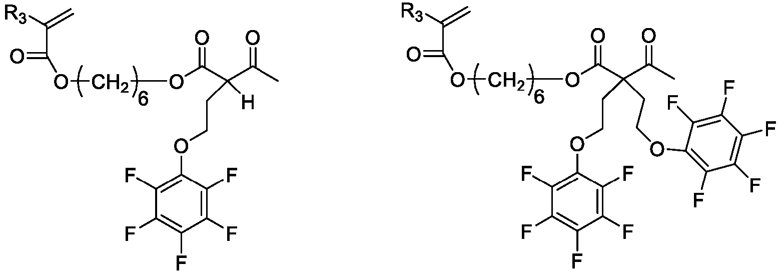

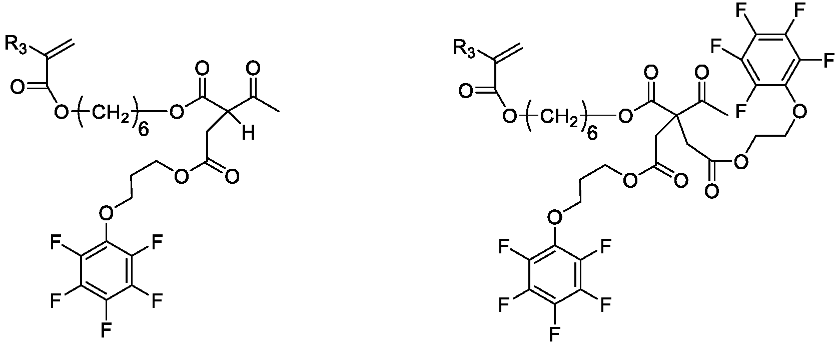

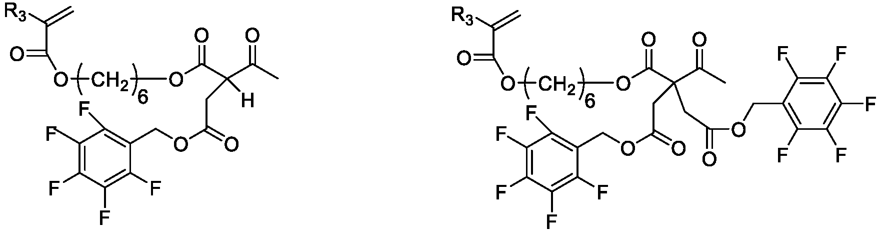

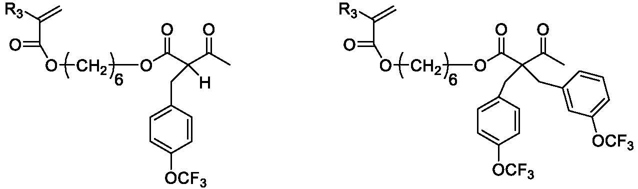

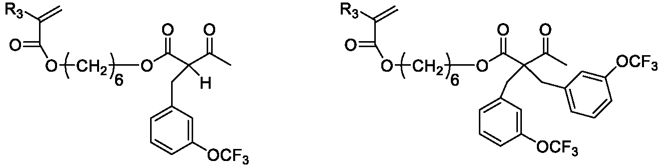

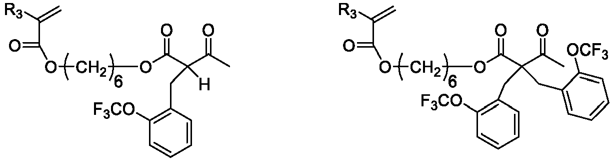

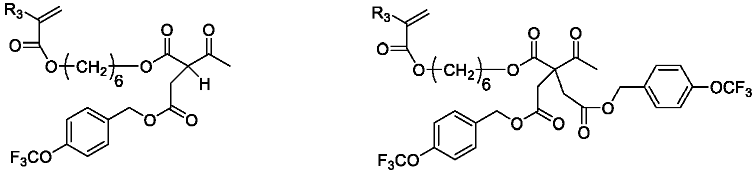

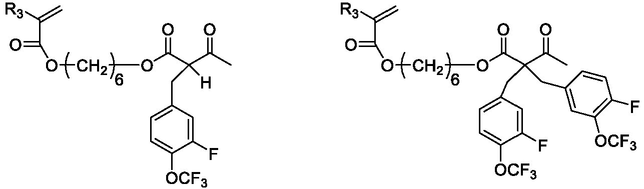

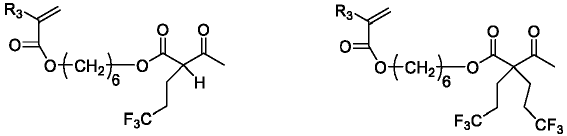

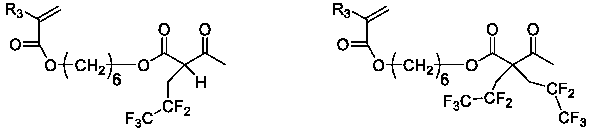

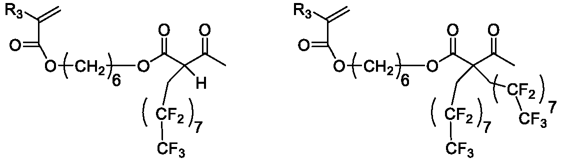

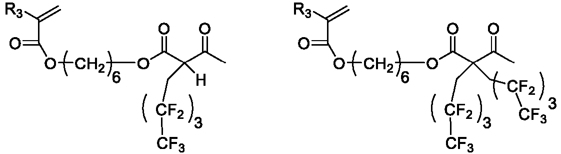

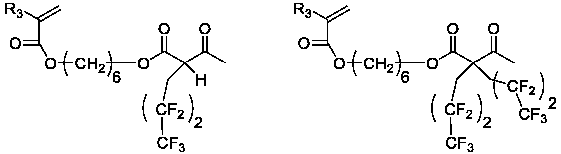

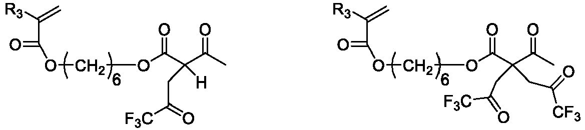

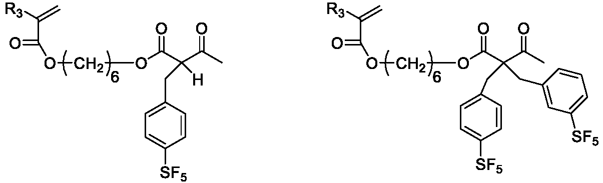

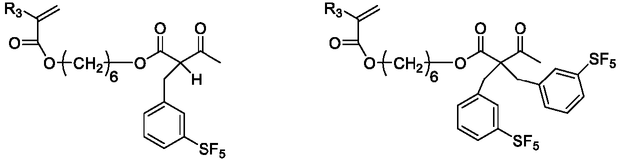

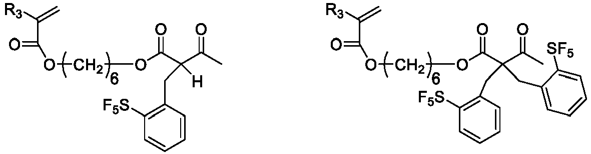

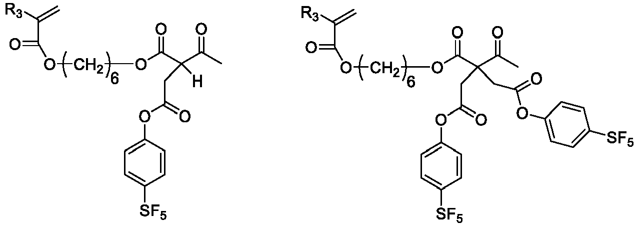

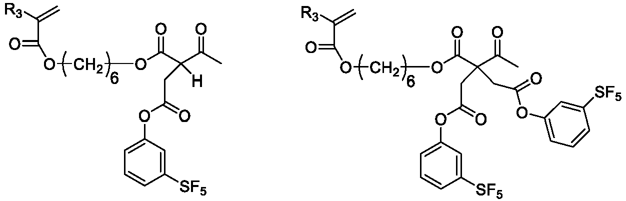

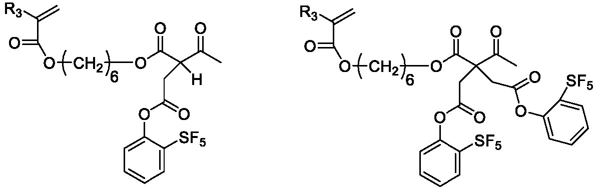

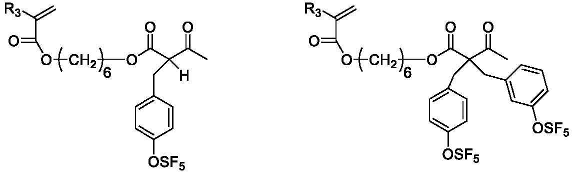

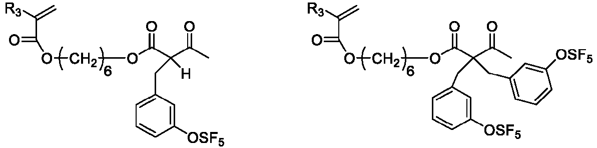

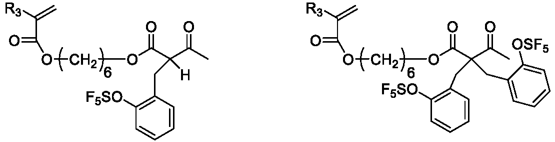

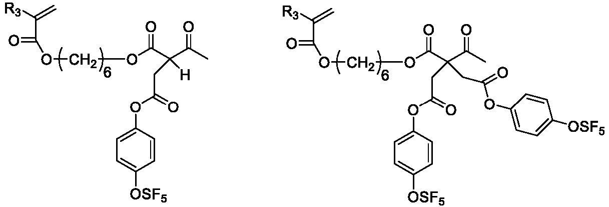

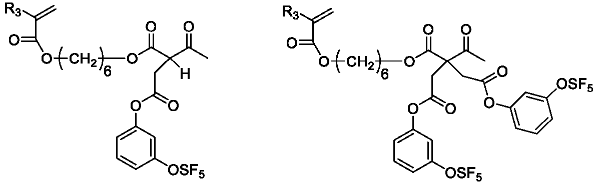

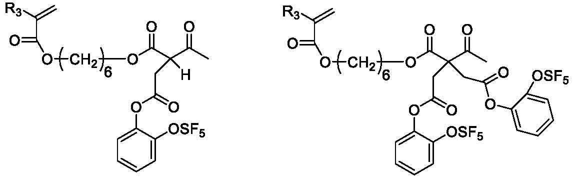

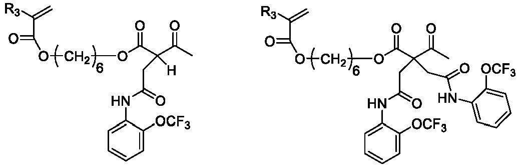

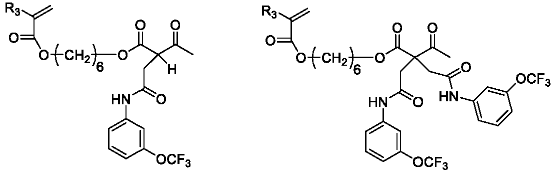

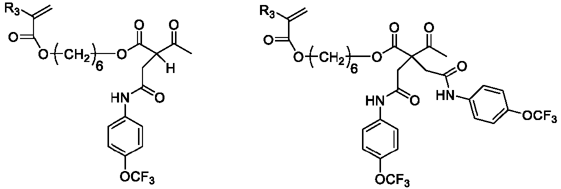

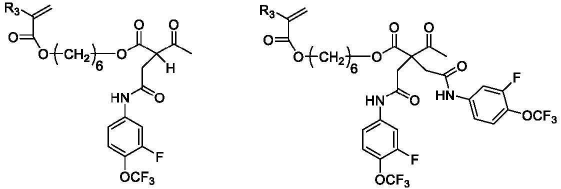

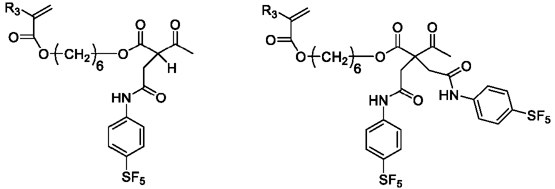

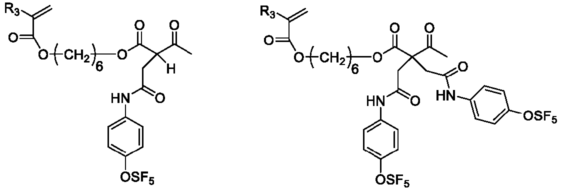

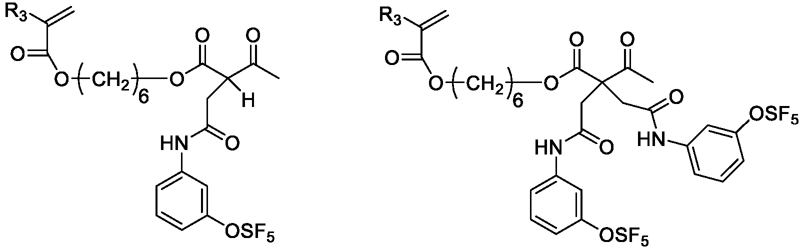

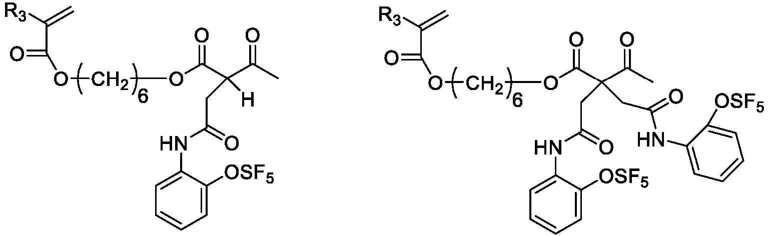

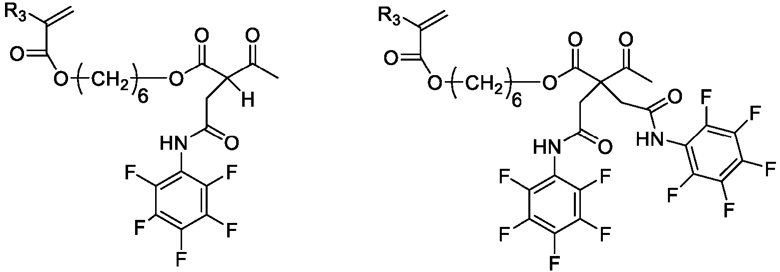

The weight average molecular weight (Mw) of the polymer (a1-1) in terms of polystyrene, as determined by gel permeation chromatography (GPC) using THF as a solvent, is preferably 1000 to 500000, more preferably 1500 to 30000, and still more preferably 2000 to 30000. Further, when the molecular weight distribution (Mw/Mn) of the polymer (a1-1) is broad, the presence of low molecular weight and high molecular weight polymers arise a risk of the precipitation of foreign substances derived from the ultra-high molecular weight in the coating film and the deterioration of the in-plane uniformity of the coating film derived from the low molecular weight. In addition, as miniaturization progresses, substrate shapes become more complex, requiring highly accurate film formation onto a variety of substrate shapes, and thus Mw and Mw/Mn must also be controlled. Therefore, in order to obtain an organic film material suitable for fine pattern processing, it is preferable that the Mw/Mn of the polymer (a1-1) is narrowly dispersed, i.e., 1.0 to 4.0, particularly 1.0 to 3.0. There are concerns about a decrease in the surfactant effect due to low molecular weight components, and a decrease in solubility due to the inclusion of ultra-high molecular weight components, which can lead to deterioration of hump properties and the like, and thus it is preferable to narrow the dispersity within a range in which these components are not contained in large amounts.

The polymer (a1-1) may contain two or more polymers with different composition ratios, Mw, and Mw/Mn.

The polymer (a1-1) can be obtained by polymerizing a monomer that provides a repeating unit selected from the repeating units (a1-1) by a method such as radical polymerization, anionic polymerization, or cationic polymerization.

When the polymer (a1-1) contains two or more types of repeating units, the polymer may be a random copolymer or a block copolymer, but a block copolymer has the feature of being more effective as a surfactant. In particular, a block copolymer containing repeating units (a1) and (b1) is preferable. The block copolymer may be a diblock copolymer including two units, a triblock copolymer including three units, or a tetrablock copolymer including four units.

In addition, the polymer (a1-1) is preferably a copolymer with a repeating unit having a hydrophilic group having an ether bond, as shown in the general formula (5). Containing a repeating unit having a highly water-repellent fluorine atom, as shown in the general formula (3), and a repeating unit having a hydrophilic group (5) allows to impart sufficient improvement in the film-forming properties, 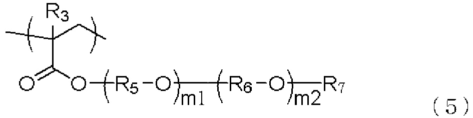 wherein R₃ is as defined above, R₅ and R₆ are each a linear or branched divalent alkylene group having 1 to 4 carbon atoms, R₇ is a hydrogen atom, an alkyl group having 1 to 4 carbon atoms, or a phenyl group, m1 is 0 to 23, m2 is 0 to 23, and 23 ≥ ml + m2 ≥ 2.

The above R₅ and R₆ each represent a divalent alkylene group having 1 to 4 carbon atoms, which may be linear or branched. Specific examples of the divalent alkylene group having 1 to 4 carbon atoms, which may be linear or branched, include a methylene group, an ethylene group, a propylene group, a butylene group, a trimethylene group, and a tetramethylene group. Of these, an ethylene group is more preferable from the viewpoint of eliminating voids in film-forming properties. The disposition of (R₅O) and (R₆O) may be random, block, or multiblock.

The above R₇ represents a hydrogen atom, an alkyl group having 1 to 4 carbon atoms, or a phenyl group. Specific examples of the alkyl group having 1 to 4 carbon atoms include a methyl group, an ethyl group, a propyl group, an isopropyl group, an allyl group, an n-butyl group, an s-butyl group, a t-butyl group, and an isobutyl group. Of these, a hydrogen atom, a methyl group or an ethyl group, and a phenyl group are more preferable. From the viewpoint of availability of raw materials, a hydrogen atom or a methyl group is preferable.

The above m1 is 0 to 23, m2 is 0 to 23, 23 ≥ m1 + m2 ≥ 2. Herein, m1 and m2 represent the average number of repetitions. The upper limit of m1 + m2 is 23, and from the viewpoint of low-temperature storage stability, it is preferably 2 ≤ m1 + m2 ≤ 13, and more preferably 9 ≤ m1 + m2 ≤ 13.

Specific examples of monomers used to provide a polymer having a repeating unit represented by the above general formula (5) include the following.

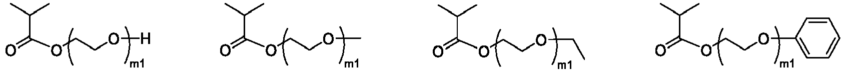

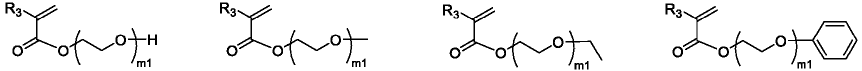

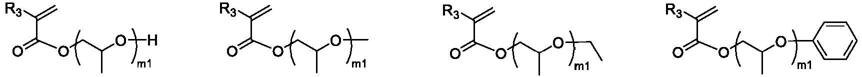

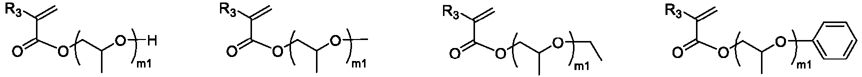

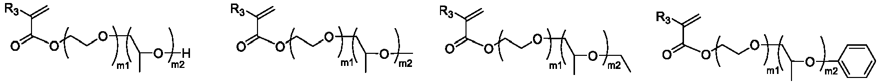

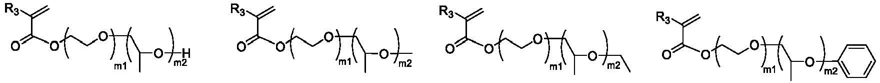

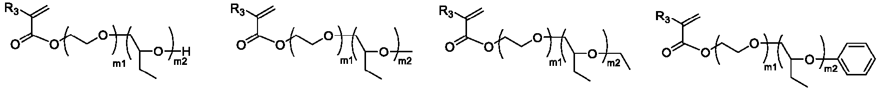

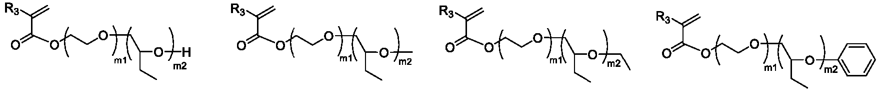

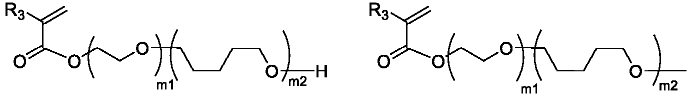

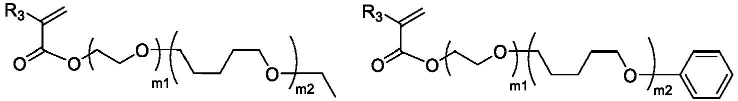

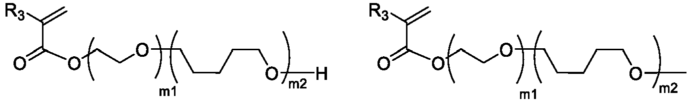

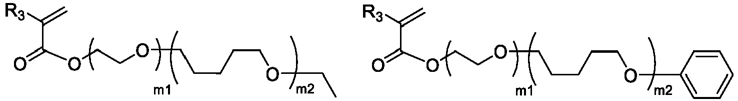

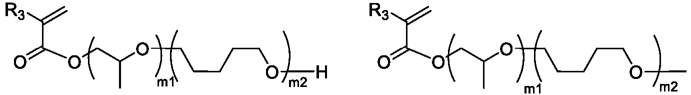

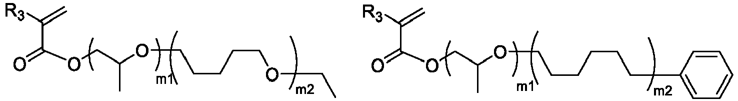

In the copolymer, when the ratio of the repeating unit represented by the general formula (3) is (a1-1), and the ratio of the polymer represented by the general formula (5) is (b1), and then the content ratio is preferably 0 ≤ (a1-1) < 1.0 and 0 < (b1) < 1.0, more preferably 0.1 ≤ (a1-1) ≤ 0.9 and 0.1 ≤ (b1) ≤ 0.9, and further preferably 0.2 ≤ (a1-1) ≤ 0.8 and 0.2 ≤ (b1) ≤ 0.8. Provided that (a1-1) + (b1) = 1.0.

Further, the polymer can be used by combining one or more of each of the monomers providing the structural unit represented by the general formula (3) and the monomers providing the structural unit represented by the general formula (5). For example, in order to improve the film-forming properties, it is possible to appropriately select combining a plurality of monomers that provide the repeating units of (3), combining a plurality of monomers that provide the repeating unit represented by (5), or using a plurality of monomers that provide the repeating units of (3) and (5) respectively, according to the properties of the resins and compounds used in the organic film to be applied. This makes it possible to adjust the performance to provide the desired film-forming properties according to the resins and compounds used in the organic film-forming material, for single compounds such as phenolic resins, radical polymers, polyimides, and polyimines, polycarbonates, multifunctional phenolic compounds.

### [Method for manufacturing polymer (a1-1)]

As a method for manufacturing the polymer (a1-1), the polymer can be obtained by polymerization using a method such as radical polymerization, anionic polymerization, or cationic polymerization, as described above. As an example, the following method is shown, in which monomers are polymerized by adding a radical polymerization initiator in an organic solvent, followed by heating.

Examples of the organic solvents used during polymerization include toluene, benzene, THF, diethyl ether, dioxane, cyclohexane, cyclopentane, methyl ethyl ketone (MEK), propylene glycol monomethyl ether acetate (PGMEA), and γ-butyrolactone (GBL). Examples of the polymerization initiator include 2,2'-azobisisobutyronitrile (AIBN), 2,2'-azobis(2,4-dimethylvaleronitrile), dimethyl-2,2-azobis(2-methylpropionate), 1,1'-azobis(1-acetoxy-1-phenylethane), benzoyl peroxide, and lauroyl peroxide. The amount of these initiators added is preferably 0.01 to 25 mol% with respect to the total amount of monomers to be polymerized. The reaction temperature is preferably 50 to 150°C, more preferably 60 to 100°C. The reaction time is preferably 2 to 24 hours, and from the viewpoint of manufacturing efficiency, more preferably 2 to 18 hours.

The polymerization initiator may be added to the monomer solution and fed to the reaction vessel, or an initiator solution may be prepared separately from the monomer solution and fed to the reaction vessel separately. During the waiting time, radicals generated from the initiator may cause the polymerization reaction to proceed, resulting in the production of ultra-high molecular weight molecules, and thus from the viewpoint of quality control, it is preferable to prepare the monomer solution and the initiator solution separately and add them dropwise. In addition, known chain transfer agents such as dodecyl mercaptan and 2-mercaptoethanol may be used in combination to adjust the molecular weight. In this case, the amount of these chain transfer agents added is preferably 0.01 to 20 mol% with respect to the total amount of monomers to be polymerized.

The amount of each monomer in the monomer solution may be appropriately set such that the polymer has a preferable content ratio of each repeating unit according to the required performance.

For the polymer obtained by the above-described manufacturing method, the reaction solution obtained by the polymerization reaction may be the final product, or the powder obtained through a purification step such as a reprecipitation method in which the polymerization solution is added to a poor solvent to provide a powder may be handled as the final product, and from the viewpoint of work efficiency and quality stabilization, it is preferable to handle the polymer solution obtained by dissolving the powder obtained by the purification step in a solvent as the final product.

Specific examples of the solvent to be used in this case include ketones such as cyclohexanone and methyl-2-n-pentyl ketone,; alcohols such as 3-methoxybutanol, 3-methyl-3-methoxybutanol, 1-methoxy-2-propanol, and 1-ethoxy-2-propanol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as PGMEA, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate; lactones such as GBL; alcohols such as diacetone alcohol (DAA); high-boiling alcohol solvents such as diethylene glycol, propylene glycol, glycerin, 1,4-butanediol, and 1,3-butanediol, as described in paragraphs [0144] to [0145] of JP 2008-111103 A, and mixed solvents of these.

The concentration of the polymer in the solution in a case of handling the polymer solution is preferably 0.1 to 60% by mass, more preferably 1 to 50% by mass. When the concentration is too high, the viscosity increases and handling performance decreases. In addition, when the concentration is too low, the polymer and compound solution must be diluted to a large extent in order to add a specified amount of surfactant to the product when the polymer and compound are used as an organic film forming material in solution, which narrows the film thickness range that can be produced, causing a disadvantage.

The polymer solution is preferably filtered. Filtering can remove foreign matter and gels that may cause poor film formation, and is effective in stabilizing quality.

Filter materials used in the filter filtration include fluorocarbon-based, cellulose-based, nylon-based, polyester-based, and hydrocarbon-based materials, and in the filtration step of the chemical amplification resist composition, filters made of fluorocarbons, so-called Teflon (registered trademark), hydrocarbons such as polyethylene and polypropylene, or nylon are preferable. The pore size of the filter can be appropriately selected according to the target cleanliness, and is preferably 100 nm or less, more preferably 20 nm or less. In addition, these filters may be used singly or may be used in combination thereof. The filtration method may be to pass the solution through the filter only once, but it is more preferable to circulate the solution and filter a plurality of times. The filtration step may be performed in any order and any number of times in the manufacturing step of the polymer solution, but it is preferable to filter the reaction solution after the polymerization reaction, the polymer solution, or both.

Further, when random copolymerization is performed by radical polymerization, it is common to mix the monomers to be copolymerized and a radical initiator and polymerize by heating. When the first monomer is polymerized in the presence of a radical initiator and the second monomer is added later, the polymer molecule has a block polymerized with the first monomer on one side and a block polymerized with the second monomer on the other side. However, in this case, the repeating units derived from the first and second monomers are mixed in the middle moiety, and the form is different from that of a block copolymer. In order to form a block copolymer by radical polymerization, living radical polymerization is preferably used. In the living radical polymerization method called Reversible Addition Fragmentation chain Transfer (RAFT) polymerization, the radicals at the polymer end are always alive, and thus it is possible to start polymerization with the first monomer, and when it is consumed, add the second monomer to form a block copolymer including the first and second repeating units. When polymerization is started with the first monomer, and when it is consumed, the second monomer is added, and then the third monomer is added, a triblock copolymer can be formed. RAFT polymerization also has a feature of the formation of narrow-dispersity polymers.

Examples of the organic solvents used during polymerization include toluene, benzene, tetrahydrofuran (THF), diethyl ether, and dioxane. Examples of the polymerization initiators include 2,2'-azobisisobutyronitrile (AIBN), 2,2'-azobis (2,4-dimethylvaleronitrile), dimethyl 2,2-azobis (2-methylpropionate), benzoyl peroxide, and lauroyl peroxide. The temperature during polymerization is preferably 50 to 80°C. The reaction time is preferably 2 to 100 hours, more preferably 5 to 20 hours.

A chain transfer agent is required to perform RAFT polymerization, and Specific examples thereof include 2-cyano-2-propyl benzothioate, 4-cyano-4-phenylcarbonothioylthiopentanoic acid, 2-cyano-2-propyl dodecyl trithiocarbonate, 4-cyano-4-[(dodecylsulfanylthiocarbonyl)sulfanyl]pentanoic acid, 2-(dodecylthiocarbonothioylthio)-2-methylpropanoic acid, cyanomethyl dodecylthiocarbonate, cyanomethyl N-methyl-N-phenylcarbamothioate, bis (thiobenzoyl) disulfide, bis (dodecylsulfanylthiocarbonyl) disulfide. Of these, 2-cyano-2-propyl benzothioate is the most preferable.

When the monomers are added all at once and RAFT polymerization is performed, randomly polymerized and narrowly dispersed polymer can be synthesized.

### [Another method for manufacturing polymer (a1-1) having a repeating unit represented by the general formula (3)]

As another method for manufacturing the polymer (a1-1), as shown below, a monomer having an acetylacetone structure is polymerized in an organic solvent by adding a radical polymerization initiator and heating (step 1), and then the monomer is subjected to an addition reaction with a halide having R₁ or R₂ as a substituent, mesylate, tosylate, or the like in the presence of a base catalyst (step 2) (in the following formula, X represents a halide, a mesylate, or a tosylate, R₁, R₂ (provided that R₂ is other than a hydrogen atom), R₃, and n1 are as defined above).

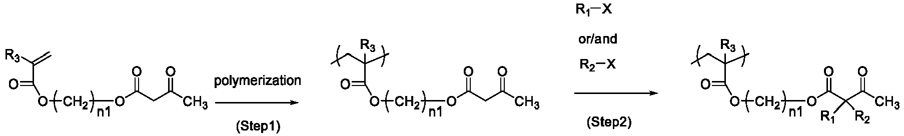

When using the above reaction method, there are two reactive sites for the repeating unit of the polymer because of the reaction selectivity, and thus a reaction rate of 100% means that R₁ and R₂ are completely introduced as substituents, and when R₁ is not R₂, the following three types are obtained, and when R₁ = R₂ = R', one type is obtained. In addition, when the reaction rate is less than 100%, it is possible to obtain polymers with repeating units with a plurality of combinations as shown below. When R₁ is not R₂, the following six types are obtained, and when R₁ = R₂ = R', two types are obtained. Adjusting the overall charge ratio allows control of the reaction rate for all reactive sites, and a plurality of or single substituents corresponding to R₁ and R₂ can be combined to suit the required performance. For example, when the substitution rate in the repeating unit of the polymer is 100, the ratio of substitution with R₁ and R₂ is "a", and the ratio of unmodified hydrogen atoms is "b", then 0 ≤ a + b ≤ 100, with 0.5 < a ≤ 1.0 being preferable, and 0.7 ≤ a ≤ 1.0 being more preferable. In this case, a polymer including a repeating unit shown below by a relationship of R₁ and R₂ is provided.
[Case where reaction rate is 100%]
   **R1 ≠ R2** 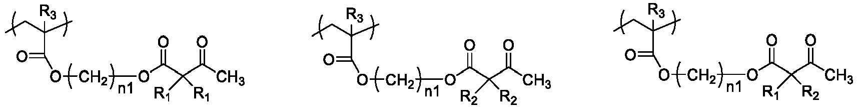
   **R1 = R2= R'** 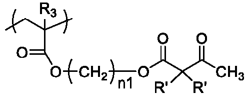
[Case where reaction rate is less than 100%]
   **R1 ≠ R2** 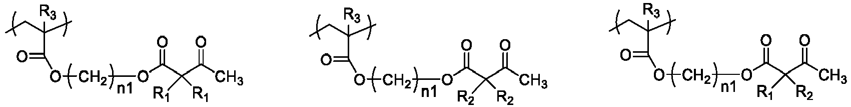 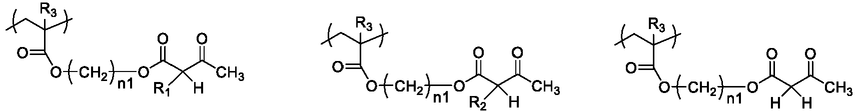
   **R1 = R2= R'**

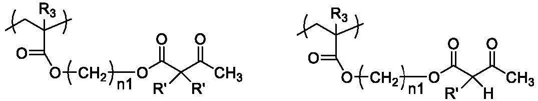

Regarding a method to obtain the polymer, the above polymer can be obtained by the method described in paragraphs [0100] to [0112], simply by changing the monomers in the polymerization of step 1 to those corresponding to the precursors. The polymer obtained in Step 1 can be used in the addition reaction of step 2.

Examples of the base catalysts used in the substitution reaction of step 2 include inorganic base compounds such as sodium hydrogen carbonate, sodium carbonate, potassium carbonate, calcium carbonate, cesium carbonate, sodium hydroxide, potassium hydroxide, sodium hydride, and potassium phosphate, and organic amine compounds such as triethylamine, pyridine, and N-methylmorpholine, and these may be used singly or in combination of two or more. The amount of the catalyst used ranges from 0.1 to 20 moles, preferably 0.2 to 10 moles, with respect to the number of moles of the raw material amide acid.

The solvent used in this reaction is not particularly limited as long as it is inert to the above reaction, and for example, ether-based solvents such as diethyl ether, tetrahydrofuran, and dioxane, aromatic-based solvents such as benzene, toluene, and xylene, acetonitrile, dimethyl sulfoxide, N,N-dimethylformamide, N-methylpyrrolidone, and water can be used singly or in combination. These solvents can be used in an amount ranging from 0 to 2000 parts by mass with respect to 100 parts by mass of the reaction raw materials, and the reaction temperature is preferably about from -50°C to the boiling point of the solvent, and more preferably from room temperature to 150°C. The reaction time is appropriately selected from 0.1 to 100 hours.

The reaction method includes a method of charging the polymer obtained in step 1, the halide, mesylate, or tosylate having R₁ and R₂ as substituents, and the catalyst all at once, a method of dispersing or dissolving the polymer obtained in step 1 and the halide, mesylate, or tosylate having R₁ and R₂ as substituents, and then adding the catalyst all at once or diluting with a solvent and dropping, or a method of dispersing or dissolving the catalyst, and then adding the polymer obtained in step 1 and the halide, mesylate, or tosylate having R₁ and R₂ as substituents all at once or diluting with a solvent and dropping. After the reaction is completed, the product may be used as the organic film material as it is, and can also be recovered by diluting with an organic solvent and then performing separation washing to remove unreacted raw materials, catalysts, and the like present in the system.

The organic solvent used in this case is not particularly limited as long as it can dissolve the compound and separate into two layers when mixed with water, and examples thereof include: hydrocarbons such as hexane, heptane, benzene, toluene, and xylene; esters such as ethyl acetate, n-butyl acetate, and propylene glycol methyl ether acetate; ketones such as methyl ethyl ketone, methyl amyl ketone, cyclohexanone, and methyl isobutyl ketone; ethers such as diethyl ether, diisopropyl ether, methyl tert-butyl ether, and ethylcyclopentyl methyl ether; chlorine-based solvents such as methylene chloride, chloroform, dichloroethane, and trichloroethylene; and mixtures thereof. The washing water used in this case is typically what is called deionized water or ultrapure water. It is sufficient to wash at least once, but washing 10 times or more will not necessarily provide the desired effect, and thus it is preferable to wash about 1 to 5 times.

In order to remove unreacted raw materials or acidic components from the system during separation washing, washing may be performed with a basic aqueous solution. Specific examples of the bases include hydroxides of alkali metals, carbonates of alkali metals, hydroxides of alkaline earth metals, carbonates of alkaline earth metals, ammonia, and organic ammonium.

Further, in order to remove unreacted raw materials, metal impurities, or basic components from the system during separation washing, washing may be performed with an acidic aqueous solution. Specific examples of the acids include inorganic acids such as hydrochloric acid, hydrobromic acid, sulfuric acid, nitric acid, phosphoric acid, and heteropolyacid, and organic acids such as oxalic acid, trifluoroacetic acid, methanesulfonic acid, benzenesulfonic acid, p-toluenesulfonic acid, and trifluoromethanesulfonic acid.

The above-described separation washing with a basic aqueous solution or an acidic aqueous solution may be performed either singly or in combination. From the viewpoint of removing metal impurities, it is preferable to perform separation washing in the order of a basic aqueous solution and an acidic aqueous solution.

After the above-described separation washing with the basic aqueous solution and acidic aqueous solution, washing with neutral water may be performed subsequently. Washing may be performed once or more, but preferably about 1 to 5 times. As the neutral water, the above-described deionized water or ultrapure water may be used. Washing may be performed once or more, but when the number of times is too few, the basic and acidic components may not be removed. Washing 10 or more times does not necessarily provide the effect of washing, and thus washing about 1 to 5 times is preferable.

Further, the reaction product after the liquid separation operation can be recovered as a powder by concentrating and drying the solvent or crystallizing under reduced or normal pressure, but can also be left in a solution state of a moderate concentration to improve operability when preparing the organic film material. The concentration in this case is preferably 0.1 to 50% by mass, and more preferably 0.5 to 30% by mass. At such a concentration, the viscosity is unlikely to increase, which prevents a loss of operability, and the amount of solvent is not excessive, which is economical.

The solvent in this case is not particularly limited as long as it can dissolve the compound, and specific examples thereof include: ketones such as cyclohexanone and methyl-2-amyl ketone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate, and these can be used singly or in combination of two or more. Further, the obtained polymer can be used by filtering the obtained polymerization solution as described in [0107] and [0108].

Further, in manufacturing the polymer obtained by this method, it is possible to combine halides, mesylates, and tosylates different from halides, mesylates, or tosylates having R₁ and R₂ as substituents according to the required performance.

### [Polymer: Polymer (a1-2) having repeating unit represented by general formula (4)]

The polymer (a1-2) having the repeating unit represented by the general formula (4) is a so-called polyester. The polymer can be obtained by dehydration condensation reaction of diol with biscarboxylic acid, acid halide or acid anhydride corresponding to biscarboxylic acid, or ester exchange with biscarboxylic acid ester.

The diol compounds are exemplified as follows. Of these, diols linked by a glyme chain or diols linked by an alkyl group are preferable from the viewpoint of surfactant effect.

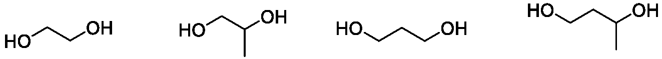

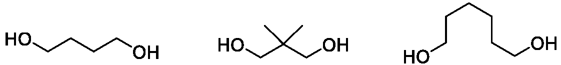

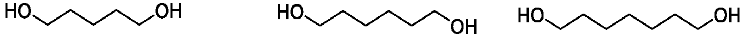

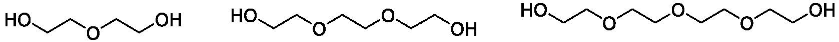

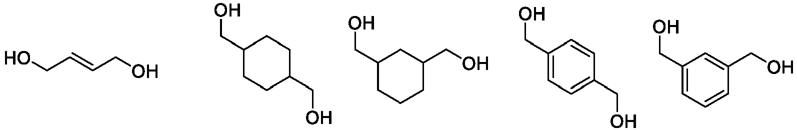

The biscarboxylic acid compounds are exemplified as follows.

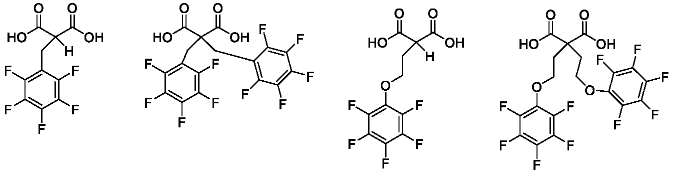

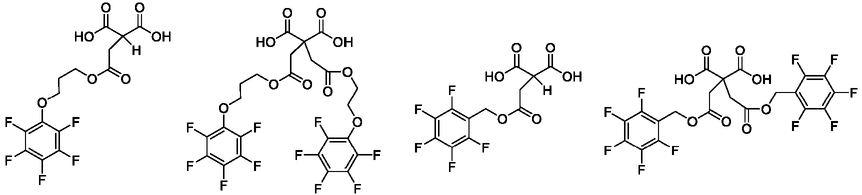

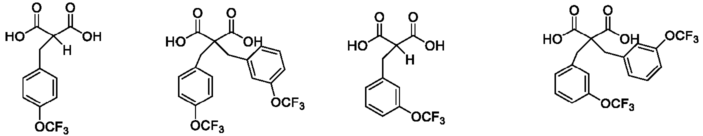

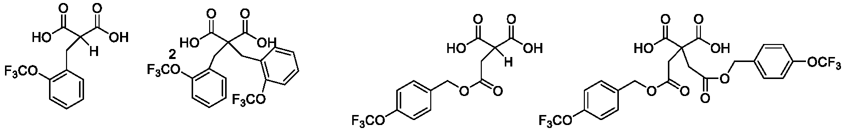

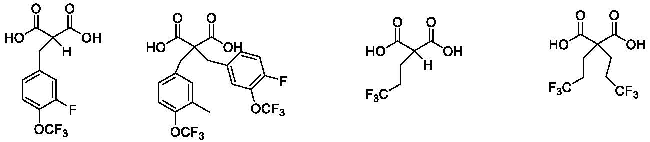

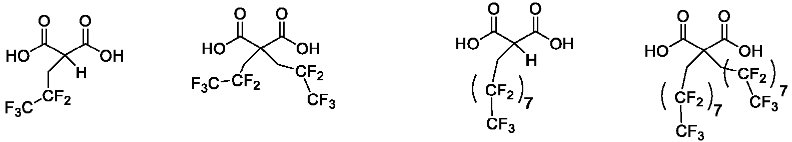

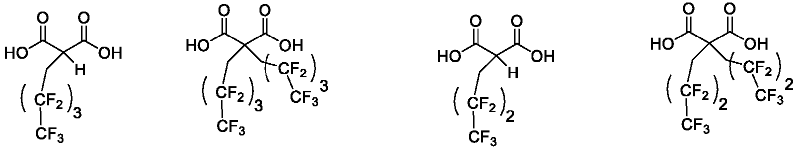

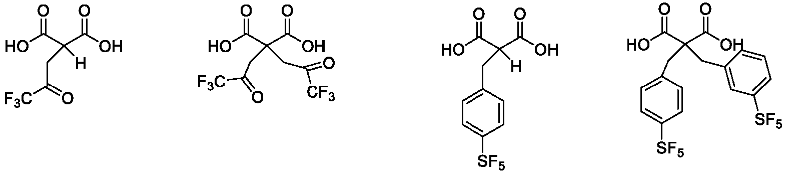

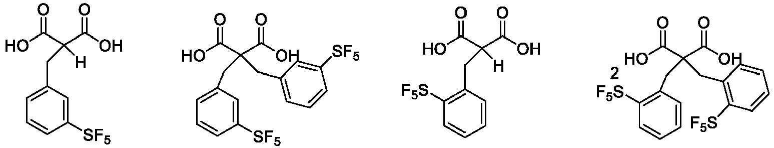

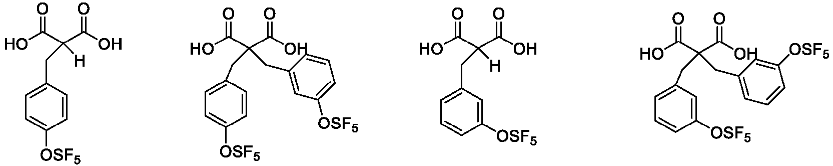

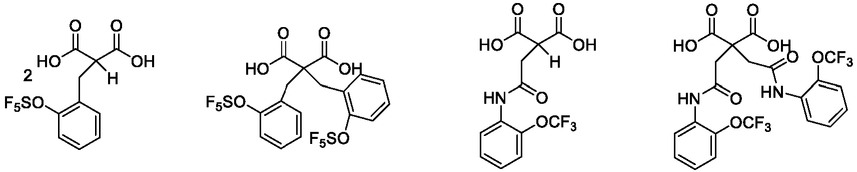

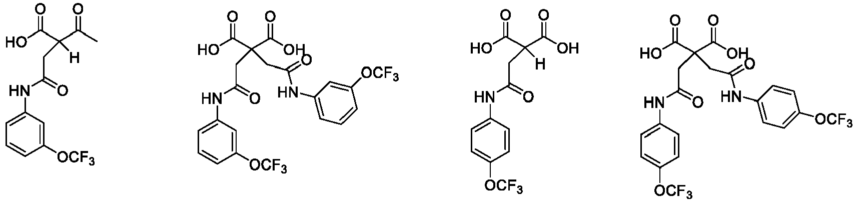

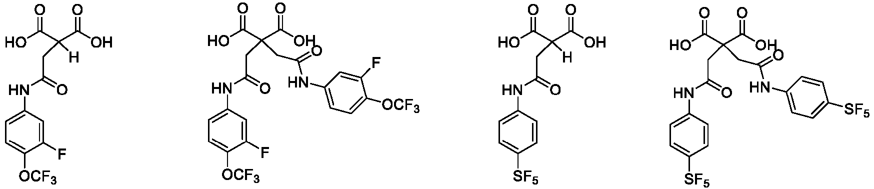

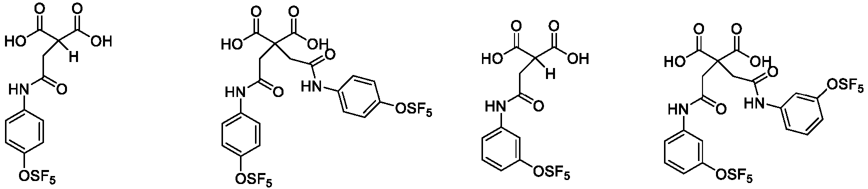

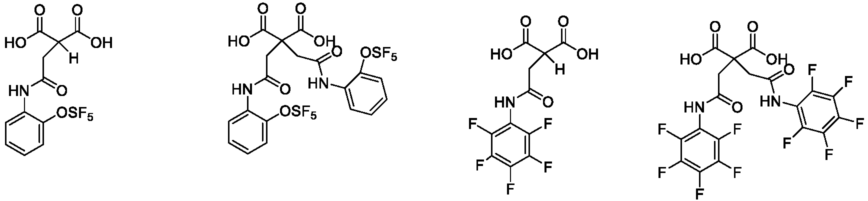

The Mw and Mw/Mn of the polymer (a1-2) must be controlled within an appropriate range for microfabrication, as with the polymer (a1-1). Specifically, the weight average molecular weight (Mw) in terms of polystyrene, as determined by gel permeation chromatography (GPC) using THF as a solvent is preferably 1000 to 500000, more preferably 1500 to 30000, and further preferably 2000 to 30000. It is preferable that Mw/Mn has a narrow distribution of 1.0 to 4.0, and particularly 1.0 to 3.0.

### [Method for manufacturing polymer (a1-2)]

As a method for manufacturing the polymer (a1-2), as described above, a polymer can be obtained by the dehydration condensation reaction of a diol with a biscarboxylic acid, an acid halide or an acid anhydride corresponding to the biscarboxylic acid, or ester exchange with a biscarboxylic acid ester. Examples of reaction formulae for dehydration condensation, acid halide, and ester exchange are exemplified below. These can be appropriately selected taking into consideration the stability of the raw materials used.

(In the following formula, R₁, R₂, and R₄ are as defined above, X₁ is a halogen atom, and R" represents an alkyl group having 1 to 5 carbon atoms.)

### [Dehydration condensation]

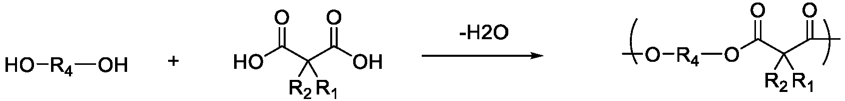

### [Ester exchange]

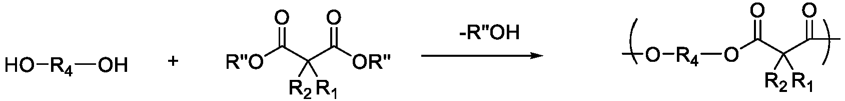

### [Acid halide]

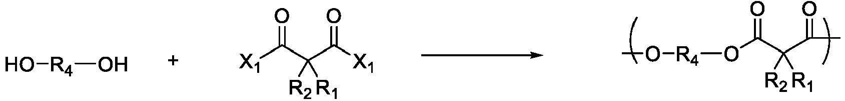

When the polymer (a1-2) is produced by dehydration condensation or ester exchange as described above, the polymer can be obtained by reacting a diol with a biscarboxylic acid or an ester compound corresponding to the biscarboxylic acid in the absence or presence of a catalyst while removing the water or alcohol generated.

There is no problem when the reaction proceeds without a catalyst, but when a catalyst is used, the following substances are exemplified: metal hydroxides such as sodium hydroxide and potassium hydroxide; alkaline metal or alkaline earth metal carbonates such as sodium carbonate, potassium carbonate, and cesium carbonate; amines such as imidazoles and benzotriazoles; phosphines such as triphenylphosphine; tetraalkylammonium halides such as tetraethylammonium chloride and tetraethylammonium bromide; quaternary ammonium salts such as benzyltrialkylammonium chlorides such as benzyltrimethylammonium chloride and benzyltriethylammonium chloride; quaternary phosphonium salts such as benzyltriphenylphosphonium chloride; aluminum compounds such as trialkylaluminum; tin compounds such as tin chloride and tin carboxylates; and titanium compounds such as titanium alkoxide. When a catalyst is used, the amount of the catalyst used can be selected from the range of 0.001 to 1.0 moles, preferably 0.003 to 0.3 moles, and more preferably 0.005 to 0.1 moles, with respect to 1.0 mole of the total amount of the diol and bisdicarboxylic acid.

The reaction may be performed without a solvent, or a solvent may be used to reduce the viscosity of the resulting polymer. There are no particular limitations on the solvent as long as it is inert to the above reaction, and for example, aromatic solvents such as benzene, toluene, and xylene, acetonitrile, dimethyl sulfoxide, N,N-dimethylformamide, N-methylpyrrolidone, diphenyl sulfone, diphenyl ether, trichlorobiphenyl, trichlorobenzene, and dichlorobenzene may be used singly or in combination. These solvents can be used in the range of 0 to 2000 parts by mass with respect to 100 parts by mass of the reaction raw materials, and the reaction temperature is preferably about from -50°C to the boiling point of the solvent, and more preferably from 100°C to 150°C. The reaction time is appropriately selected from 0.1 to 100 hours. In this case, it is preferable to perform the reaction while removing water or alcohol generated by the reaction from the system.

The above polymer can be obtained by the method described in paragraphs [0100] to [0112], simply by changing the reacting substrate to a biscarboxylic acid or an ester compound corresponding to the biscarboxylic acid.

When the polymer (a1-2) is produced using an acid halide as described above, the polymer can be obtained by reacting an acid halide corresponding to the biscarboxylic acid, such as an acid chloride, in the presence of a base catalyst.

The base catalyst used in this case includes, for example, amines, and specific examples thereof include: tertiary amines such as trimethylamine, triethylamine, tripropylamine, diisopropylethylamine, tributylamine, tripentylamine, and trihexylamine; aliphatic amines having an aromatic ring such as N,N-dimethylaniline, phenyldimethylamine, diphenylmethylamine, and triphenylamine; cyclic aliphatic amines such as 1-methylpyrrolidine, 1-methylpiperidine, and 4-methylmorpholine; amidines such as 1,8-diazabicyclo[5.4.0]-7-undecene and 1,5-diazabicyclo[4.3.0]-5-nonene; guanidines such as guanidine, 1,1,3,3-tetramethylguanidine, and 1,2,3-triphenylguanidine; aromatic amines such as 1-methylpyrrole, pyridine, 2-methylpyridine, 3-methylpyridine, 4-methylpyridine, 2,6-dimethylpyridine, and N,N-dimethyl-5-aminopyridine; quaternary ammonium salts such as tetramethylammonium hydroxide and tetraethylammonium hydroxide. These catalysts can be used singly or in combination of two or more, and the amount of the catalyst used is in the range of 0.1 to 20 moles, preferably 0.2 to 10 moles, with respect to the number of moles of the acid halide as the raw material.

The solvent used in this case is not particularly limited as long as it is inert to the above reaction, and for example, ether solvents such as diethyl ether, tetrahydrofuran, and dioxane, aromatic solvents such as benzene, toluene, and xylene, acetonitrile, dimethyl sulfoxide, N,N-dimethylformamide, N-methylpyrrolidone, and water can be used singly or in combination. These solvents can be used in the range of 0 to 2000 parts by mass with respect to 100 parts by mass of the reaction raw material, and the reaction temperature is preferably about from -50°C to the boiling point of the solvent, and more preferably from room temperature to 150°C. The reaction time is appropriately selected from 0.1 to 100 hours.

The above polymer can be obtained by the method described in paragraphs [0100] to [0112], simply by changing the reacting substrate to an acid halide of a biscarboxylic acid corresponding to a diol.

### [Another method for manufacturing polymer (a1-2) having repeating unit represented by general formula (3)]

In addition, another method for manufacturing the polymer (a1-2) described above includes a method of obtaining a polymer by changing the raw material used in obtaining the polymer (a1-2) described above, that is, a biscarboxylic acid, a biscarboxylic acid ester, or a halide of a biscarboxylic acid, to a malonic acid derivative [step 1], and then subjecting the obtained polymer to an addition reaction with a halide, a mesylate, or a tosylate having R₁ and R₂ as substituents under a base catalyst [step 2] to obtain the polymer. (In the following formula, X represents a halide, mesylate, or tosylate, R₁, R₂ (provided that R₂ is other than a hydrogen atom), and R₄ are as defined above.)

### [STEP 1]

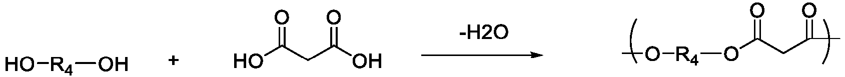

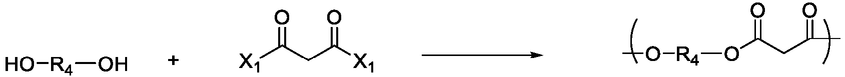

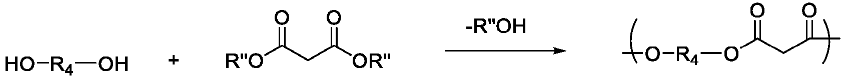

### [STEP 2]

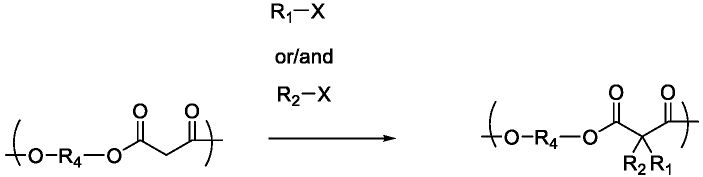

When the above reaction method is used, as with the polymer (a1-1), there are two reactive sites for the repeating unit of the polymer because of reaction selectivity, and thus a reaction rate of 100% means that R₁ and R₂ are completely introduced as substituents, and when R₁ is not R₂, the following three types are obtained, and when R₁ =R₂ =R', one type is obtained. In addition, when the reaction rate is less than 100%, it is possible to obtain a polymer with repeating units with a plurality of combinations, as shown below. When R₁ is not R₂, the following six types are obtained, and when R₁ = R₂ = R', two types are obtained. Adjusting the overall charge ratio allows control of the reaction rate for all reactive sites, and a plurality or single substituents corresponding to R₁ and R₂ can be combined to suit the required performance. For example, when the substitution rate in the repeating unit of a polymer is 100, the ratio of substitution by R₁ and R₂ is "a", and the ratio of unmodified hydrogen atoms is "b", then 0 ≤ a + b ≤ 100, with 0.5 < a ≤ 1.0 being preferable and 0.7 ≤ a ≤ 1.0 being more preferable. In this case, the relationship between R₁ and R₂ results in a polymer containing the repeating units shown below.
[Case where reaction rate is 100%]
   **R₁ ≠ R₂** 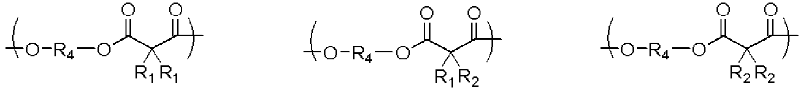
   **R₁ = R₂ = R'** 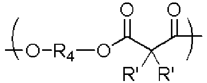
[Case where reaction rate is less than 100%]
   **R₁ ≠ R₂** 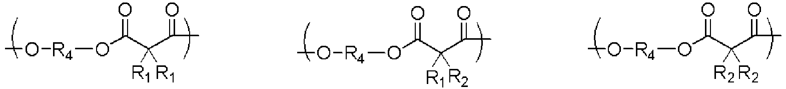 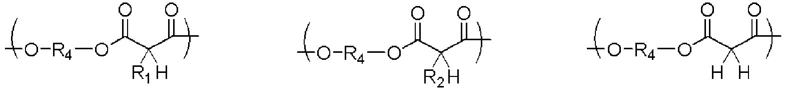
   **R₁ = R₂ = R'**

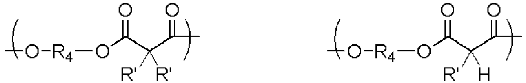

For the polymerization of [step 1], the above polymer can be obtained by the method described in paragraphs [0143] to [0148], simply by changing the raw material of the (a1-2) of biscarboxylic acid to one corresponding malonic acid. The polymer obtained in [step 1] can be used in the addition reaction in step 2. Further, in the reaction in [step 2], the polymer obtained can be obtained by the method described in paragraphs [0143] to [0148], simply by changing the polymer obtained in step 1 of the alternative method (a-1) to the polymer obtained in [step 1] above.

In the manufacturing of the polymer used in the composition for forming an organic film, obtained by these methods, it is possible to obtain the polymer that meets the required performance by combining the structure and introduction ratio of R₁ and R₂ of the polymer, as well as the method of manufacturing the polymer, according to the required performance.

For example, side chain structures that contribute to improving planarizing properties, and fluorine-containing substituents for controlling surface tension and the like to change the surface activity can be arbitrarily combined. Therefore, these polymers not only have excellent surfactant effects that contribute to improving film-forming properties, but also make it possible to achieve high levels of compatibility between various performances such as film-forming properties and embedding properties when used as an underlayer film as a composition for forming an organic film.

### [Composition for forming organic film]

The composition for forming an organic film contains (A) a resin or compound for forming an organic film, (B) a polymer described above, and (C) a solvent.

In the composition for forming an organic film according to the present invention, the (B) polymer, the (A) resin or compound for forming an organic film, and the (C) solvent can be used singly or in combination of two or more. The (B) polymer of the present invention functions as a surfactant that imparts excellent film-forming properties and high leveling performance. Its use is not limited to an organic underlayer film, and the polymer can be used in general coating materials for photolithography, and examples thereof include photosensitive resist materials and materials for forming topcoats formed on resist films. Further, the polymer can be applied not only to the organic film-forming material but also to the silicon-containing resist intermediate film, and can be used as a suitable surfactant for achieving highly versatile film-forming properties that can be applied to various film-forming materials.

Further, the (B) polymer having the repeating unit shown in (1) of the present invention can be used singly or in combination of two or more. The amount of these compounds added is set such that 0.01 to 5 parts by mass of the (B) polymer is contained per 100 parts by mass of the (A) resin or composition for forming an organic film.

### [(A) Resin or compound for forming organic film]

The (A) resin or compound for forming organic film used in the present composition for forming an organic film is not particularly limited as long as it satisfies the film-forming and curing properties of spin coating, but from the viewpoints of etching resistance, optical properties, heat resistance, and the like, it is more preferable to use a resin or compound containing an aromatic skeleton.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, and carbazole. Of these, benzene, naphthalene, fluorene, and carbazole are particularly preferable.

Examples of the (A) resin or composition for forming an organic film used in the present invention include resins containing the following structures described in JP 2012-001687 A and JP 2012-0077295 A: 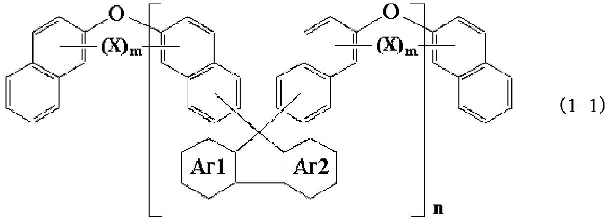
wherein the ring structures Ar1 and Ar2 represent a benzene ring or a naphthalene ring; X represents a single bond or an alkylene group having 1 to 20 carbon atoms; "m" represents 0 or 1; and "n" represents any natural number that provides a molecular weight of 100,000 or less, wherein the symbols in the formula are only applicable to this formula, 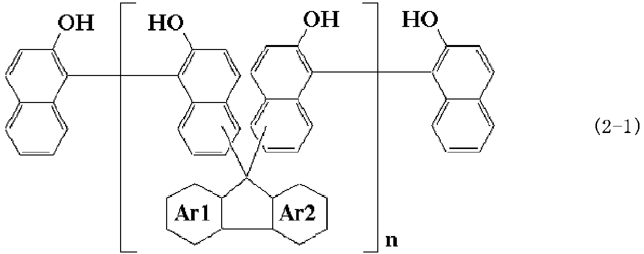
wherein the ring structures Ar1 and Ar2 represent a benzene ring or a naphthalene ring; "n" is any natural number that provides a weight average molecular weight of 100,000 or less, in terms of polystyrene, as determined by gel permeation chromatography, wherein the symbols in the formula are only applicable to this formula.

Further examples of the (A) resins or compounds for forming an organic film used in the present invention include resins containing the following structures described in JP 2004-264710 A, JP 2005-043471 A, JP 2005-250434 A, JP 2007-293294 A, and JP 2008-065303 A: 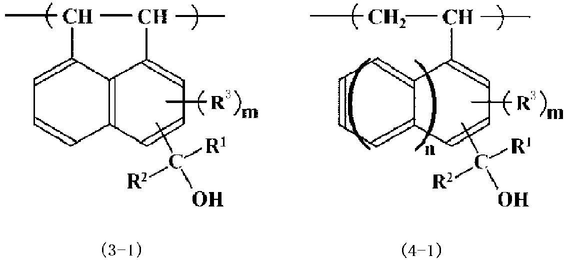
wherein R¹ and R² represent a hydrogen atom, an alkyl group having 1 to 3 carbon atoms, or an aryl group; R³ represents an alkyl group having 1 to 3 carbon atoms, a vinyl group, an allyl group, or an aryl group which may be substituted; "n" represents 0 or 1; and "m" represents 0, 1, or 2, wherein the symbols in the formula apply only to this formula, 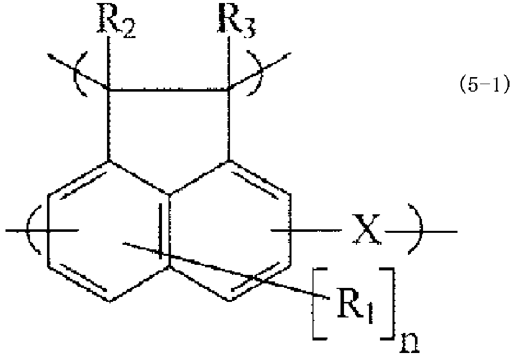
wherein R₁ is a monovalent atom or group other than a hydrogen atom; "n" represents an integer of 0 to 4, provided that when "n" is 2 to 4, a plurality of R₁s may be the same or different; R₂ and R₃ are independently monovalent atoms or groups; and X is a divalent group, wherein the symbols in the formula are only applicable to this formula, 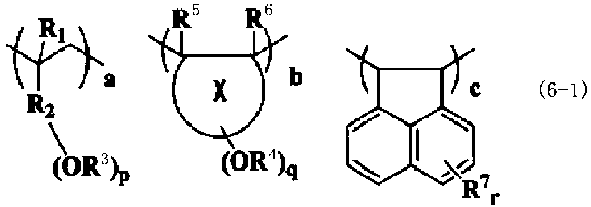
wherein R₁ is a hydrogen atom or a methyl group, R₂ is a single bond, a linear, branched, or cyclic alkylene group having 1 to 20 carbon atoms, or an arylene group having 6 to 10 carbon atoms, and may have ether, ester, lactone, or amide; R³ and R⁴ are each a hydrogen atom or a glycidyl group; X represents a polymer of a hydrocarbon having an indene skeleton, a cycloolefin having 3 to 10 carbon atoms, or a maleimide, and may have ether, ester, lactone, or carboxylic acid anhydride; R⁵ and R⁶ are each a hydrogen atom, a fluorine atom, a methyl group, or a trifluoromethyl group; R⁷ is a hydrogen atom, a linear, branched, or cyclic alkyl group having 1 to 6 carbon atoms, a hydroxy group, or an alkoxycarbonyl group; "p" and "q" are each an integer of 1 to 4; "r" represents an integer of 0 to 4; "a", "b", and "c" are in the ranges 0.5 ≤ a + b + c ≤ 1, 0 ≤ a ≤ 0.8, 0 ≤ b ≤ 0.8, 0.1 ≤ a + b ≤ 0.8, and 0.1 ≤ c ≤ 0.8, respectively, wherein the symbols in the formula apply only to this formula, 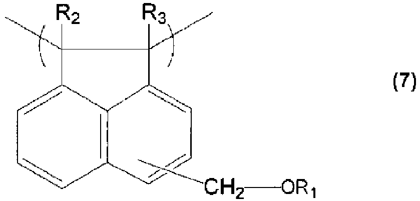
wherein R₁ represents a hydrogen atom or a monovalent organic group; and R₂ and R₃ each independently represent a monovalent atom or a monovalent organic group, wherein the symbols in the formula are only applicable to this formula.

Specific examples of the (A) resin or compound for forming an organic film used in the present invention include resins containing the following structures described in JP 2004-205685 A, JP 2007-171895 A, and JP 2009-014816 A: 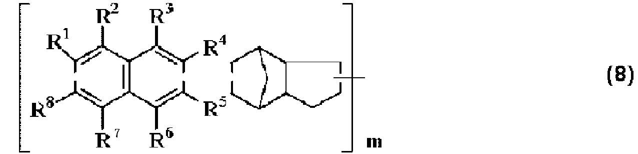 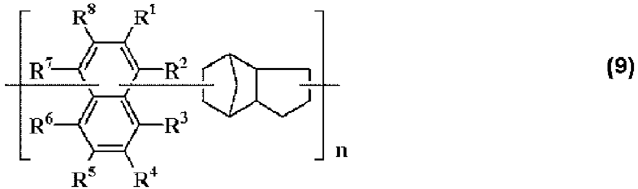
wherein R¹ to R⁸ are each independently a hydrogen atom, a hydroxy group, an alkyl group having 1 to 6 carbon atoms, which may be substituted, an alkoxy group having 1 to 6 carbon atoms, which may be substituted, an alkoxycarboxyl group having 2 to 6 carbon atoms, which may be substituted, an aryl group having 6 to 10 carbon atoms, which may be substituted, a hydroxyalkyl group having 1 to 6 carbon atoms, an isocyanate group, or a glycidyl group; and "m" and "n" are positive integers, wherein the symbols in the formulae are applicable only to this formula, 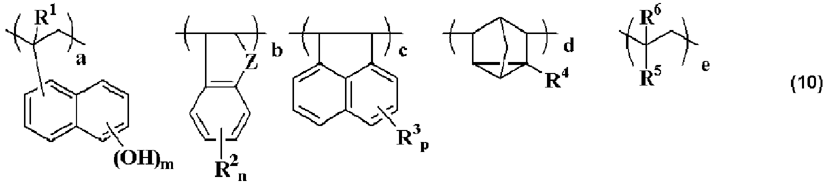
wherein R¹ and R⁶ are hydrogen atoms or methyl groups; R², R³, and R⁴ are a hydrogen atom, an alkyl group having 1 to 4 carbon atoms, an alkoxy group, a hydroxy group, an acetoxy group, or an alkoxycarbonyl group, or an aryl group having 6 to 10 carbon atoms; R⁵ is a condensed polycyclic hydrocarbon group having 13 to 30 carbon atoms, -O-R⁷, -C(=O)-O-R⁷, -O-C(=O)-R⁷, or - C(=O)-NR⁸-R⁷; "m" is 1 or 2; "n" represents an integer of 0 to 4; "p" represents an integer of 0 to 6; R⁷ represents an organic group having 7 to 30 carbon atoms, R⁸ is a hydrogen atom, or a hydrocarbon group having 1 to 6 carbon atoms; Z represents any of a methylene group, - O-, -S- or -NH-; "a", "b", "c", "d", and "e" are in the ranges 0 < a < 1.0, 0 ≤ b ≤ 0.8, 0 ≤ c ≤ 0.8, 0 ≤ d ≤ 0.8, 0 ≤ e ≤ 0.8, and 0 < b + c + d + e < 1.0, respectively, wherein the symbols in the formula are applicable only to this formula, 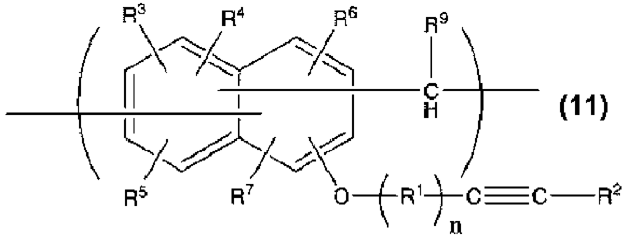
wherein n represents 0 or 1; R¹ is a methylene group which may be substituted, an alkylene group having 2 to 20 carbon atoms, which may be substituted, or an arylene group having 6 to 20 carbon atoms, which may be substituted; R² is a hydrogen atom, an alkyl group having 1 to 20 carbon atoms, which may be substituted, or an aryl group having 6 to 20 carbon atoms, which may be substituted; R³ to R⁷ each represent a hydroxy group, an alkyl group having 1 to 6 carbon atoms, which may be substituted, an alkoxy group having 1 to 6 carbon atoms, which may be substituted, an alkoxycarbonyl group having 2 to 10 carbon atoms, which may be substituted, an aryl group having 6 to 14 carbon atoms, which may be substituted, or a glycidyl ether group having 2 to 6 carbon atoms, which may be substituted; R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms, wherein the symbols in the formula are applicable only to this formula.

Examples of the formula (11) include the following resins.

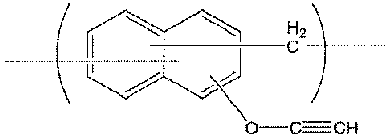

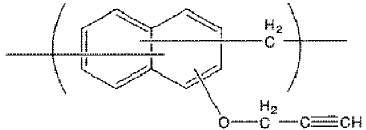

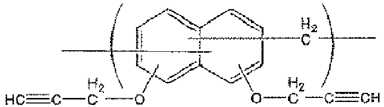

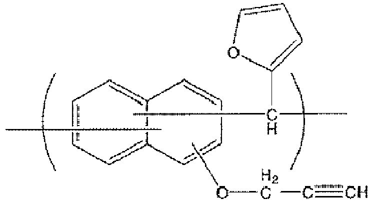

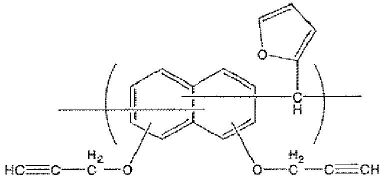

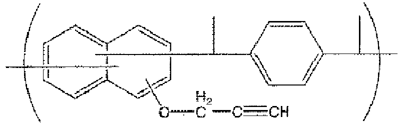

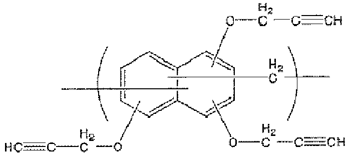

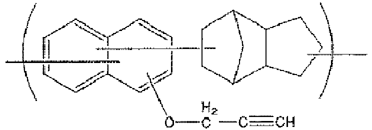

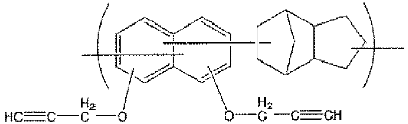

Examples of the (A) resin or compound for forming an organic film used in the present invention include resins containing the following structures described in JP 2007-199653 A, JP 2008-274250 A, and JP 2010-122656 A: 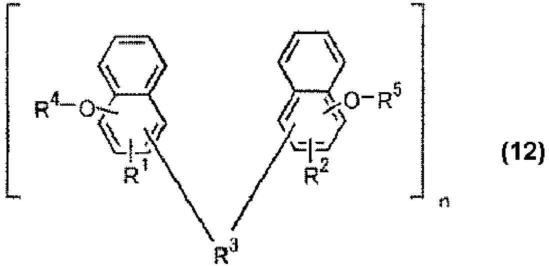
wherein R¹ and R² are independently the same or different hydrogen atoms, linear, branched, or cyclic alkyl groups having 1 to 10 carbon atoms, aryl groups having 6 to 10 carbon atoms, or alkenyl groups having 2 to 10 carbon atoms; R³ is a single bond or an alkylene group having a linear, branched, or cyclic structure having 1 to 30 carbon atoms, which may have a bridged cyclic hydrocarbon group, a double bond, a heteroatom, or an aromatic group having 6 to 30 carbon atoms; R⁴ and R⁵ are independently hydrogen atoms or glycidyl groups; and "n" represents an integer of 1 to 4, wherein the symbols in the formula is applicable only to this formula, 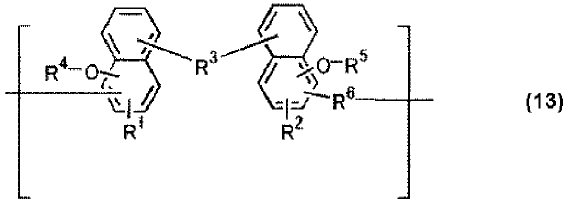
wherein R¹ and R² are independently the same or different hydrogen atoms, linear, branched, or cyclic alkyl groups having 1 to 10 carbon atoms, aryl groups having 6 to 10 carbon atoms, or alkenyl groups having 2 to 10 carbon atoms; R³ is a single bond or an alkylene group having a linear, branched, or cyclic structure having 1 to 30 carbon atoms, which may have a bridged cyclic hydrocarbon group, a double bond, a heteroatom, or an aromatic group having 6 to 30 carbon atoms; R⁴ and R⁵ are each independently a hydrogen atom or a glycidyl group; and R⁶ is a single bond or a linear or branched alkylene group having 1 to 10 carbon atoms, wherein the symbols in the formula are applicable only to this formula, 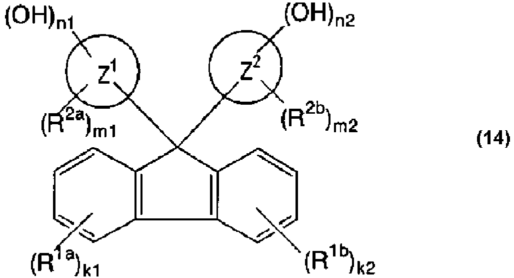
wherein a ring Z¹ and a ring Z² represent condensed polycyclic aromatic hydrocarbon rings; R^{1a}, R^{1b}, R^{2a}, and R^{2b}, which are the same or different, represent a substituent; "k1" and "k2", which are the same or different, represent 0 or an integer of 1 to 4; "m1" and "m2" are each 0 or an integer of 1 or more; and "n1" and "n2" are each 0 or an integer of 1 or more, provided that n1 + n2 ≥ 1, wherein the symbols in the formula are applicable only to this formula, 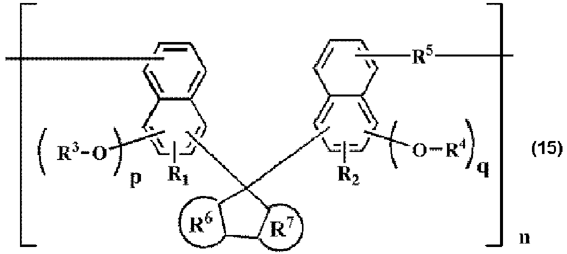
wherein R¹ and R², which are the same or different, a hydrogen atom, a linear, branched, or cyclic alkyl group having 1 to 10 carbon atoms, an aryl group having 6 to 10 carbon atoms, or an alkenyl group having 2 to 10 carbon atoms; R³ and R⁴ are each a hydrogen atom or a glycidyl group; R⁵ is a single bond or a linear or branched alkylene group having 1 to 10 carbon atoms; and R⁶ and R⁷ are each a benzene ring or a naphthalene ring; "p" and "q" are each 1 or 2; and "n" is 0 < n ≤ 1, wherein the symbols in the formula are applicable only to this formula.

Examples of the formula (15) include the following resins.

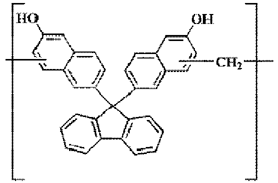

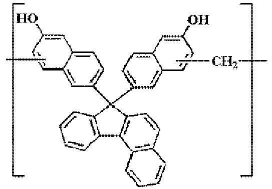

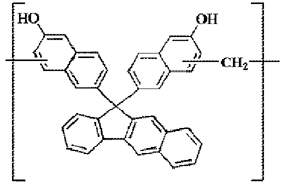

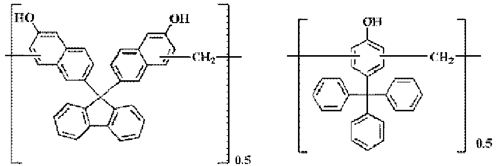

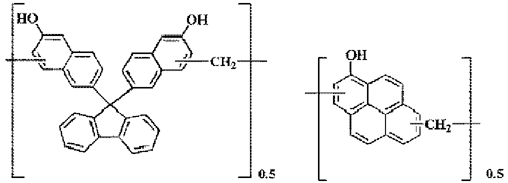

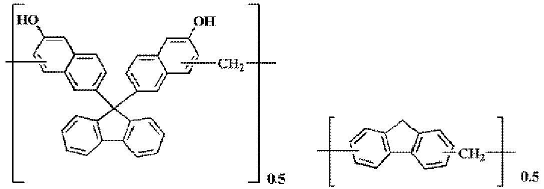

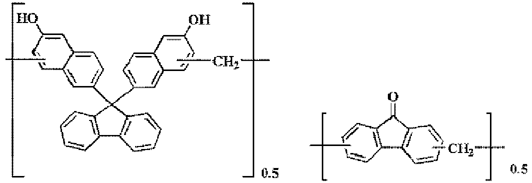

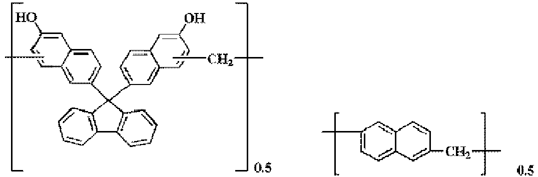

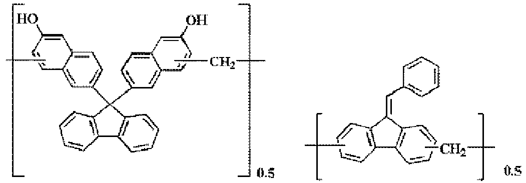

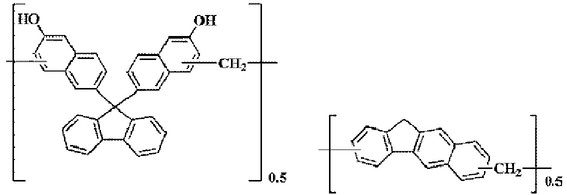

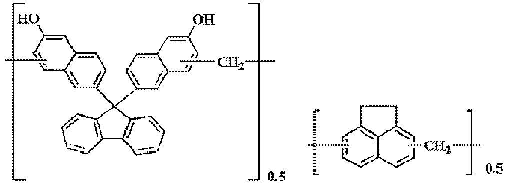

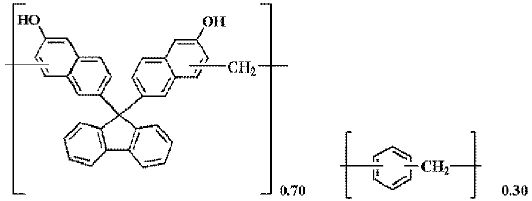

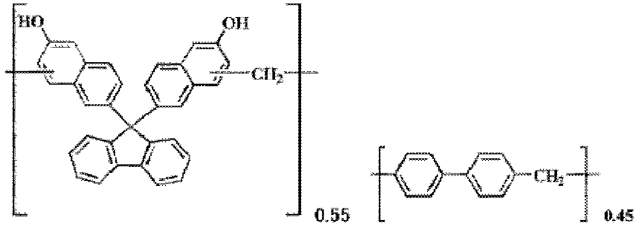

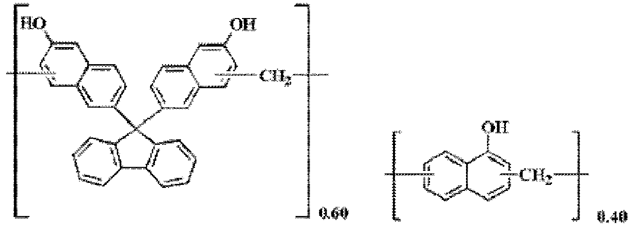

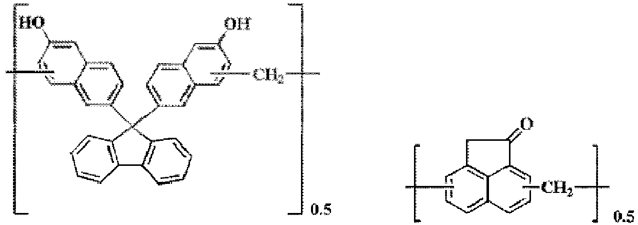

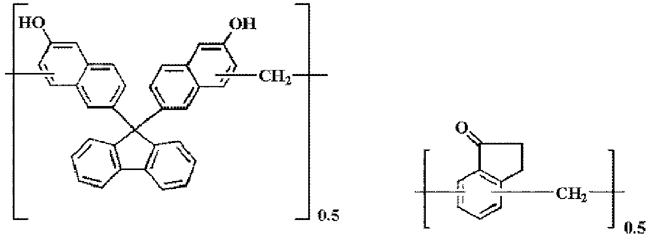

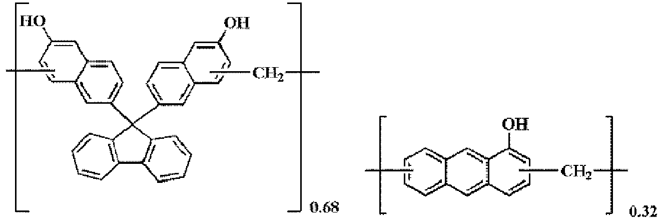

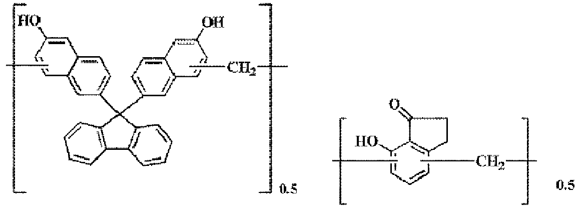

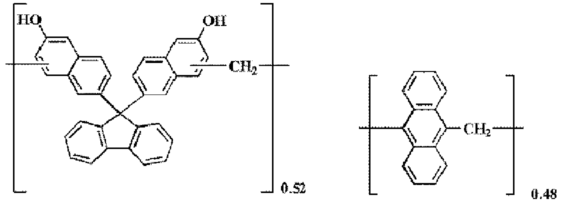

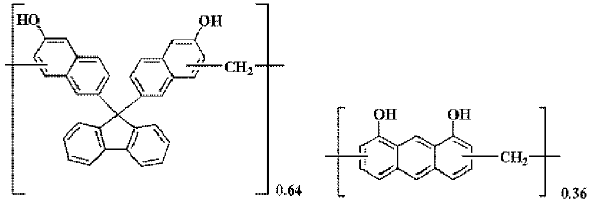

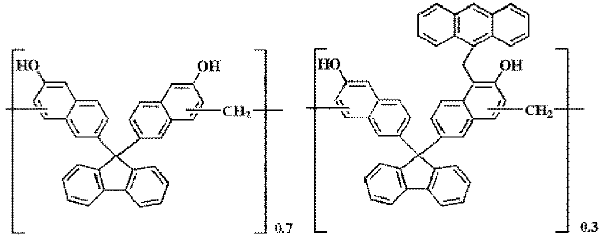

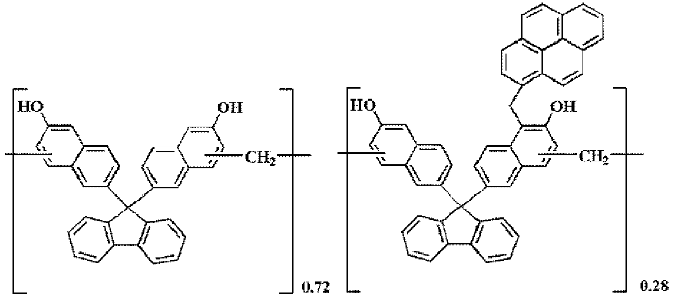

Examples of the (A) resin or compound for forming an organic film used in the present invention include resins containing the following structure described in JP 2012-214720 A: 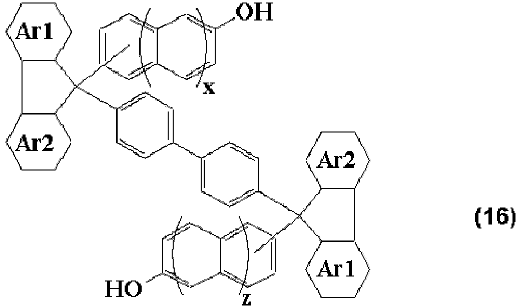 wherein the ring structures Ar1 and Ar2 represent a benzene ring or a naphthalene ring; and "x" and "z" each independently represent 0 or 1, wherein the symbols in the formula are applicable only to this formula.

Examples of the (A) resin or compound for forming an organic film used in the present invention include the resins described in JP 2014-29435 A: 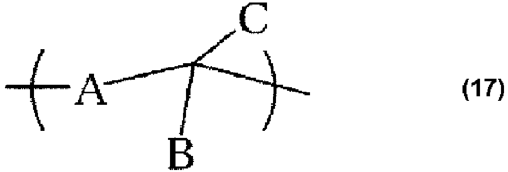 wherein A represents a structure having carbazole; B represents a structure having an aromatic ring; and C represents a hydrogen atom, an alkyl group, or a structure having an aromatic ring, wherein B and C may form a ring together, and the combined structure of A, B, and C has 1 to 4 carboxyl groups or salts thereof, or carboxylate ester groups, wherein the symbols in the formula are applicable only to this formula.

In addition, as the (A) resin or compound for forming an organic film used in the present invention, a polymer including a unit structure represented by the following formula (18) and a unit structure represented by the following formula (19) described in WO 2012/077640 in which the ratio between the unit structure represented by the formula (18) and the unit structure represented by the formula (19) is 3 to 97:97 to 3 in a molar ratio can be exemplified: 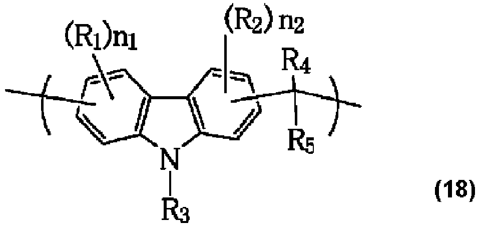 wherein R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of these groups which may include an ether bond, a ketone bond, or an ester bond; R₃ represents a hydrogen atom, an alkyl group having 1 to 10 carbon atoms, an alkenyl group having 2 to 10 carbon atoms, an aryl group having 6 to 40 carbon atoms, or a combination of these groups which may include an ether bond, a ketone bond, or an ester bond; R₄ represents a hydrogen atom, or an aryl group having 6 to 40 carbon atoms, which may be substituted with a halogen atom, a nitro group, an amino group, or a hydroxy group, or a heterocyclic group; R₅ represents a hydrogen atom, or an alkyl group having 1 to 10 carbon atoms, which may be substituted with a halogen atom, a nitro group, an amino group, or a hydroxy group, an aryl group having 6 to 40 carbon atoms, or a heterocyclic group, R₄ and R₅ may form a ring together; and "n1" and "n2" each represent an integer of 1 to 3, wherein the symbols in the formula are applicable only to this formula, 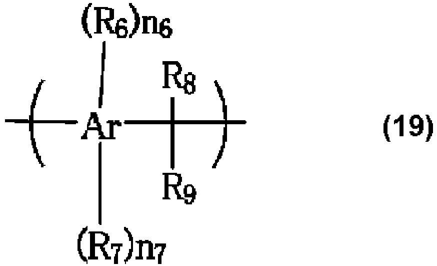 wherein Ar represents an aromatic ring group having 6 to 20 carbon atoms; R₆ represents a hydroxy group; R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of these groups that may include an ether bond, a ketone bond, or an ester bond; R₈ represents a hydrogen atom, or an aryl group having 6 to 40 carbon atoms or a heterocyclic group, which may be substituted with a halogen atom, a nitro group, an amino group, or a hydroxy group; R₉ represents a hydrogen atom, or an alkyl group having 1 to 10 carbon atoms, an aryl group having 6 to 40 carbon atoms, or a heterocyclic group, which may be substituted with a halogen atom, a nitro group, an amino group, or a hydroxy group, wherein R₈ and R₉ may form a ring together; "n6" represents an integer of 1 to p; and "n7" represents an integer of p - n6, wherein "p" represents the maximum number of substituents with which the aromatic ring group Ar can be substituted, wherein the symbols in the formula are applicable only to this formula.

An example of the (A) resin or compound for forming an organic film used in the present invention includes a polymer containing a unit structure represented by the following formula (20) described in WO 2010-147155: 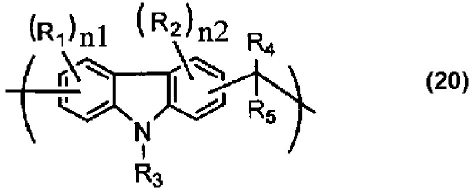 wherein R₁ and R₂ are each selected from the group consisting of a hydrogen atom, a halogen group, a nitro group, an amino group, a hydroxy group, an alkyl group having 1 to 10 carbon atoms, an alkenyl group having 2 to 10 carbon atoms, an aryl group having 6 to 40 carbon atoms, and combinations thereof, wherein the alkyl group, the alkenyl group, or the aryl group may include an ether bond, a ketone bond, or an ester bond; R₃ is selected from the group consisting of a hydrogen atom, an alkyl group having 1 to 10 carbon atoms, an alkenyl group having 2 to 10 carbon atoms, an aryl group having 6 to 40 carbon atoms, and combinations thereof, wherein the alkyl group, the alkenyl group, or the aryl group may include an ether bond, a ketone bond, or an ester bond; R₄ represents an aryl group having 6 to 40 carbon atoms or a heterocyclic group, which may be substituted with a halogen group, a nitro group, an amino group, or a hydroxy group; R₅ represents a hydrogen atom, or an alkyl group having 1 to 10 carbon atoms, an aryl group having 6 to 40 carbon atoms, or a heterocyclic group, which may be substituted with a halogen group, a nitro group, an amino group, or a hydroxy group, wherein R₄ and R₅ may form a ring together with the carbon atom to which they are bonded; and "n1" and "n2" are each an integer of 1 to 3, wherein the symbols in the formula are applicable only to this formula.

Examples of the (A) resin or compound for forming an organic film used in the present invention include novolac resins obtained by reacting one or more of phenols such as phenol, cresol, xylenol, catechol, resorcinol, hydroquinone, pyrogallol, hydroxyquinol, and phloroglycinol with one or more of aldehyde sources such as formaldehyde, paraformaldehyde, and trioxane using an acid catalyst, and resins containing a repeating unit structure represented by the following formula (21) described in WO 2012-176767: 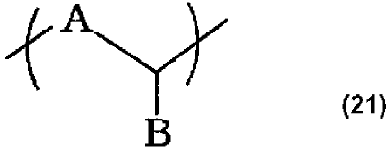 wherein A represents a hydroxyl-substituted phenylene group derived from polyhydroxybenzene; and B represents a monovalent condensed aromatic hydrocarbon ring group in which 2 to 6 benzene rings are condensed, wherein the symbols in the formula are applicable only to this formula.

Examples of the (A) resin or compound for forming an organic film in the present invention include novolac resins having a fluorene or tetrahydrospirobiindene structure described in JP 2005-128509 A, JP 2006-259249 A, JP 2006-259482 A, JP 2006-293298 A, and JP 2007-316282 A, which include a repeating unit structure represented by the following formula (22-1) or (22-2): 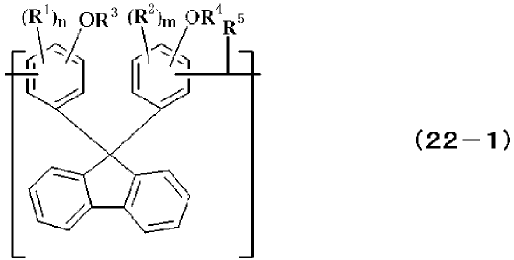 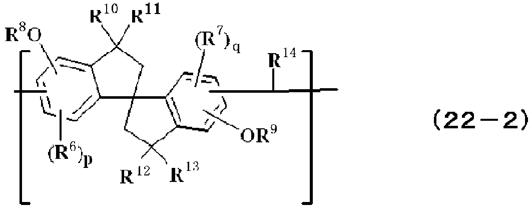 wherein R¹, R², R⁶, and R⁷ are independently a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ are independently a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ are independently a hydrogen atom, a linear, branched, or cyclic alkyl group having 1 to 10 carbon atoms, or an aryl group having 6 to 10 carbon atoms; "n", "m", "p", and "q" are integers of 1 to 3; and R¹⁰ to R¹³ are each independently a hydrogen atom, a halogen atom, a hydroxy group, a linear, branched, or cyclic alkyl group having 1 to 6 carbon atoms, or a linear, branched, or cyclic alkoxy group having 1 to 6 carbon atoms, wherein the symbols in the formula are applicable only to this formula.

As the (A) resin or compound for forming an organic film used in the present invention, a reaction product obtained by the method described in JP 2012-145897 A can be exemplified. More specifically, a polymer obtained by condensing one or more compounds represented by the following general formula (23-1) and/or (23-2) with one or more compounds represented by the following general formula (24-1) and/or (24-2) and/or the equivalents thereof can be exemplified: 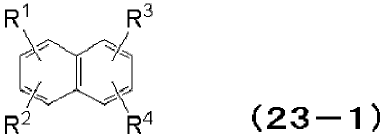 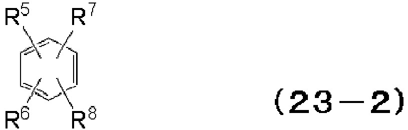
wherein R¹ to R⁸ are each independently a hydrogen atom, a halogen atom, a hydroxy group, an isocyanato group, a glycidyloxy group, a carboxyl group, an amino group, an alkoxy group having 1 to 30 carbon atoms, an alkoxycarbonyl group having 1 to 30 carbon atoms, an alkanoyloxy group having 1 to 30 carbon atoms, or a saturated or unsaturated organic group having 1 to 30 carbon atoms, which may be substituted, wherein any two substituents selected from R¹ to R⁴ or R⁵ to R⁸ may be bonded to each other in the molecule to form a cyclic substituent, wherein the symbols in the formula are applicable only to this formula, 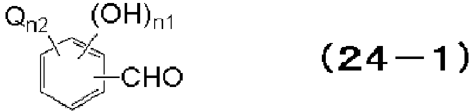 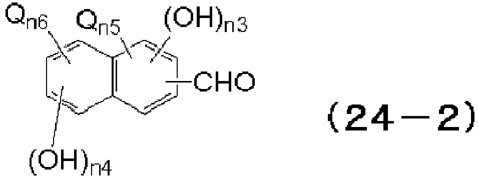
wherein Q represents an organic group having 1 to 30 carbon atoms, which may be substituted, wherein any two Qs selected in the molecule may be bonded to form a cyclic substituent; "n1" to "n6" are the number of each substituent, and n1 to n6 = 0, 1, and 2, wherein in the formula (24-1), hydroxybenzaldehyde is excluded, and in the formula (24-2), the relationships 0 ≤ n3 + n5 ≤ 3, 0 ≤ n4 + n6 ≤ 4, and 1 ≤ n3 + n4 ≤ 4 are satisfied, wherein the symbols in the formula are applicable only to this formula.

In addition, a polymer obtained by condensing one or more compounds represented by the above general formula (23-1) and/or (23-2), one or more compounds represented by the above general formula (24-1) and/or (24-2) and/or the equivalents thereof, and one or more compounds represented by the following general formula (25) and/or the equivalents thereof can be exemplified:

Y-CHO (25)

wherein Y is a hydrogen atom or a monovalent organic group having 30 or less carbon atoms, which may have a substituent, and the formula (25) is different from the general formula (24-1) and the general formula (24-2), wherein the symbols in the formula are applicable only to this formula.

As the (A) resin or compound for forming an organic film used in the present invention, a compound having the following structure described in JP 2017-119671 A can be exemplified: 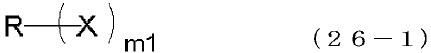
wherein R is a single bond or an organic group having 1 to 50 carbon atoms; X is a group represented by the following general formula (26-2); and "m1" represents an integer satisfying 2 ≤ m1 ≤ 10, wherein the symbols in the formula are applicable only to this formula, 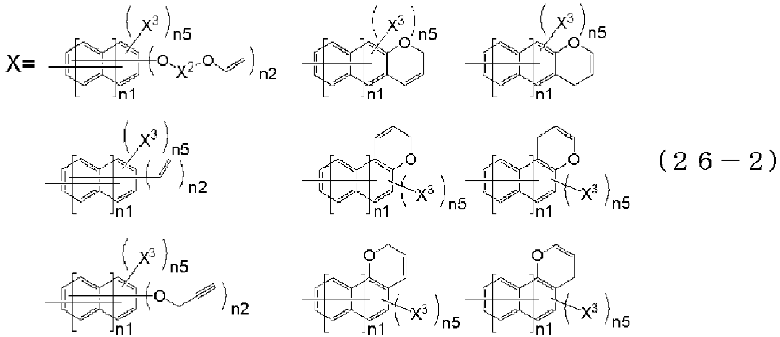
wherein X² is a divalent organic group having 1 to 10 carbon atoms; "n1" is 0 or 1; "n2" is 1 or 2; X³ is a group represented by the following general formula (26-3); and "n5" is 0, 1 or 2, wherein the symbols in the formula are applicable only to this formula, 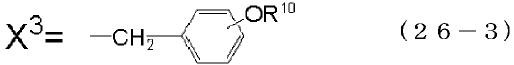
wherein R¹⁰ is a hydrogen atom or a saturated or unsaturated hydrocarbon group having 1 to 10 carbon atoms, wherein the hydrogen atom on the benzene ring in the formula may be replaced by a methyl group or a methoxy group, wherein the symbols in the formula are applicable only to this formula.

Examples of compounds containing the above structure include the following compounds:

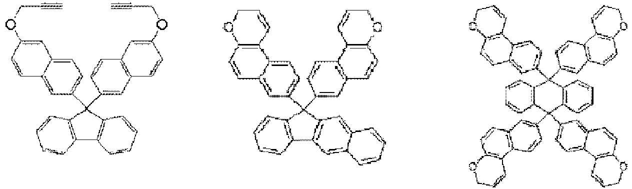

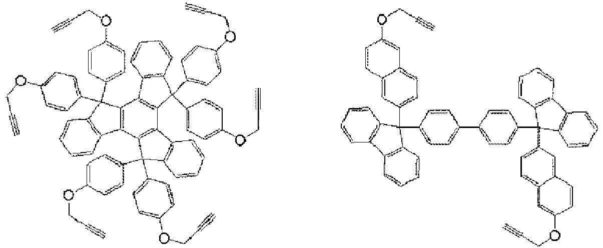

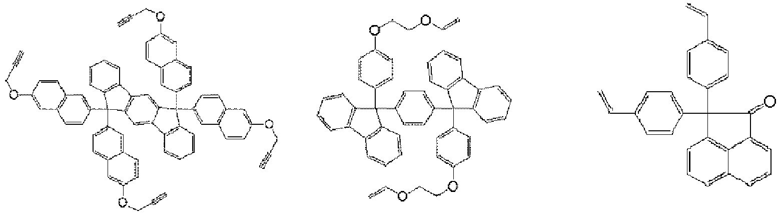

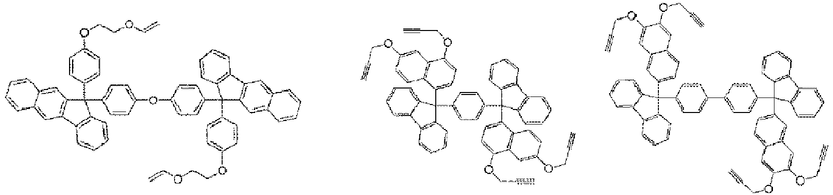

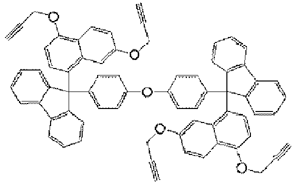

As the (A) resin or compound for forming an organic film used in the present invention, a polymer having a repeating unit represented by the following general formula (27-1) described in JP 2019-044022 A can be exemplified: 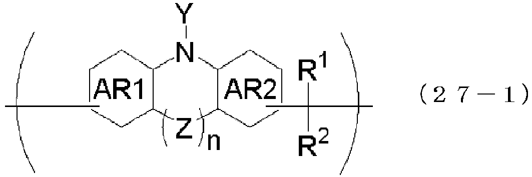
wherein AR1 and AR2 are benzene or naphthalene rings which may have a substituent; R¹ and R² are each independently a hydrogen atom or an organic group having 1 to 30 carbon atoms, and when R¹ and R² are organic groups, R¹ and R² may be bonded to each other within the molecule to form a cyclic organic group; "n" is 0 or 1, wherein when n = 0, AR1 and AR2 do not form a bridge structure between the aromatic rings of AR1 and AR2 via Z, and when n = 1, AR1 and AR2 form a bridge structure between the aromatic rings of AR1 and AR2 via Z; Z is either a single bond or the following formula (27-2); and Y is a group represented by the following formula (27-3), wherein the symbols in the formula are applicable only to this formula, 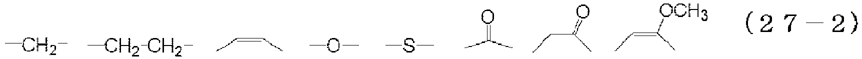 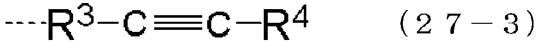
wherein R³ is a single bond or a divalent organic group having 1 to 20 carbon atoms; R⁴ is a hydrogen atom or a monovalent organic group having 1 to 20 carbon atoms; and the dashed line indicates an attachment point, wherein the symbols in the formula are applicable only to this formula.

As the polymers having repeating units represented by the above general formula (27-1), the following polymers can be exemplified.

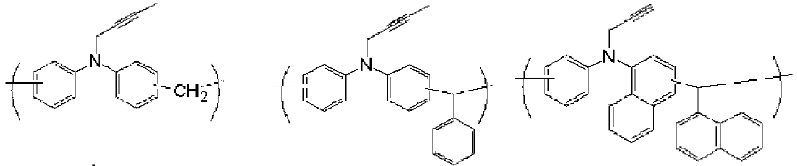

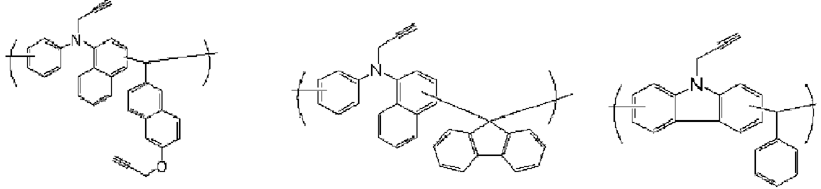

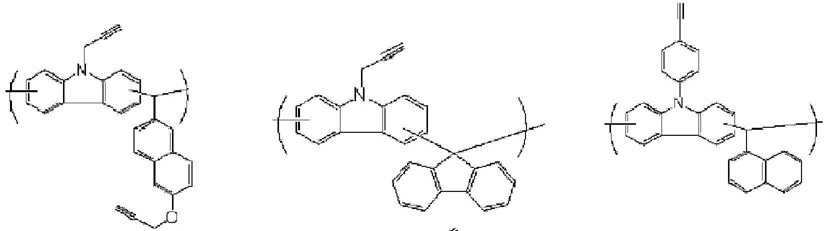

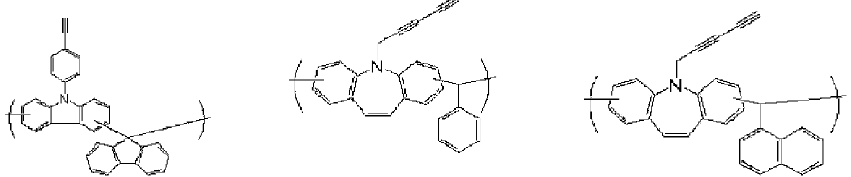

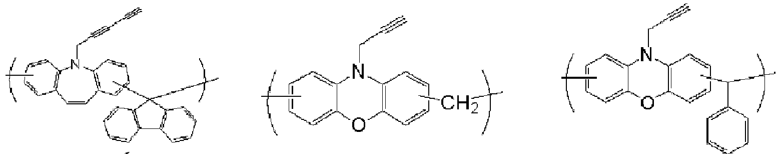

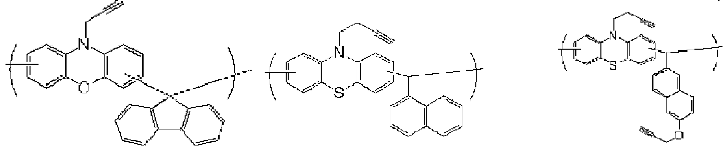

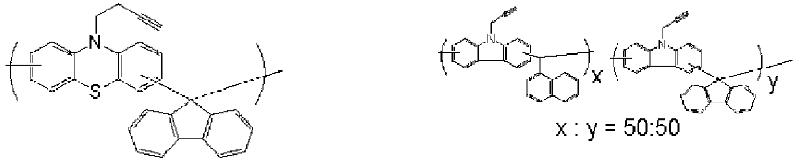

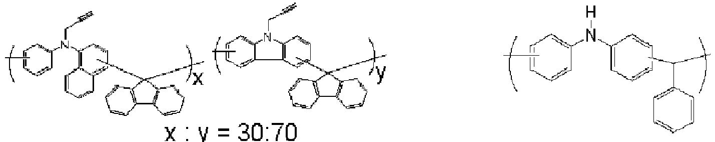

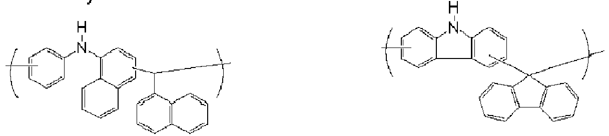

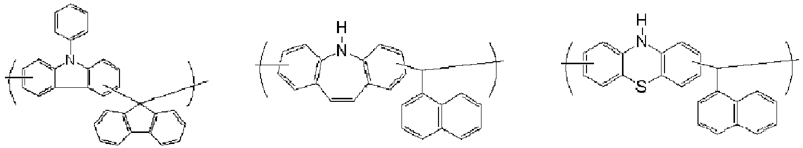

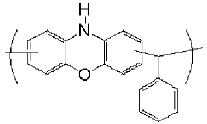

The (A) resin or compound for forming an organic film may be synthesized by a known method, or a commercially available product may be used.

The amount of the (A) resin or compound for forming an organic film is not particularly limited as long as the film-forming properties of the spin coating of the composition for forming an organic film are satisfactory. However, the amount of the (A) resin or compound for forming an organic film is preferably 10 to 40 parts by mass, more preferably 10 to 30 parts by mass, and further preferably 10 to 25 parts by mass, with respect to 100 parts by mass of the composition for forming an organic film. For example, when embedding holes or trenches with a very high aspect ratio of a 3D NAND memory architecture with a composition for forming an organic film, it is necessary to increase the amount of the resin for forming an organic film, but such a composition for forming an organic film has a high viscosity, and the in-plane uniformity and embedding properties after spin coating are deteriorated. With the blend ratio of the above-described (A) resin for forming an organic film, the compositions for forming an organic film of the present invention can be suitably applied because they can form organic films with excellent in-plane uniformity and embedding properties.

Further, it is preferable that the content of the (B) polymer is 0.01 to 5 parts by mass with respect to 100 parts by mass of the (A) resin or compound for forming an organic film. When the composition for forming an organic film includes a polymer with such a content, the in-plane uniformity of the formed organic film is superior.

The (C) solvent that can be used in the material for forming an organic film of the present invention is not particularly limited as long as it can dissolve the (A) resin or compound for forming an organic film and the (B) compound, and is preferably one that can also dissolve the acid generator, crosslinking agent, surfactant, and the like described below. Specifically, solvents with a boiling point of less than 180°C, such as those described in paragraphs (0091) to (0092) of JP 2007-199653 A, can be used. Of these, propylene glycol monomethyl ether acetate, propylene glycol monomethyl ether, 2-heptanone, cyclopentanone, cyclohexanone, and mixtures of two or more thereof are preferably used.

The content of the (C) solvent is 200 to 10,000 parts by mass, and more preferably 300 to 5,000 parts by mass, with respect to 100 parts of the (A) resin or compound for forming an organic film. Setting it in this range allows the concentration to be adjusted according to the film thickness to be consumed.

Further, in the materials for forming an organic film of the present invention, it is also possible to add a high boiling point solvent having a boiling point of 180°C or more to the above-described solvent having a boiling point of less than 180°C as an organic solvent (a mixture of a solvent having a boiling point of less than 180°C and a solvent having a boiling point of 180°C or more). The high-boiling organic solvent is not particularly limited as long as it can dissolve the compound for forming an organic film, and may be, for example, a hydrocarbon, an alcohol, a ketone, an ester, an ether, or a chlorine-based solvent. Specific examples thereof include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripro-pylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono n-butyl ether, diethylene glycol mono isobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol mono methyl ether, triethylene glycol n-butyl ether, triethylene glycol butyl methyl ether, triethylene glycol diacetate, tetraethylene glycol dimethyl ether, dipropylene glycol mono methyl ether, dipropylene glycol mono n-propyl ether, dipropylene glycol Mono n-butyl ether, tripropylene glycol dimethyl ether, tripropylene glycol monomethyl ether, tripropylene glycol mono n-propyl ether, tripropylene glycol mono n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, dihexyl malonate, diethyl succinate, dipropyl succinate, dibutyl succinate, dihexyl succinate, dimethyl adipate, diethyl adipate, and dibutyl adipate, and these may be used singly or in combination.

The boiling point of the high boiling point solvent may be appropriately selected according to the temperature at which the material for forming an organic film is heat-treated. The boiling point of the high boiling point solvent to be added is preferably 180°C to 300°C, more preferably 200°C to 300°C. When the boiling point is too low, there is no risk of the solvent volatilizing too quickly during baking (heat treatment), and thus sufficient thermal fluidity can be obtained. In addition, when the boiling point is high, there is no risk of the solvent remaining in the film after baking without volatilizing, and thus there is no risk of adversely affecting the film properties such as etching resistance.

When using the above high boiling point solvent, the amount of the high boiling point solvent is preferably 1 to 30 parts by mass with respect to 100 parts by mass of the solvent with a boiling point of less than 180°C. With such an amount, there is no risk of the amount being too small to impart sufficient thermal fluidity during baking, or the amount being too large to remain in the film, leading to deterioration of the film properties such as etching resistance.

When such a material for forming an organic film is used, a high boiling point solvent is added to the above resin or compound for forming an organic film, which is then provided with thermal fluidity, resulting in a material for forming an organic film, which has both high embedding and planarizing properties.

### [Other components]

In addition, an acid generator or crosslinking agent can be added to the composition for forming an organic film of the present invention to further promote the crosslinking reaction. As the acid generator, there are those that generate an acid by thermal decomposition and those that generate an acid by light irradiation, and either of them can be added. Specific examples of the acid generator include those described in paragraphs [0061] to [0085] of JP 2007-199653 A. The above acid generators can be used singly or in combination of two or more. When an acid generator is added, the amount of the acid generator is preferably 0.05 to 50 parts by mass, more preferably 0.1 to 10 parts by mass, with respect to 100 parts by mass of the (A) resin or compound for forming an organic film. This amount accelerates the cross-linking reaction and allows the formation of a dense membrane.

As specific examples of crosslinking agents, those described in paragraphs [0055] to [0060] of JP 2007-199653 A are exemplified. The crosslinking agents can be used singly or in combination of two or more. The amount of crosslinking agent added is preferably 1 to 100 parts by mass, more preferably 5 to 50 parts by mass, with respect to 100 parts by mass of the (A) resin or compound for forming an organic film. Such an amount enhances the curing properties and makes it possible to further suppress intermixing with the upper layer film.

In addition, a surfactant other than the (B) compound of the present invention can be added to the composition for forming an organic film of the present invention in order to further improve the in-plane uniformity in spin coating. As specific examples of the surfactant, those described in paragraphs [0142] to [0147] of JP 2009-269953 A can be exemplified. The above surfactants can be used singly or in combination of two or more. When a surfactant is added, the amount of the surfactant is preferably 0.01 to 10 parts by mass, more preferably 0.05 to 5 parts by mass, with respect to 100 parts by mass of the resin or compound for forming an organic film. With such an amount, an organic film with excellent in-plane uniformity can be formed.

Further, a basic compound can be added to the composition for forming an organic film of the present invention to improve storage stability. The basic compound acts as an acid quencher to prevent a small amount of acid generated from the acid generator from proceeding with the crosslinking reaction. As specific examples of such basic compounds, those described in paragraphs [0086] to [0090] of JP 2007-199653 A can be exemplified. The above basic compounds can be used singly or in combination of two or more. The amount of the basic compounds added is preferably 0.05 to 50 parts by mass, more preferably 0.1 to 10 parts by mass, with respect to 100 parts by mass of the (A) resin or compound for forming an organic film. With such an amount, it is possible to improve the storage stability of the composition for forming an organic film.

As described above, the composition for forming an organic film of the present invention is a composition for forming an organic film, which is excellent in suppressing humps during the EBR step.

Therefore, the composition for forming an organic film of the present invention is extremely useful as a resist underlayer film material (organic film material) for multi-layer resist processes such as a two-layer resist process, a three-layer resist process using a silicon-containing resist intermediate film or a silicon-containing inorganic hard mask intermediate film, and a four-layer resist process using a silicon-containing resist intermediate film or a silicon-containing inorganic hard mask intermediate film and an organic antireflective film or adhesive film.

### [Method for forming organic film]

The present invention provides a method for forming an organic film used in a process for manufacturing a semiconductor device, which includes spin-coating the composition for forming an organic film of the present invention on a substrate to be processed, and heat-treating the substrate coated with the composition for forming an organic film at a temperature of 100°C or more and 600°C or less for 10 to 600 seconds to cure the organic film.

In this method for forming an organic film, first, the composition for forming an organic film of the present invention described above is spin-coated onto the substrate to be processed. Using the spin-coating method allows favorable embedding properties to be obtained. After removing the coating film from the edge in the EBR step, baking (heat treatment) is performed to promote the crosslinking reaction. In addition, this baking can evaporate the solvent in the composition, and thus mixing can be prevented when forming a resist upper layer film or a silicon-containing resist intermediate film on the organic film.

Baking is preferably performed at a temperature between 100°C and 600°C for 10 to 600 seconds, more preferably at a temperature between 200°C and 500°C for 10 to 300 seconds. In consideration of the effect on device damage and wafer deformation, the upper limit of the heating temperature in the lithography wafer process is preferably 600°C or less, more preferably 500°C or less. Performing heat treatment under these conditions promotes the crosslinking reaction, and an organic film that does not mix with the film formed on the upper layer can be formed.

### [Pattern forming method]

The following describes a pattern forming method using the present composition for forming an organic film.

### [Three-layer resist process using silicon-containing resist intermediate film]

The present invention provides a pattern forming method including: forming an organic film on a body to be processed using the composition for forming an organic film described above; forming a silicon-containing resist intermediate film on the organic film using a silicon-containing resist intermediate film material; forming a resist upper layer film on the silicon-containing resist intermediate film using a resist upper layer film material including a photoresist composition; forming a circuit pattern on the resist upper layer film; transferring a pattern by etching to the silicon-containing resist intermediate film using the resist upper layer film on which the circuit pattern is formed as a mask; transferring a pattern by etching to the organic film using the silicon-containing resist intermediate film on which the pattern is transferred as a mask; and further transferring a pattern by etching to the body to be processed using the organic film on which the pattern is transferred as a mask.

As the body to be processed, it is preferable to use a semiconductor device substrate, or the semiconductor device substrate on which any of a metal film, a metal carbide film, a metal oxide film, a metal nitride film, a metal oxide carbide film, and a metal oxide nitride film is formed, more specifically, but not limited to, substrates such as Si, α-Si, p-Si, SiO₂, SiN, SiON, W, TiN, and Al, or the substrates on which the above-described metal films and the like are formed as the layer of the body to be processed, are used.

As the processed layer, various low-k films such as Si, SiO₂, SiON, SiN, p-Si, α-Si, W, W-Si, Al, Cu, Al-Si, and the stopper films thereof are used, and they can be formed to a thickness of typically 50 to 10,000 nm, especially 100 to 5,000 nm. When forming the processed layer, the substrate and the processed layer made of different materials are used.

The metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When forming an organic film on the body to be processed using the composition for forming an organic film of the present invention, the method for forming an organic film of the present invention described above may be applied.

Then, a resist intermediate film (silicon-containing resist intermediate film) is formed on the organic film using a resist intermediate film material containing silicon atoms. As a resist intermediate film material containing silicon atoms, a polysiloxane-based intermediate film material is preferable. Providing the silicon resist-containing intermediate film with an antireflection effect allows reflection to be suppressed. In particular, for 193 nm exposure, when a material containing many aromatic groups and having high etching selectivity with the substrate is used as the composition for forming an organic film, the k value is high and the substrate reflection is high, but the silicon-containing resist intermediate film has absorption as an appropriate k value, allowing suppression of the reflection and reduction of the substrate reflection to 0.5% or less. As silicon-containing resist intermediate films with antireflection effects, anthracene is preferably used for 248 nm and 157 nm exposure, and polysiloxanes that have a pendant structure with a light-absorbing group having a phenyl group or a silicon-silicon bond and are crosslinked by acid or heat for 193 nm exposure are preferably used.

Then, a resist upper layer film is formed on the silicon-containing resist intermediate film using a resist upper layer film material including a photoresist composition. The resist upper layer film material may be either positive or negative, and the same one as a commonly used photoresist composition can be used. After spin-coating the resist upper layer film material, it is preferable to perform pre-baking at 60 to 180°C for 10 to 300 seconds. Thereafter, exposure is performed according to a conventional method, followed by post-exposure baking (PEB) and development to provide a resist upper layer film pattern. The thickness of the resist upper layer film is not particularly limited, but is preferably 30 to 500 nm, and more preferably 50 to 400 nm.

Then, a circuit pattern (resist upper layer film pattern) is formed on the resist upper layer film. The circuit pattern is preferably formed by lithography using light with a wavelength of 10 nm or more and 300 nm or less, direct drawing with an electron beam, nanoimprinting, or a combination thereof.

The exposure light may be high energy rays with a wavelength of 300 nm or less, specifically far ultraviolet light, KrF excimer laser light (248 nm), ArF excimer laser light (193 nm), F₂ laser light (157 nm), Kr₂ laser light (146 nm), Ar₂ laser light (126 nm), soft X-rays (EUV) of 3 to 20 nm, electron beam (EB), ion beam, X-ray, and the like.

In addition, in forming the circuit pattern, it is preferable to develop the circuit pattern with an alkaline developer or an organic solvent.

Then, the pattern is transferred to the silicon-containing resist intermediate film by etching using the resist upper layer film with the formed circuit pattern as a mask. The etching of the silicon-containing resist intermediate film using the resist upper layer film pattern as a mask is preferably performed using a fluorocarbon-based gas. This transfers the silicon-containing resist intermediate film pattern.

Then, the pattern is transferred to the organic film by etching using the silicon-containing resist intermediate film with the transferred pattern as a mask. The silicon-containing resist intermediate film exhibits resistance to etching by oxygen gas or hydrogen gas, and thus it is preferable to use an etching gas mainly composed of oxygen gas or hydrogen gas to etch the organic film using the silicon-containing resist intermediate film pattern as a mask. This transfers the organic film pattern.

Then, the pattern is transferred to the body to be processed by etching using the organic film with the transferred pattern as a mask. The subsequent etching of the body to be processed (layer to be processed), can be performed by standard methods. For example, when the body to be processed is SiO₂, SiN, or a silica-based low dielectric constant insulating film, etching is performed mainly with chlorofluorocarbon-based gases, and when it is p-Si, Al, or W, etching is performed mainly with chlorine- or bromine-based gases. When substrate processing is performed by etching with chlorofluorocarbon-based gas, the silicon-containing resist underlayer film pattern is removed at the same time as the substrate processing. On the other hand, when substrate processing is performed by etching with chlorine-based or bromine-based gas, a separate dry etching removal with fluorocarbon gas must be performed after substrate processing in order to remove the silicon-containing resist underlayer film pattern.

The organic film obtained by using the composition for forming an organic film of the present invention can have excellent etching resistance when etching the body to be processed as described above.

### [Four-layer resist process using silicon-containing resist intermediate film and organic antireflective film or adhesive film]

The present invention also provides a pattern forming method including: forming an organic film on a body to be processed using the composition for forming an organic film described above; forming a silicon-containing resist intermediate film on the organic film using a silicon-containing resist intermediate film material; forming an organic antireflective film or adhesive film on the silicon-containing resist intermediate film; forming a resist upper layer film on the organic antireflective film or the adhesive film using a resist upper layer film material including a photoresist composition; forming a circuit pattern on the resist upper layer film; transferring a pattern by etching to the organic antireflective film or the adhesive film and the silicon-containing resist intermediate film using the resist upper layer film on which the circuit pattern is formed as a mask; transferring a pattern by etching to the organic film using the silicon-containing resist intermediate film on which the pattern is transferred as a mask; and further transferring a pattern by etching to the body to be processed using the organic film to which the pattern is transferred as a mask.

This method can be performed in the same manner as the three-layer resist process using the silicon-containing resist intermediate film described above, except that an organic antireflective film (BARC) or adhesive film is formed between the silicon-containing resist intermediate film and the resist upper layer.

The organic antireflective film and adhesive film can be formed by spin coating using known organic antireflective film materials.

### [Three-layer resist process using an inorganic hard mask intermediate film]

The present invention also provides a pattern forming method including: forming an organic film on a body to be processed using the composition for forming an organic film described above; forming an inorganic hard mask intermediate film selected from a silicon oxide film, a silicon nitride film, and a silicon oxide nitride film on the organic film; forming a resist upper layer film on the inorganic hard mask intermediate film using a resist upper layer film material including a photoresist composition; forming a circuit pattern on the resist upper layer film; transferring a pattern by etching to the inorganic hard mask intermediate film using the resist upper layer film on which the circuit pattern is formed as a mask; transferring a pattern by etching to the organic film using the inorganic hard mask intermediate film on which the pattern is transferred as a mask; and further transferring a pattern by etching to the body to be processed using the organic film on which the pattern is transferred as a mask.

This method can be performed in the same manner as the three-layer resist process using the silicon-containing resist intermediate film described above, except that an inorganic hard mask intermediate film is formed on the organic film instead of the silicon-containing resist intermediate film.

The inorganic hard mask intermediate film selected from the group consisting of silicon oxide film, silicon nitride film, and silicon oxide nitride film (SiON film) can be formed by the CVD method, the ALD method, and the like. Methods for forming silicon nitride films are described, for example, in JP 2002-334869 A and WO 2004-066377. The thickness of the inorganic hard mask intermediate film is preferably 5 to 200 nm, more preferably 10 to 100 nm. As the inorganic hard mask intermediate film, a SiON film, which is highly effective as an antireflection film, is most preferably used.

### [Four-layer resist process using an inorganic hard mask intermediate film and organic antireflective film or adhesive film]

The present invention also provides a pattern forming method including: forming an organic film on a body to be processed using the composition for forming an organic film described above; forming an inorganic hard mask intermediate film selected from a silicon oxide film, a silicon nitride film, and a silicon oxide nitride film on the organic film; forming an organic antireflective film or adhesive film on the inorganic hard mask intermediate film; forming a resist upper layer film on the organic antireflective film or the adhesive film using a resist upper layer film material including a photoresist composition; forming a circuit pattern on the resist upper layer film; transferring a pattern by etching to the organic antireflective film or the adhesive film and the inorganic hard mask intermediate film using the resist upper layer film on which the circuit pattern is formed as a mask; transferring a pattern by etching to the organic film using the inorganic hard mask intermediate film on which the pattern is transferred as a mask; and further transferring a pattern by etching to the body to be processed using the organic film to which the pattern is transferred as a mask.

This method can be performed in the same manner as the three-layer resist process using the inorganic hard mask intermediate film described above, except that an organic antireflective film (BARC) or adhesive film is formed between the inorganic hard mask intermediate film and the resist upper layer film.

In particular, when a SiON film is used as an inorganic hard mask intermediate film, the two-layer antireflection film of the SiON film and BARC makes it possible to suppress reflections in immersion exposure with a high NA exceeding 1.0. Another advantage of forming a BARC is to reduce the tailing of the resist upper layer film pattern directly above the SiON film.

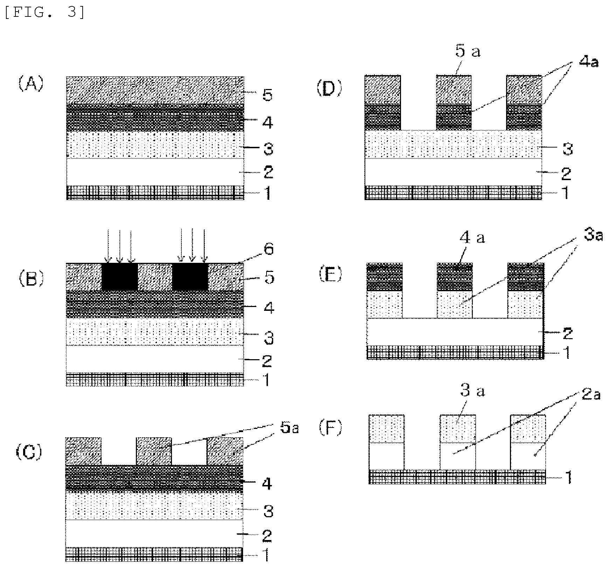

Herein, an example of the pattern forming method using the three-layer resist process of the present invention is shown in FIGS. 3(A) to (F). In the case of the three-layer resist process, as shown in FIG. 3(A), an organic film 3 is formed on a layer of a body to be processed 2 formed on a substrate 1 using the composition for forming an organic film according to the present invention, and then a silicon-containing resist intermediate film 4 is formed on top of that, and a resist upper layer film 5 is formed thereon.

Then, as shown in FIG. 3(B), an exposed portion 6 of the resist upper layer film 5 is exposed and PEB (post-exposure bake) is performed. Then, as shown in FIG. 3(C), development is performed to form a resist upper layer film pattern 5a. Then, as shown in FIG. 3(D), the silicon-containing resist intermediate film 4 is dry-etched using a chlorofluorocarbon-based gas with the resist upper layer film pattern 5a as a mask to form a silicon-containing resist intermediate film pattern 4a. Then, as shown in FIG. 3(E), after removing the resist upper layer film pattern 5a, the organic film 3 is oxygen plasma etched using the silicon-containing resist intermediate film pattern 4a as a mask to form an organic film pattern 3a. Further, as shown in FIG. 3(F), after removing the silicon-containing resist intermediate film pattern 4a, the processed layer 2 is etched using the organic film pattern 3a as a mask to form a pattern 2a. Suppressing the hump during organic film formation allows reduction of defects that occur due to the hump in the organic film during dry etching processing in FIGS. (D), (E), and (F).

When forming an inorganic hard mask intermediate film, the silicon-containing resist intermediate film 4 may be changed to an inorganic hard mask intermediate film, and when forming a BARC or adhesive film, the BARC or adhesive film may be formed between the silicon-containing resist intermediate film 4 and the resist upper layer film 5. The etching of the BARC or adhesive film may be performed consecutively prior to the etching of the silicon-containing resist intermediate film 4, or the etching of the silicon-containing resist intermediate film 4 may be performed by changing the etching device after etching only the BARC or adhesive film.

As described above, the pattern forming method according to the present invention allows formation of a fine pattern on the body to be processed with high precision using a multi-layer resist process, and reduction of defects caused by humps in the organic film by suppressing the formation of humps in the organic film.

### Examples

The present invention will be explained in more detail below with the following synthesis examples, comparative synthesis examples, examples, and comparative examples, but the present invention is not limited to these. The molecular weight was measured by the following method specifically. The weight average molecular weight (Mw) and number average molecular weight (Mn) in terms of polystyrene were determined by gel permeation chromatography (GPC) using tetrahydrofuran as the eluent (solvent), and the dispersity (Mw/Mn) was determined.

### [Synthesis of polymers (A1) to (A18)]

The monomers (m1) to (m15) shown below were used to synthesize polymers (A1) to (A18) used as polymers of materials for forming an organic film.

### [Monomer]

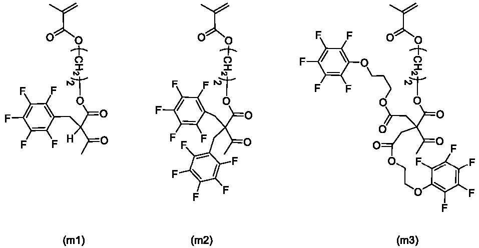

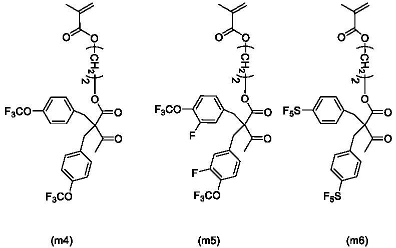

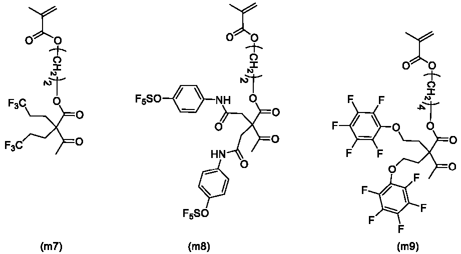

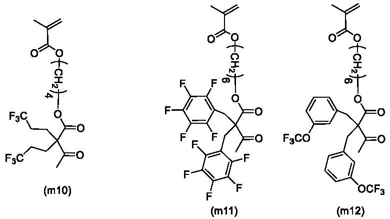

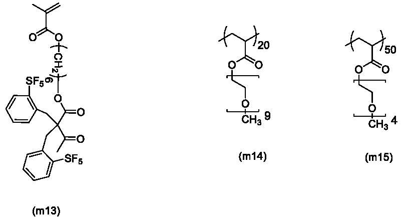

### [Synthesis Example 1] Synthesis of polymer (A1)

10.0 g of propylene glycol monomethyl ether acetate (PGMEA) was heated and stirred at 80°C under a nitrogen atmosphere. To this, a mixture of 5.91 g (15.0 mmol) of a monomer (m1), 0.345 g (1.5 mmol) of dimethyl 2,2-azobis(2-methylpropionate) as a polymerization initiator, and 20.0 g of PGMEA were added dropwise over 4 hours. After further heating and stirring for 16 hours, the mixture was cooled to room temperature to provide a PGMEA solution of a target polymer (A1). Analysis revealed that the weight average molecular weight (Mw) of the polymer (A1) was 14900 and the dispersity (Mw/Mn) was 1.65.

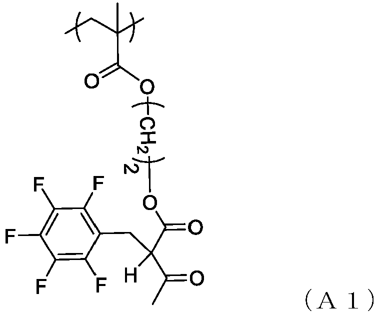

### [Synthesis Examples 2 to 18] Polymers (A2) to (A18)

Except for the monomers, amounts charged, and amount of polymerization initiator charged, which were used, as shown in Table 1, the polymers (A2) to (A18) shown below were obtained by the method similar to Synthesis Example 1. The weight average molecular weight (Mw) and dispersity (Mw/Mn) obtained by GPC are also shown. Synthesis Example 1 is also shown.

**[Table 1]**

| Synthesis Example | Polymer | Amount charged (g) | Polymer | Amount charged(g) | Amount of polymerization initiator charged(g) |
|---|---|---|---|---|---|
| Synthesis Example 1 | m1 | 5.91 | - | | 0.345 |
| Synthesis Example 2 | m2 | 8.62 | - | | 0.345 |
| Synthesis Example 3 | m3 | 11.47 | - | | 0.345 |
| Synthesis Example 4 | m4 | 8.44 | - | | 0.345 |
| Synthesis Example 5 | m5 | 8.98 | - | | 0.345 |
| Synthesis Example 6 | m6 | 9.70 | - | | 0.345 |
| Synthesis Example 7 | m7 | 6.09 | - | | 0.345 |
| Synthesis Example 8 | m8 | 11.47 | - | | 0.345 |
| Synthesis Example 9 | m9 | 9.94 | - | | 0.345 |
| Synthesis Example 10 | m10 | 6.52 | - | | 0.345 |
| Synthesis Example 11 | m11 | 9.46 | - | | 0.345 |
| Synthesis Example 12 | m12 | 9.28 | - | | 0.345 |
| Synthesis Example 13 | m13 | 10.54 | - | | 0.345 |
| Synthesis Example 14 | m2 | 6.89 | m14 | 1.45 | 0.345 |
| Synthesis Example 15 | m4 | 4.22 | m15 | 1.97 | 0.345 |
| Synthesis Example 16 | m6 | 4.85 | m15 | 1.97 | 0.345 |
| Synthesis Example 17 | m6 | 4.85 | m15 | 1.97 | 0.104 |
| Synthesis Example 18 | m7 | 4.35 | m15 | 0.79 | 0.345 |

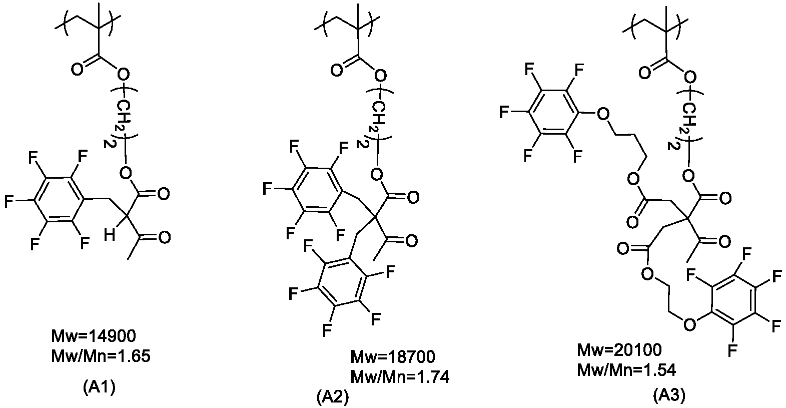

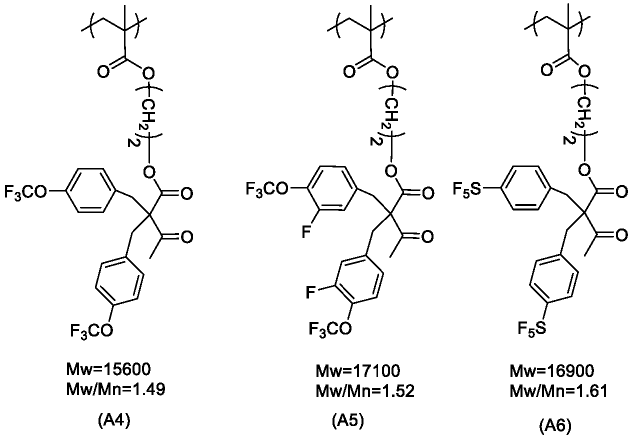

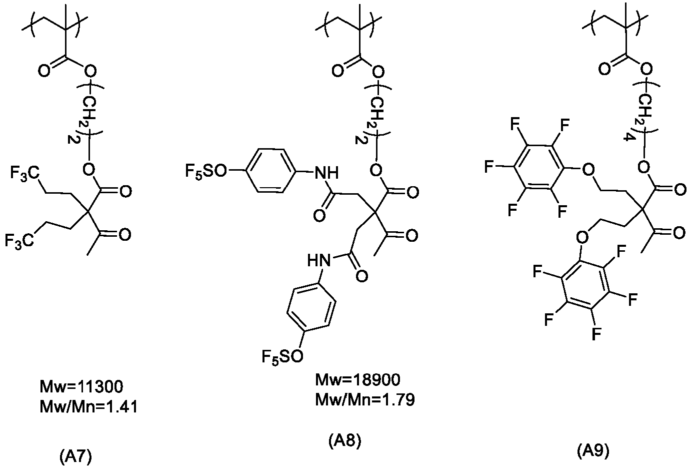

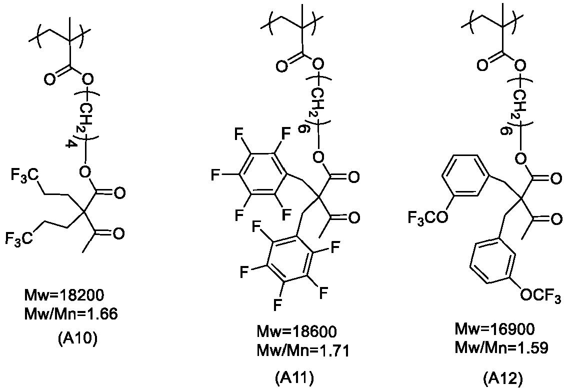

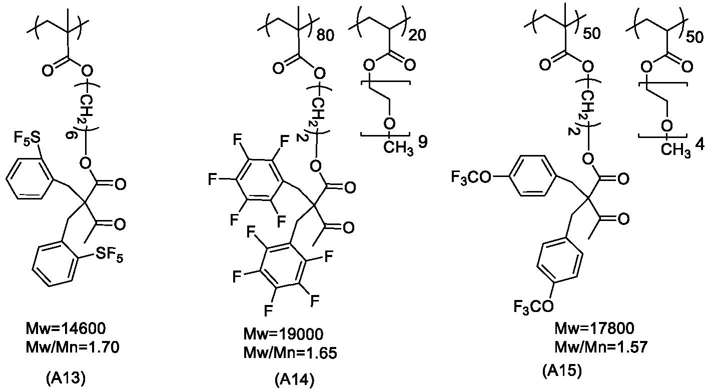

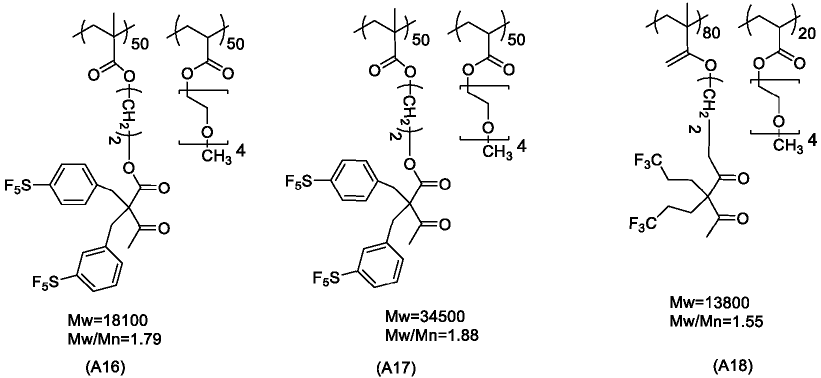

### [Synthesis of polymers (A19) to (A25)]

The diol compounds and acetoacetate ester derivatives (M1) to (M8) shown below were used to synthesize the polymers (A19) to (A25) used as polymers of materials for forming organic films.

### [Monomer]

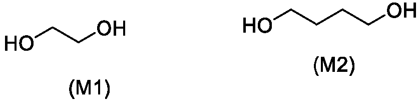

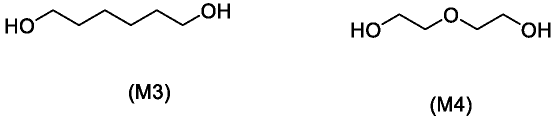

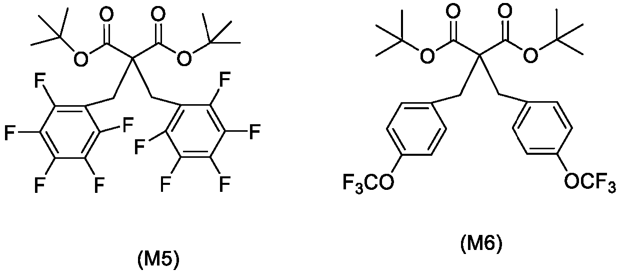

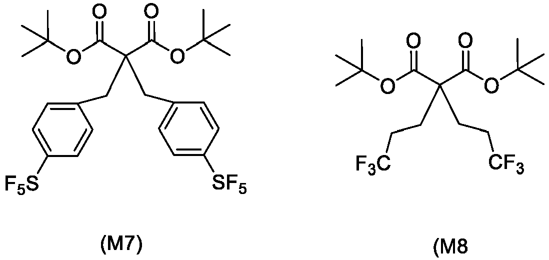

### [Synthesis Example 19] Synthesis of polymer (A19)

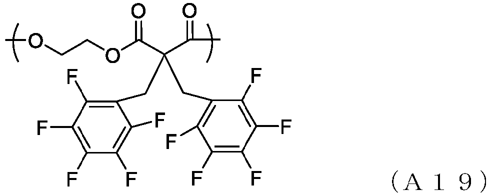

Under a nitrogen atmosphere, 1.0 g of a monomer (Ml), 9.1 g of a monomer (M5), and 20 g of xylene were added to a flask, and the reaction was performed for 2 hours at an internal temperature of 140°C while removing t-butyl alcohol produced by the ester exchange reaction from the system. The internal temperature was then raised to 160°C while removing t-butyl alcohol and o-xylene from the system, and the reaction was performed at the internal temperature of 160°C for 6 hours. After cooling to an internal temperature of 50°C, 200 g of hexane was added to precipitate the polymer in a gum-like form. The mixture was then cooled to room temperature and left to stand at room temperature for 1 hour, and then the supernatant liquid was decanted. 100 g of PGMEA (propylene glycol monomethyl ether acetate) was added to the residue to prepare a homogeneous solution, then the water and low boiling point solvents were distilled off and the concentration was adjusted to recover a PGMEA solution with a stabilizer compound (A19) having a concentration of 50%.
(A19): Mw = 14800, Mw/Mn = l.79

### [Synthesis Example 20] Synthesis of polymer (A20)

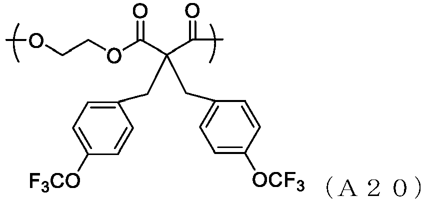

Under a nitrogen atmosphere, 1.0 g of a monomer (M1), 8.9 g of a monomer (M6), and 20 g of xylene were added to a flask, and the reaction was performed for 2 hours at an internal temperature of 140°C while removing t-butyl alcohol generated by the ester exchange reaction from the system. The internal temperature was then raised to 160°C while removing t-butyl alcohol and o-xylene from the system, and the reaction was performed at the internal temperature of 160°C for 6 hours. After cooling to an internal temperature of 50°C, 200 g of hexane was added to precipitate the polymer in a gum-like form. The mixture was then cooled to room temperature and left to stand at room temperature for 1 hour, and then the supernatant liquid was decanted. 100 g of PGMEA (propylene glycol monomethyl ether acetate) was added to the residue to prepare a homogeneous solution, then the water and low boiling point solvent were distilled off and the concentration was adjusted to recover a PGMEA solution with the stabilizer compound (A20) having a concentration of 50%.
(A20): Mw = 18100, Mw/Mn = 1.88

### [Synthesis Example 21] Synthesis of polymer (A21)

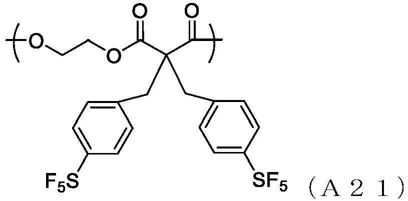

Under a nitrogen atmosphere, 1.0 g of a monomer (Ml), 10.2 g of a monomer (M7), and 20 g of xylene were added to a flask, and the reaction was performed for 2 hours at an internal temperature of 140°C while removing t-butyl alcohol generated by the ester exchange reaction from the system. The internal temperature was then raised to 160°C while removing t-butyl alcohol and o-xylene from the system, and the reaction was performed at the internal temperature of 160°C for 6 hours. After cooling to an internal temperature of 50°C, 200 g of hexane was added to precipitate the polymer in a gum-like form. The mixture was then cooled to room temperature and left to stand at room temperature for 1 hour, and then the supernatant liquid was decanted. 100 g of PGMEA (propylene glycol monomethyl ether acetate) was added to the residue to prepare a homogeneous solution, then the water and low boiling point solvent were distilled off and the concentration was adjusted to recover a PGMEA solution with the stabilizer compound (A21) having a concentration of 50%.
(A21): Mw = 17300, Mw/Mn = 1.67

### [Synthesis Example 22] Synthesis of polymer (A22)

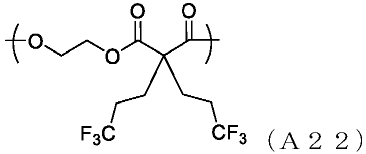

Under a nitrogen atmosphere, 1.0 g of a monomer (Ml), 6.5 g of a monomer (M8), and 20 g of xylene were added to a flask, and the reaction was performed for 2 hours at an internal temperature of 140°C while removing t-butyl alcohol generated by the ester exchange reaction from the system. The internal temperature was then raised to 160°C while removing t-butyl alcohol and o-xylene from the system, and the reaction was performed at the internal temperature of 160°C for 6 hours. After cooling to an internal temperature of 50°C, 200 g of hexane was added to precipitate the polymer in a gum-like form. The mixture was then cooled to room temperature, left to stand at room temperature for 1 hour, and the supernatant was decanted. 100 g of PGMEA (propylene glycol monomethyl ether acetate) was added to the residue to prepare a homogeneous solution, then the water and low boiling point solvent were distilled off, and the concentration was adjusted to recover a PGMEA solution with the stabilizer compound (A22) having a concentration of 50%.
(A22): Mw = 21000, Mw/Mn = 1.46

### [Synthesis Example 23] Synthesis of polymer (A23)

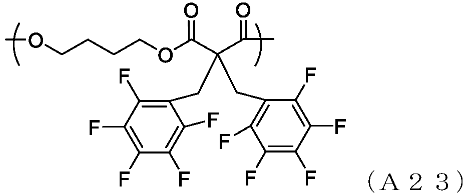

Under a nitrogen atmosphere, 1.5 g of a monomer (M2), 9.4 g of a monomer (M5), and 20 g of xylene were added to a flask, and the reaction was performed for 2 hours at an internal temperature of 140°C while removing t-butyl alcohol generated by the ester exchange reaction from the system. The internal temperature was then raised to 160°C while removing t-butyl alcohol and o-xylene from the system, and the reaction was performed at the internal temperature of 160°C for 6 hours. After cooling to an internal temperature of 50°C, and 200 g of hexane was added to precipitate the polymer in a gum-like form. The mixture was then cooled to room temperature, left to stand at room temperature for 1 hour, and the supernatant was decanted. 100 g of PGMEA (propylene glycol monomethyl ether acetate) was added to the residue to prepare a homogeneous solution, then the water and low boiling point solvent were distilled off, and the concentration was adjusted to recover a PGMEA solution with the stabilizer compound (A23) having a concentration of 50%.
(A23): Mw = 12400, Mw/Mn = 1.66

### [Synthesis Example 24] Synthesis of polymer (A24)

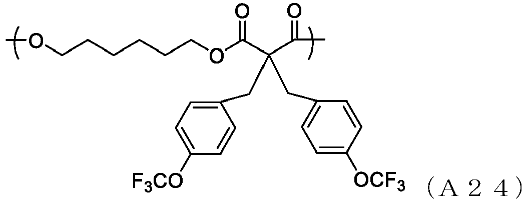

Under a nitrogen atmosphere, 2.0 g of a monomer (M3), 9.4 g of a monomer (M6), and 20 g of xylene were added to a flask, and the reaction was performed for 2 hours at an internal temperature of 140°C while removing t-butyl alcohol generated by the ester exchange reaction from the system. The internal temperature was then raised to 160°C while removing t-butyl alcohol and o-xylene from the system, and the reaction was performed at the internal temperature of 160°C for 6 hours. After cooling to an internal temperature of 50°C, 200 g of hexane was added to precipitate the polymer in a gum-like form. The mixture was then cooled to room temperature, left to stand at room temperature for 1 hour, and the supernatant was decanted. 100 g of PGMEA (propylene glycol monomethyl ether acetate) was added to the residue to prepare a homogeneous solution, then the water and low boiling point solvent were distilled off, and the concentration was adjusted to recover a PGMEA solution with the stabilizer compound (A24) having a concentration of 50%.
(A24): Mw = 19200, Mw/Mn = l.91

### [Synthesis Example 25] Synthesis of polymer (A25)

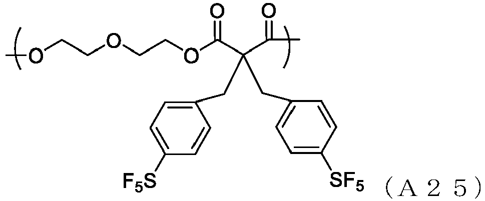

Under a nitrogen atmosphere, 2.0 g of a monomer (M4), 12.0 g of a monomer (M7), and 20 g of xylene were added to a flask, and the reaction was performed for 2 hours at an internal temperature of 140°C while removing t-butyl alcohol generated by the ester exchange reaction from the system. The internal temperature was then raised to 160°C while removing t-butyl alcohol and o-xylene from the system, and the reaction was performed at the internal temperature of 160°C for 6 hours. After cooling to an internal temperature of 50°C, 200 g of hexane was added to precipitate the polymer in a gum-like form. The mixture was then cooled to room temperature, left to stand at room temperature for 1 hour, and the supernatant was decanted. 100 g of PGMEA (propylene glycol monomethyl ether acetate) was added to the residue to make a homogeneous solution, then the water and low boiling point solvent were distilled off, and the concentration was adjusted to recover a PGMEA solution with the stabilizer compound (A25) having a concentration of 50%.
(A25): Mw = 16100, Mw/Mn = l.55

### [Synthesis of comparative polymers (R1) to (R5)]

The following monomers (mr1) to (mr6) were used to synthesize comparative polymers (R1) to (R5) used to prepare the composition for forming an organic film.

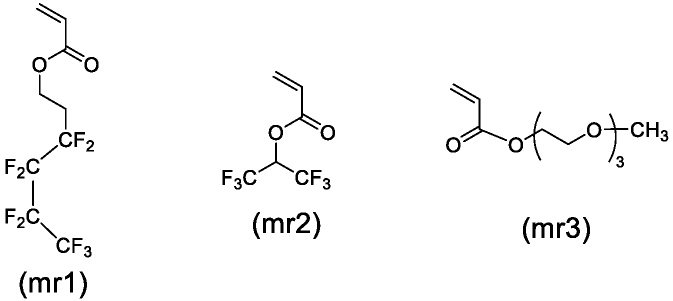

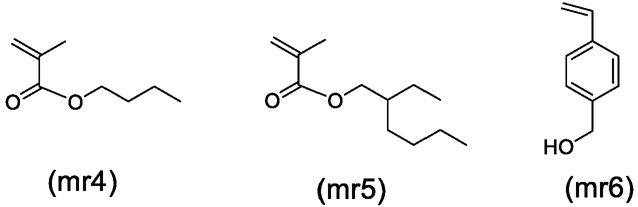

### [Comparative Synthesis Example 1] Synthesis of comparative polymer (R1)

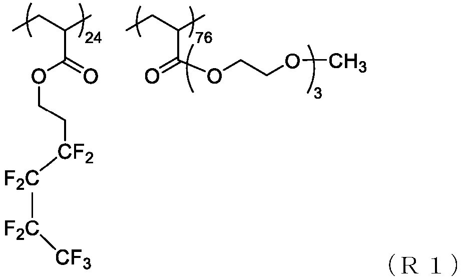

Under a nitrogen atmosphere, 6.0 g of PGMEA was heated and stirred at 80°C. To this, a mixture of 3.44 g (0.011 mol) of a monomer (mr1), 7.46 g (0.034 mol) of a monomer (mr3), 0.350 g of dimethyl 2,2-azobis(2-methylpropionate), and 34 g of PGMEA was added dropwise over a period of 4 hours. After further heating and stirring for 16 hours, the mixture was cooled to room temperature to provide a PGMEA solution of the target polymer (R1).

The weight average molecular weight (Mw) and dispersity (Mw/Mn) were determined by GPC, with the following result.
(Rl): Mw = l3500, Mw/Mn = l.56

### [Comparative Synthesis Example 2] Synthesis of comparative polymer (R2)

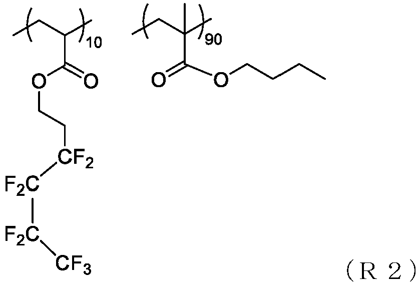

Under a nitrogen atmosphere, 6.0 g of PGMEA was heated and stirred at 80°C. To this, a mixture of 1.43 g (0.005 mol) of a monomer (mr1), 5.76 g (0.041 mol) of a monomer (mr4), 0.250 g of dimethyl 2,2-azobis(2-methylpropionate), and 34 g of PGMEA was added dropwise over 4 hours. After further heating and stirring for 16 hours, the mixture was cooled to room temperature to provide a PGMEA solution of the target polymer (R2).

The weight average molecular weight (Mw) and dispersity (Mw/Mn) were determined by GPC, and the result was as follows.
(R2): Mw = 12800, Mw/Mn = 1.57

### [Comparative Synthesis Example 3] Synthesis of comparative polymer (R3)

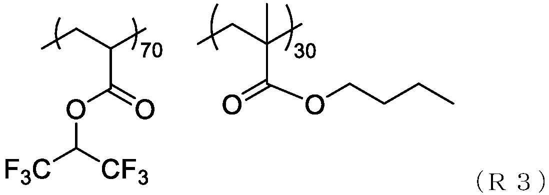

Under a nitrogen atmosphere, 6.0 g of PGMEA was heated and stirred at 80°C. To this, a mixture of 7.00 g (0.032 mol) of a monomer (mr2), 1.92 g (0.014 mol) of a monomer (mr3), 0.250 g of dimethyl 2,2-azobis(2-methylpropionate), and 34 g of PGMEA was added dropwise for 4 hours. After further heating and stirring for 16 hours, the mixture was cooled to room temperature to provide a PGMEA solution of the target polymer (R3).

The weight average molecular weight (Mw) and dispersity (Mw/Mn) were determined by GPC, and the result was as follows.
(R3): Mw = 16400, Mw/Mn = 1.75

### [Comparative Synthesis Example 4] Synthesis of comparative polymer (R4)

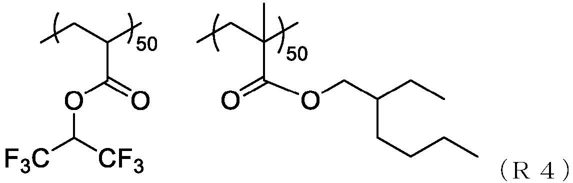

Under a nitrogen atmosphere, 6.0 g of PGMEA was heated and stirred at 80°C. To this, a mixture of 5.00 g (0.023 mol) of (mr2), 3.20 g (0.023 mol) of (mr5), 0.345 g of dimethyl 2,2-azobis(2-methylpropionate), and 34 g of PGMEA was added dropwise for 4 hours. After further heating and stirring for 16 hours, the mixture was cooled to room temperature to provide a PGMEA solution of the target polymer (R4).

The weight average molecular weight (Mw) and dispersity (Mw/Mn) were determined by GPC, and the result was obtained as follows.
(R4): Mw = 13300, Mw/Mn = 1.39

### [Comparative Synthesis Example 5] Synthesis of comparative polymer (R5)

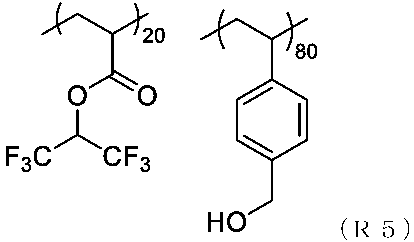

Under a nitrogen atmosphere, 6.0 g of PGMEA was heated and stirred at 80°C. To this, a mixture of 2.00 g (0.009 mol) of (mr2), 5.41 g (0.036 mol) of (mr6), 0.300 g of dimethyl 2,2-azobis(2-methylpropionate), and 34 g of PGMEA was added dropwise for 4 hours. After further heating and stirring for 16 hours, the mixture was cooled to room temperature to provide a PGMEA solution of the target polymer (R5).

The weight average molecular weight (Mw) and dispersity (Mw/Mn) were determined by GPC, and the result was as follows.
(R5): Mw = 9800, Mw/Mn = l.55

### [Resin or compound for forming organic film]

C1: Resin represented by the following formula (C1)
C2: Resin represented by the following formula (C2)
C3: Compound represented by the following formula (C3)
C4: Compound represented by the following formula (C4)
C5: Resin represented by the following formula (C5)
C6: Resin represented by the following formula (C6)

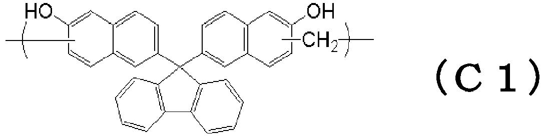

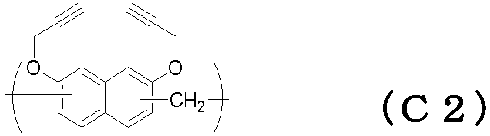

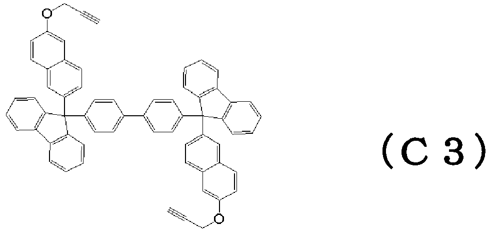

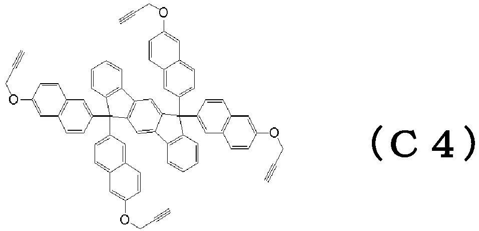

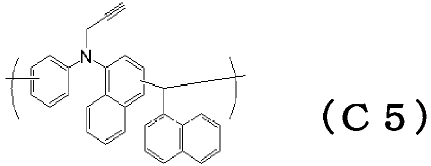

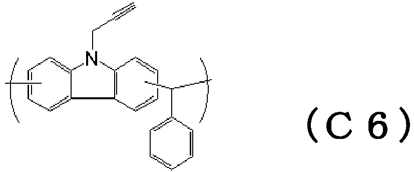

### [Solvent]

D1: Propylene glycol monomethyl ether acetate
D2: Propylene glycol monoethyl ether

### [Preparation of compositions for forming organic film (UDL-1 to 89, comparative UDL-1 to 16)]

The above polymers (A1) to (A25), comparative polymers (R1) to (R5), resins or compounds for forming organic films (C1) to (C6), and solvents were dissolved in the ratios shown in Tables 2 to 4, and the organic film materials (resist underlayer film materials: UDL-1 to 89, comparative examples UDL-1 to 16) were prepared by filtering through a 0.1 µm fluororesin filter.

**[Table 2]**

| Composition for forming organic-film | Resin or compound for forming organic film | | Polymer or comparative polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-1 | (C1) | 10.00 | (A1) | 0.10 | (D1) | 89.90 | | |
| UDL-2 | (C1) | 10.00 | (A2) | 0.10 | (D1) | 89.90 | | |
| UDL-3 | (C1) | 10.00 | (A3) | 0.10 | (D1) | 89.90 | | |
| UDL-4 | (C1) | 10.00 | (A4) | 0.10 | (D1) | 89.90 | | |
| UDL-5 | (C1) | 10.00 | (A5) | 0.10 | (D1) | 89.90 | | |
| UDL-6 | (C1) | 10.00 | (A6) | 0.10 | (D1) | 89.90 | | |
| UDL-7 | (C1) | 10.00 | (A7) | 0.10 | (D1) | 89.90 | | |
| UDL-8 | (C1) | 10.00 | (A8) | 0.10 | (D1) | 89.90 | | |
| UDL-9 | (C1) | 10.00 | (A9) | 0.10 | (D1) | 89.90 | | |
| UDL-10 | (C1) | 10.00 | (A10) | 0.10 | (D1) | 89.90 | | |
| UDL-11 | (C1) | 10.00 | (A11) | 0.10 | (D1) | 89.90 | | |
| UDL-12 | (C1) | 10.00 | (A12) | 0.10 | (D1) | 89.90 | | |
| UDL-13 | (C1) | 10.00 | (A13) | 0.10 | (D1) | 89.90 | | |
| UDL-14 | (C1) | 10.00 | (A14) | 0.10 | (D1) | 89.90 | | |
| UDL-15 | (C1) | 10.00 | (A15) | 0.10 | (D1) | 89.90 | | |
| UDL-16 | (C1) | 10.00 | (A16) | 0.10 | (D1) | 89.90 | | |
| UDL-17 | (C1) | 10.00 | (A17) | 0.10 | (D1) | 89.90 | | |
| UDL-18 | (C1) | 10.00 | (A18) | 0.10 | (D1) | 89.90 | | |
| UDL-19 | (C1) | 10.00 | (A19) | 0.10 | (D1) | 89.90 | | |
| UDL-20 | (C1) | 10.000 | (A20) | 0.10 | (D1) | 89.90 | | |
| UDL-21 | (C1) | 10.00 | (A21) | 0.10 | (D1) | 89.90 | | |
| UDL-22 | (C1) | 10.00 | (A22) | 0.10 | (D1) | 89.90 | | |
| UDL-23 | (C1) | 10.00 | (A23) | 0.10 | (D1) | 89.90 | | |
| UDL-24 | (C1) | 10.00 | (A24) | 0.10 | (D1) | 89.90 | | |
| UDL-25 | (C1) | 10.00 | (A25) | 0.10 | (D1) | 89.90 | | |
| UDL-26 | (C1) | 10.00 | (A4) | 0.10 | (D1) | 62.93 | (D2) | 26.97 |
| UDL-27 | (C1) | 10.00 | (A11) | 0.10 | (D1) | 62.93 | (D2) | 26.97 |
| UDL-28 | (C1) | 10.00 | (A16) | 0.10 | (D1) | 62.93 | (D2) | 26.97 |
| UDL-29 | (C1) | 10.00 | (A20) | 0.10 | (D1) | 62.93 | (D2) | 26.97 |
| UDL-30 | (C1) | 10.00 | (A21) | 0.10 | (D1) | 62.93 | (D2) | 26.97 |
| UDL-31 | (C1) | 10.00 | (A23) | 0.10 | (D1) | 62.93 | (D2) | 26.97 |
| UDL-32 | (C1) | 10.00 | (A16) | 1.000 | (D1) | 89.00 | | |
| UDL-33 | (C1) | 10.00 | (A16) | 0.500 | (D1) | 89.50 | | |
| UDL-34 | (C1) | 10.00 | (A16) | 0.001 | (D1) | 90.00 | | |
| UDL-35 | (C2) | 10.00 | (A4) | 0.10 | (D1) | 89.90 | | |
| UDL-36 | (C2) | 10.00 | (A11) | 0.10 | (D1) | 89.90 | | |
| UDL-37 | (C2) | 10.00 | (A16) | 0.10 | (D1) | 89.90 | | |
| UDL-38 | (C2) | 10.00 | (A20) | 0.10 | (D1) | 89.90 | | |
| UDL-39 | (C2) | 10.00 | (A21) | 0.10 | (D1) | 89.90 | | |
| UDL-40 | (C2) | 10.00 | (A23) | 0.10 | (D1) | 89.90 | | |

**[Table 3]**

| Composition for forming organic-film | Resin or compound for forming organic film | | Polymer or comparative polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-41 | (C3) | 10.00 | (A4) | 0.10 | (D1) | 89.90 | | |
| UDL-42 | (C3) | 10.00 | (A11) | 0.10 | (D1) | 89.90 | | |
| UDL-43 | (C3) | 10.00 | (A16) | 0.10 | (D1) | 89.90 | | |
| UDL-44 | (C3) | 10.00 | (A20) | 0.10 | (D1) | 89.90 | | |
| UDL-45 | (C3) | 10.00 | (A21) | 0.10 | (D1) | 89.90 | | |
| UDL-46 | (C3) | 10.00 | (A23) | 0.10 | (D1) | 89.90 | | |
| UDL-47 | (C4) | 10.00 | (A4) | 0.10 | (D1) | 89.90 | | |
| UDL-48 | (C4) | 10.00 | (A11) | 0.10 | (D1) | 89.90 | | |
| UDL-49 | (C4) | 10.00 | (A16) | 0.10 | (D1) | 89.90 | | |
| UDL-50 | (C4) | 10.00 | (A20) | 0.10 | (D1) | 89.90 | | |
| UDL-51 | (C4) | 10.00 | (A21) | 0.10 | (D1) | 89.90 | | |
| UDL-52 | (C4) | 10.00 | (A23) | 0.10 | (D1) | 89.90 | | |
| UDL-53 | (C5) | 10.00 | (A4) | 0.10 | (D1) | 89.90 | | |
| UDL-54 | (C5) | 10.00 | (A11) | 0.10 | (D1) | 89.90 | | |
| UDL-55 | (C5) | 10.00 | (A16) | 0.10 | (D1) | 89.90 | | |
| UDL-56 | (C5) | 10.00 | (A20) | 0.10 | (D1) | 89.90 | | |
| UDL-57 | (C5) | 10.00 | (A21) | 0.10 | (D1) | 89.90 | | |
| UDL-58 | (C5) | 10.00 | (A23) | 0.10 | (D1) | 89.90 | | |
| UDL-59 | (C6) | 10.00 | (A4) | 0.10 | (D1) | 89.90 | | |
| UDL-60 | (C6) | 10.00 | (A11) | 0.10 | (D1) | 89.90 | | |
| UDL-61 | (C6) | 10.00 | (A16) | 0.10 | (D1) | 89.90 | | |
| UDL-62 | (C6) | 10.00 | (A20) | 0.10 | (D1) | 89.90 | | |
| UDL-63 | (C6) | 10.00 | (A21) | 0.10 | (D1) | 89.90 | | |
| UDL-64 | (C6) | 10.00 | (A23) | 0.10 | (D1) | 89.90 | | |
| UDL-65 | (C1) | 25.00 | (A1) | 0.25 | (D1) | 74.75 | | |
| UDL-66 | (C1) | 25.00 | (A2) | 0.25 | (D1) | 74.75 | | |
| UDL-67 | (C1) | 25.00 | (A3) | 0.25 | (D1) | 74.75 | | |
| UDL-68 | (C1) | 25.00 | (A4) | 0.25 | (D1) | 74.75 | | |
| UDL-69 | (C1) | 25.00 | (A5) | 0.25 | (D1) | 74.75 | | |
| UDL-70 | (C1) | 25.00 | (A6) | 0.25 | (D1) | 74.75 | | |
| UDL-71 | (C1) | 25.00 | (A7) | 0.25 | (D1) | 74.75 | | |
| UDL-72 | (C1) | 25.00 | (A8) | 0.25 | (D1) | 74.75 | | |
| UDL-73 | (C1) | 25.00 | (A9) | 0.25 | (D1) | 74.75 | | |
| UDL-74 | (C1) | 25.00 | (A10) | 0.25 | (D1) | 74.75 | | |
| UDL-75 | (C1) | 25.00 | (A11) | 0.25 | (D1) | 74.75 | | |
| UDL-76 | (C1) | 25.00 | (A12) | 0.25 | (D1) | 74.75 | | |
| UDL-77 | (C1) | 25.00 | (A13) | 0.25 | (D1) | 74.75 | | |
| UDL-78 | (C1) | 25.00 | (A14) | 0.25 | (D1) | 74.75 | | |
| UDL-79 | (C1) | 25.00 | (A15) | 0.25 | (D1) | 74.75 | | |
| UDL-80 | (C1) | 25.00 | (A16) | 0.25 | (D1) | 74.75 | | |

**[Table 4]**

| Composition for forming organic-film | Resin or compound for forming organic film | | Polymer or comparative polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-81 | (C1) | 25.00 | (A17) | 0.25 | (D1) | 74.75 | | |
| UDL-82 | (C1) | 25.00 | (A18) | 0.25 | (D1) | 74.75 | | |
| UDL-83 | (C1) | 25.00 | (A19) | 0.25 | (D1) | 74.75 | | |
| UDL-84 | (C1) | 25.00 | (A20) | 0.25 | (D1) | 74.75 | | |
| UDL-85 | (C1) | 25.00 | (A21) | 0.25 | (D1) | 74.75 | | |
| UDL-86 | (C1) | 25.00 | (A22) | 0.25 | (D1) | 74.75 | | |
| UDL-87 | (C1) | 25.00 | (A23) | 0.25 | (D1) | 74.75 | | |
| UDL-88 | (C1) | 25.00 | (A24) | 0.25 | (D1) | 74.75 | | |
| UDL-89 | (C1) | 25.00 | (A25) | 0.25 | (D1) | 74.75 | | |
| Comparative UDL-1 | (C1) | 10.00 | (R1) | 0.10 | (D1) | 89.90 | | |
| Comparative UDL-2 | (C2) | 10.00 | (R1) | 0.10 | (D1) | 89.90 | | |
| Comparative UDL-3 | (C3) | 10.00 | (R1) | 0.10 | (D1) | 89.90 | | |
| Comparative UDL-4 | (C4) | 10.00 | (R1) | 0.10 | (D1) | 89.90 | | |
| Comparative UDL-5 | (C5) | 10.00 | (R1) | 0.10 | (D1) | 89.90 | | |
| Comparative UDL-6 | (C6) | 10.00 | (R1) | 0.10 | (D1) | 89.90 | | |
| Comparative UDL-7 | (C1) | 10.00 | (R2) | 0.10 | (D1) | 89.90 | | |
| Comparative UDL-8 | (C1) | 10.00 | (R3) | 0.10 | (D1) | 89.90 | | |
| Comparative UDL-9 | (C1) | 10.00 | (R4) | 0.10 | (D1) | 89.90 | | |
| Comparative UDL-10 | (C1) | 10.00 | (R5) | 0.10 | (D1) | 89.90 | | |
| Comparative UDL-11 | (C1) | 10.00 | | | (D1) | 90.00 | | |
| Comparative UDL-12 | (C2) | 10.00 | | | (D1) | 90.00 | | |
| Comparative UDL-13 | (C3) | 10.00 | | | (D1) | 90.00 | | |
| Comparative UDL-14 | (C4) | 10.00 | | | (D1) | 90.00 | | |
| Comparative UDL-15 | (C5) | 10.00 | | | (D1) | 90.00 | | |
| Comparative UDL-16 | (C6) | 10.00 | | | (D1) | 90.00 | | |

### [Preparation of silicon wafers coated with organic cured films using compositions for forming organic film (UDL-1 to 89 and comparative UDL-1 to 16)]

Using a coater/developer "CLEAN TRACK LITHIUS Pro AP" manufactured by Tokyo Electron Ltd., 2 ml of the composition for forming an organic film (UDL-1 to 89, Comparative UDL-1 to 18) prepared above was discharged onto the center of a silicon wafer, and the wafer was rotated at a rotation speed that would result in the average film thickness shown in Tables 5 to 7 after baking, and the composition was spread to form a film. While rotating the silicon wafer at a speed of 1000 rpm, the removal solution discharging nozzle was moved from the outer periphery of the silicon wafer to a position 3 mm toward the center at a speed of 5 mm/s while discharging the removal solution (a mixture of propylene glycol monomethyl ether acetate and propylene glycol monomethyl ether (30:70, mass ratio)) at a discharging rate of 2 mL/s. At this position, the removal solution was further discharged at a discharging rate of 2 mL/s for 5 seconds. Thereafter, the discharge of the discharged solution was stopped, and the wafer was rotated at a speed of 1000 rpm for an additional 30 seconds. The silicon wafer on which the composition for forming an organic film had been formed was then heated at 350°C for 60 seconds to provide a silicon wafer on which an organic cured film had been formed.

### [Solvent resistance evaluation: Examples 1-1 to 1-89 and Comparative Examples 1-1 to 1-16]

The organic film-forming composition (UDL-1 to 89, Comparative UDL-1 to 16) was formed on a silicon wafer using the above method, the film thickness was measured, and the PGMEA solvent was dispensed thereon, left for 30 seconds, spin-dried, and baked at 100°C for 60 seconds to evaporate PGMEA, and the film thickness was measured. The film thickness before dispensing the PGMEA solvent was X, and the film thickness after dispensing the PGMEA solvent was X₁, and the absolute value of the value calculated by {(X₁ - X)/X} × 100 was taken as the film thickness change rate (%). A film thickness change rate of less than 0.5% was rated as favorable, and the change rate of 0.5% or more was rated as poor.

### [In-plane uniformity evaluation: Examples 1-1 to 1-89 and Comparative Examples 1-1 to 1-16]

The organic film forming composition (UDL-1 to 89, Comparative UDL-1 to 16) was formed on a silicon wafer by the above method, and the thickness of the organic cured film was measured at 225 concentric points within a radius of 145 mm from the center of the wafer using an optical thickness meter. The maximum value Xₘₐₓ of the film thickness, the minimum value Xₘᵢₙ, and the average value x_{average} were taken as the in-plane uniformity (%), and the value obtained by {(Xₘₐₓ - Xₘᵢₙ) / X_{average}} × 100 was taken as the in-plane uniformity (%). When the in-plane uniformity was less than 2%, it was rated as A (favorable), when it was 2% or more but less than 3%, it was rated as B, and when it was 3% or more, it was rated as C (poor).

**[Table 5]**

| | Composition for forming organic film | Average film thickness | Solvent resistance | In-plain uniformity |
|---|---|---|---|---|
| Example 1-1 | UDL-1 | 500nm | Favorable | B |
| Example 1-2 | UDL-2 | 500nm | Favorable | A |
| Example 1-3 | UDL-3 | 500nm | Favorable | A |
| Example 1-4 | UDL-4 | 500nm | Favorable | A |
| Example 1-5 | UDL-5 | 500nm | Favorable | A |
| Example 1-6 | UDL-6 | 500nm | Favorable | A |
| Example 1-7 | UDL-7 | 500nm | Favorable | A |
| Example 1-8 | UDL-8 | 500nm | Favorable | A |
| Example 1-9 | UDL-9 | 500nm | Favorable | A |
| Example 1-10 | UDL-10 | 500nm | Favorable | A |
| Example 1-11 | UDL-11 | 500nm | Favorable | A |
| Example 1-12 | UDL-12 | 500nm | Favorable | A |
| Example 1-13 | UDL-13 | 500nm | Favorable | A |
| Example 1-14 | UDL-14 | 500nm | Favorable | A |
| Example 1-15 | UDL-15 | 500nm | Favorable | A |
| Example 1-16 | UDL-16 | 500nm | Favorable | A |
| Example 1-17 | UDL-17 | 500nm | Favorable | A |
| Example 1-18 | UDL-18 | 500nm | Favorable | A |
| Example 1-19 | UDL-19 | 500nm | Favorable | A |
| Example 1-20 | UDL-20 | 500nm | Favorable | A |
| Example 1-21 | UDL-21 | 500nm | Favorable | A |
| Example 1-22 | UDL-22 | 500nm | Favorable | A |
| Example 1-23 | UDL-23 | 500nm | Favorable | A |
| Example 1-24 | UDL-24 | 500nm | Favorable | A |
| Example 1-25 | UDL-25 | 500nm | Favorable | A |
| Example 1-26 | UDL-26 | 500nm | Favorable | A |
| Example 1-27 | UDL-27 | 500nm | Favorable | A |
| Example 1-28 | UDL-28 | 500nm | Favorable | A |
| Example 1-29 | UDL-29 | 500nm | Favorable | A |
| Example 1-30 | UDL-30 | 500nm | Favorable | A |
| Example 1-31 | UDL-31 | 500nm | Favorable | A |
| Example 1-32 | UDL-32 | 500nm | Favorable | B |
| Example 1-33 | UDL-33 | 500nm | Favorable | A |
| Example 1-34 | UDL-34 | 500nm | Favorable | B |
| Example 1-35 | UDL-35 | 500nm | Favorable | A |
| Example 1-36 | UDL-36 | 500nm | Favorable | A |
| Example 1-37 | UDL-37 | 500nm | Favorable | A |
| Example 1-38 | UDL-38 | 500nm | Favorable | A |
| Example 1-39 | UDL-39 | 500nm | Favorable | A |
| Example 1-40 | UDL-40 | 500nm | Favorable | A |

**[Table 6]**

| | Composition for forming organic film | Average film thickness | Solvent resistance | In-plain uniformity |
|---|---|---|---|---|
| Example 1-41 | UDL-41 | 500nm | Favorable | A |
| Example 1-42 | UDL-42 | 500nm | Favorable | A |
| Example 1-43 | UDL-43 | 500nm | Favorable | A |
| Example 1-44 | UDL-44 | 500nm | Favorable | A |
| Example 1-45 | UDL-45 | 500nm | Favorable | A |
| Example 1-46 | UDL-46 | 500nm | Favorable | A |
| Example 1-47 | UDL-47 | 500nm | Favorable | A |
| Example 1-48 | UDL-48 | 500nm | Favorable | A |
| Example 1-49 | UDL-49 | 500nm | Favorable | A |
| Example 1-50 | UDL-50 | 500nm | Favorable | A |
| Example 1-51 | UDL-51 | 500nm | Favorable | A |
| Example 1-52 | UDL-52 | 500nm | Favorable | A |
| Example 1-53 | UDL-53 | 500nm | Favorable | A |
| Example 1-54 | UDL-54 | 500nm | Favorable | A |
| Example 1-55 | UDL-55 | 500nm | Favorable | A |
| Example 1-56 | UDL-56 | 500nm | Favorable | A |
| Example 1-57 | UDL-57 | 500nm | Favorable | A |
| Example 1-58 | UDL-58 | 500nm | Favorable | A |
| Example 1-59 | UDL-59 | 500nm | Favorable | A |
| Example 1-60 | UDL-60 | 500nm | Favorable | A |
| Example 1-61 | UDL-61 | 500nm | Favorable | A |
| Example 1-62 | UDL-62 | 500nm | Favorable | A |
| Example 1-63 | UDL-63 | 500nm | Favorable | A |
| Example 1-64 | UDL-64 | 500nm | Favorable | A |
| Example 1-65 | UDL-65 | 500nm | Favorable | B |
| Example 1-66 | UDL-66 | 500nm | Favorable | A |
| Example 1-67 | UDL-67 | 500nm | Favorable | A |
| Example 1-68 | UDL-68 | 500nm | Favorable | A |
| Example 1-69 | UDL-69 | 500nm | Favorable | A |
| Example 1-70 | UDL-70 | 500nm | Favorable | A |
| Example 1-71 | UDL-71 | 500nm | Favorable | A |
| Example 1-72 | UDL-72 | 500nm | Favorable | A |
| Example 1-73 | UDL-73 | 500nm | Favorable | A |
| Example 1-74 | UDL-74 | 500nm | Favorable | A |
| Example 1-75 | UDL-75 | 1000nm | Favorable | A |
| Example 1-76 | UDL-76 | 1000nm | Favorable | A |
| Example 1-77 | UDL-77 | 1000nm | Favorable | A |
| Example 1-78 | UDL-78 | 1000nm | Favorable | A |
| Example 1-79 | UDL-79 | 1000nm | Favorable | A |
| Example 1-80 | UDL-80 | 1000nm | Favorable | A |

**[Table 7]**

| | Composition for forming organic film | Average film thickness | Solvent resistance | In-plain uniformity |
|---|---|---|---|---|
| Example 1-81 | UDL-81 | 1000nm | Favorable | A |
| Example 1-82 | UDL-82 | 1000nm | Favorable | A |
| Example 1-83 | UDL-83 | 1000nm | Favorable | A |
| Example 1-84 | UDL-84 | 1000nm | Favorable | A |
| Example 1-85 | UDL-85 | 1000nm | Favorable | A |
| Example 1-86 | UDL-86 | 1000nm | Favorable | A |
| Example 1-87 | UDL-87 | 1000nm | Favorable | A |
| Example 1-88 | UDL-88 | 1000nm | Favorable | A |
| Example 1-89 | UDL-89 | 1000nm | Favorable | A |
| Comparative Example 1-1 | Comparative UDL-1 | 500nm | Favorable | A |
| Comparative Example 1-2 | Comparative UDL-2 | 500nm | Favorable | A |
| Comparative Example 1-3 | Comparative UDL-3 | 500nm | Favorable | A |
| Comparative Example 1-4 | Comparative UDL-4 | 500nm | Favorable | A |
| Comparative Example 1-5 | Comparative UDL-5 | 500nm | Favorable | A |
| Comparative Example 1-6 | Comparative UDL-6 | 500nm | Favorable | A |
| Comparative Example 1-7 | Comparative UDL-7 | 500nm | Favorable | A |
| Comparative Example 1-8 | Comparative UDL-8 | 500nm | Favorable | A |
| Comparative Example 1-9 | Comparative UDL-9 | 500nm | Favorable | A |
| Comparative Example 1-10 | Comparative UDL-10 | 500nm | Favorable | A |
| Comparative Example 1-11 | Comparative UDL-11 | 500nm | Favorable | C |
| Comparative Example 1-12 | Comparative UDL-12 | 500nm | Favorable | C |
| Comparative Example 1-13 | Comparative UDL-13 | 500nm | Favorable | C |
| Comparative Example 1-14 | Comparative UDL-14 | 500nm | Favorable | C |
| Comparative Example 1-15 | Comparative UDL-15 | 500nm | Favorable | C |
| Comparative Example 1-16 | Comparative UDL-16 | 500nm | Favorable | C |

### [Hump suppression evaluation: Examples 2-1 to 2-89 and Comparative Examples 2-1 to 2-10]

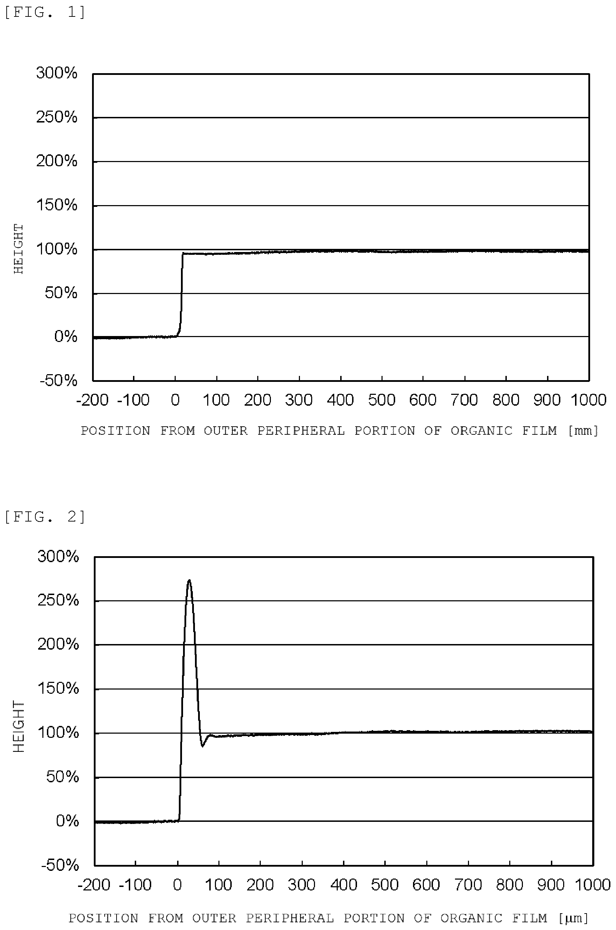

The organic film forming composition (UDL-1 to 89 and Comparative UDL1 to 10) was formed on a silicon wafer by the above method, and the height change from the outer peripheral portion of the organic film to a position 1000 µm toward the center of the silicon wafer was measured using Alpha-Step D-600 (contact profiler) manufactured by KLA-Tencor Corporation. Assuming the height of the silicon wafer is 0, as shown in FIG. 1, a case of the maximum height less than 110% of the film thickness is rated as A (favorable), a case of the maximum height equal to or more than 110% and less than 150% is rated as B, and a case of generating an area where the height is 150% or more is rated as C (poor) as shown in FIG. 2.

### [Embedding property evaluation-1: Examples 2-1 to 2-89 and Comparative Examples 2-1 to 2-10]

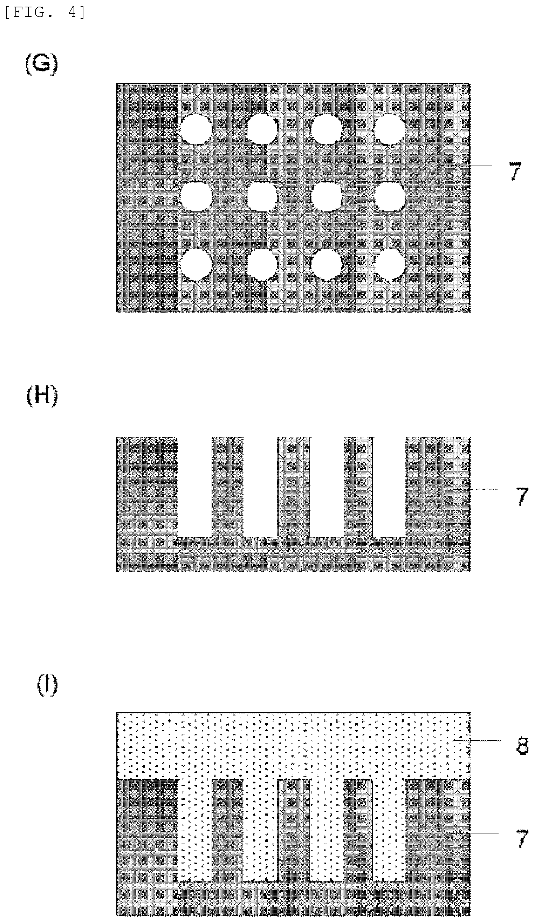

As shown in FIG. 4, on a SiO₂ wafer substrate having a dense hole pattern (hole diameter 0.2 µm, hole depth 1.0 µm, distance between the centers of two adjacent holes 0.4 µm), the organic film forming composition (UDL-1 to 89 and Comparative UDL-1 to 10) was coated by the above method to form a resist underlayer film 8. The substrate used was a base substrate (SiO₂ wafer substrate) 7 having a dense hole pattern as shown in FIG. 4 (G) (top view) and (H) (cross-sectional view). The cross-sectional shape of each obtained wafer substrate was observed using a scanning electron microscope (SEM) to confirm whether there were no voids inside the holes and whether the holes were embedded with the resist underlayer film. When a resist underlayer film material with poor embedding properties was used, voids occurred inside the holes. When a resist underlayer film material with favorable embedding properties was used, the resist underlayer film was embedded without voids inside the holes in this evaluation, as shown in FIG. 4 (I). A case of no voids generated was rated as favorable, and a case of voids generated was rated as poor.

### [Embedding property evaluation-2: Examples 2-65 to 2-89]

As shown in FIG. 4, the composition for forming organic film (UDL-65 to 89) was coated on a SiO₂ wafer substrate having a dense hole pattern (hole diameter 0.2 µm, hole depth 2.0 µm, distance between the centers of two adjacent holes 0.4 µm) by the above method to form a resist underlayer film 8. The substrate used was a base substrate (SiO₂ wafer substrate) 7 having a dense hole pattern as shown in FIG. 4 (G) (overhead view) and (H) (cross-sectional view). The cross-sectional shape of each obtained wafer substrate was observed using a scanning electron microscope (SEM) to confirm whether the holes were embedded with the resist underlayer film without any voids inside. When a resist underlayer film material with poor embedding properties is used, voids are likely to be generated inside the hole. When a resist underlayer film material with favorable embedding properties is used, the resist underlayer film is embedded into the hole without voids, as shown in FIG. 4 (I) in this evaluation. A case of no voids generated is rated as favorable, and a case of voids generated is rated as poor. In order to evaluate the superiority or inferiority of embedding performance, this evaluation is set under strict evaluation conditions in which voids are more likely to be generated than in the embedding property evaluation-1.

**[Table 8]**

| | Composition for forming organic film | Hump suppression evaluation | Embedding property evaluation-1 | Embedding property evaluation-2 |
|---|---|---|---|---|
| Example 2-1 | UDL-1 | Favorable | A | - |
| Example 2-2 | UDL-2 | Favorable | A | - |
| Example 2-3 | UDL-3 | Favorable | A | - |
| Example 2-4 | UDL-4 | Favorable | A | - |
| Example 2-5 | UDL-5 | Favorable | A | - |
| Example 2-6 | UDL-6 | Favorable | A | - |
| Example 2-7 | UDL-7 | Favorable | B | - |
| Example 2-8 | UDL-8 | Favorable | A | - |
| Example 2-9 | UDL-9 | Favorable | A | - |
| Example 2-10 | UDL-10 | Favorable | B | - |
| Example 2-11 | UDL-11 | Favorable | A | - |
| Example 2-12 | UDL-12 | Favorable | A | - |
| Example 2-13 | UDL-13 | Favorable | A | - |
| Example 2-14 | UDL-14 | Favorable | A | - |
| Example 2-15 | UDL-15 | Favorable | A | - |
| Example 2-16 | UDL-16 | Favorable | A | - |
| Example 2-17 | UDL-17 | Favorable | A | - |
| Example 2-18 | UDL-18 | Favorable | B | - |
| Example 2-19 | UDL-19 | Favorable | A | - |
| Example 2-20 | UDL-20 | Favorable | A | - |
| Example 2-21 | UDL-21 | Favorable | A | - |
| Example 2-22 | UDL-22 | Favorable | B | - |
| Example 2-23 | UDL-23 | Favorable | A | - |
| Example 2-24 | UDL-24 | Favorable | A | - |
| Example 2-25 | UDL-25 | Favorable | A | - |
| Example 2-26 | UDL-26 | Favorable | A | - |
| Example 2-27 | UDL-27 | Favorable | A | - |
| Example 2-28 | UDL-28 | Favorable | A | - |
| Example 2-29 | UDL-29 | Favorable | A | - |
| Example 2-30 | UDL-30 | Favorable | A | - |
| Example 2-31 | UDL-31 | Favorable | A | - |
| Example 2-32 | UDL-32 | Favorable | A | - |
| Example 2-33 | UDL-33 | Favorable | A | - |
| Example 2-34 | UDL-34 | Favorable | A | - |
| Example 2-35 | UDL-35 | Favorable | A | - |
| Example 2-36 | UDL-36 | Favorable | A | - |
| Example 2-37 | UDL-37 | Favorable | A | - |
| Example 2-38 | UDL-38 | Favorable | A | - |
| Example 2-39 | UDL-39 | Favorable | A | - |
| Example 2-40 | UDL-40 | Favorable | A | - |

**[Table 9]**

| | Composition for forming organic film | Hump suppression evaluation | Embedding property evaluation-1 | Embedding property evaluation-2 |
|---|---|---|---|---|
| Example 2-41 | UDL-41 | Favorable | A | - |
| Example 2-42 | UDL-42 | Favorable | A | - |
| Example 2-43 | UDL-43 | Favorable | A | - |
| Example 2-44 | UDL-44 | Favorable | A | - |
| Example 2-45 | UDL-45 | Favorable | A | - |
| Example 2-46 | UDL-46 | Favorable | A | - |
| Example 2-47 | UDL-47 | Favorable | A | - |
| Example 2-48 | UDL-48 | Favorable | A | - |
| Example 2-49 | UDL-49 | Favorable | A | - |
| Example 2-50 | UDL-50 | Favorable | A | - |
| Example 2-51 | UDL-51 | Favorable | A | - |
| Example 2-52 | UDL-52 | Favorable | A | - |
| Example 2-53 | UDL-53 | Favorable | A | - |
| Example 2-54 | UDL-54 | Favorable | A | - |
| Example 2-55 | UDL-55 | Favorable | A | - |
| Example 2-56 | UDL-56 | Favorable | A | - |
| Example 2-57 | UDL-57 | Favorable | A | - |
| Example 2-58 | UDL-58 | Favorable | A | - |
| Example 2-59 | UDL-59 | Favorable | A | - |
| Example 2-60 | UDL-60 | Favorable | A | - |
| Example 2-61 | UDL-61 | Favorable | A | - |
| Example 2-62 | UDL-62 | Favorable | A | - |
| Example 2-63 | UDL-63 | Favorable | A | - |
| Example 2-64 | UDL-64 | Favorable | A | - |
| Example 2-65 | UDL-65 | Favorable | A | Poor |
| Example 2-66 | UDL-66 | Favorable | A | Poor |
| Example 2-67 | UDL-67 | Favorable | A | Poor |
| Example 2-68 | UDL-68 | Favorable | A | Poor |
| Example 2-69 | UDL-69 | Favorable | A | Poor |
| Example 2-70 | UDL-70 | Favorable | A | Poor |
| Example 2-71 | UDL-71 | Favorable | B | Poor |
| Example 2-72 | UDL-72 | Favorable | A | Poor |
| Example 2-73 | UDL-73 | Favorable | A | Poor |
| Example 2-74 | UDL-74 | Favorable | B | Poor |
| Example 2-75 | UDL-75 | Favorable | A | Poor |
| Example 2-76 | UDL-76 | Favorable | A | Poor |
| Example 2-77 | UDL-77 | Favorable | A | Poor |
| Example 2-78 | UDL-78 | Favorable | A | Favorable |
| Example 2-79 | UDL-79 | Favorable | A | Favorable |
| Example 2-80 | UDL-80 | Favorable | A | Favorable |

**[Table 10]**

| | Composition for forming organic film | Hump suppression evaluation | Embedding property evaluation-1 | Embedding property evaluation-2 |
|---|---|---|---|---|
| Example 2-81 | UDL-81 | Favorable | A | Favorable |
| Example 2-82 | UDL-82 | Favorable | B | Favorable |
| Example 2-83 | UDL-83 | Favorable | A | Poor |
| Example 2-84 | UDL-84 | Favorable | A | Poor |
| Example 2-85 | UDL-85 | Favorable | A | Poor |
| Example 2-86 | UDL-86 | Favorable | B | Poor |
| Example 2-87 | UDL-87 | Favorable | A | Poor |
| Example 2-88 | UDL-88 | Favorable | A | Poor |
| Example 2-89 | UDL-89 | Favorable | A | Poor |
| Comparative Example 2-1 | Comparative UDL-1 | Poor | C | - |
| Comparative Example 2-2 | Comparative UDL-2 | Poor | C | - |
| Comparative Example 2-3 | Comparative UDL-3 | Poor | C | - |
| Comparative Example 2-4 | Comparative UDL-4 | Poor | C | - |
| Comparative Example 2-5 | Comparative UDL-5 | Poor | C | - |
| Comparative Example 2-6 | Comparative UDL-6 | Poor | C | - |
| Comparative Example 2-7 | Comparative UDL-7 | Poor | C | - |
| Comparative Example 2-8 | Comparative UDL-8 | Poor | C | - |
| Comparative Example 2-9 | Comparative UDL-9 | Poor | C | - |
| Comparative Example 2-10 | Comparative UDL-10 | Poor | A | - |

As shown in Tables 5 to 10, the compositions for forming an organic film according to the present invention (UDL-1 to 89) were confirmed to be excellent in solvent resistance, in-plane uniformity, hump suppression, and embedding properties.

### [Pattern formation test: Examples 3-1 to 3-74]

The composition for forming an organic film (UDL-1 to 74) was used to form a resist underlayer film on a SiO₂ wafer substrate by the above method, and the following silicon-containing resist intermediate film material (SOG1) was coated thereon and baked at 200°C for 60 seconds to form a silicon-containing resist intermediate film with a film thickness of 35 nm. The following ArF single-layer resist was applied thereon as a resist upper layer film material and baked at 105°C for 60 seconds to form a resist upper layer film with a film thickness of 100 nm. The following immersion protective film material (TC-1) was coated on the resist upper layer film and baked at 90°C for 60 seconds to form a protective film with a film thickness of 50 nm.

The silicon-containing resist intermediate film material (SOG1) was prepared by dissolving the polymer (SP1), crosslinking catalyst, and acid in an organic solvent and water in the ratios shown in Table 11, and filtering through a 0.1 µm fluororesin filter.

**[Table 11]**

| | Polymer (parts by mass) | Crosslinking catalyst (parts by mass) | Acid (parts by mass) | Organic solvent (parts by mass) | Water (parts by mass) |
|---|---|---|---|---|---|
| SOG1 | SP1 (100) | TMPANO₃ (1) | Maleic acid (1) | PGEE (4410) | Water (490) |

The polymer (SP1) is shown below. 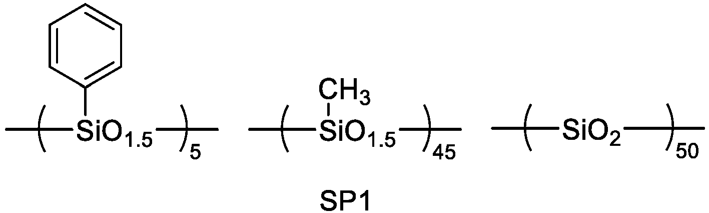
TMPN03: Trimethylphenylammonium nitrate
PGEE: Propylene glycol ethyl ether

The resist upper layer film material (single-layer resist for ArF) was prepared by dissolving the polymer (RP1), acid generator (PAG1), and basic compound (Amine 1) in a solvent containing 0.1% by mass of FC-430 (manufactured by Sumitomo 3M Limited) in the ratios shown in Table 12, and filtering through a 0.1 µm fluororesin filter.

**[Table 12]**

| | Polymer (parts by mass) | Acid generator (parts by mass) | Basic compound (parts by mass) | Solvent (parts by mass) |
|---|---|---|---|---|
| Single-layer resist for ArF | RP1 (100) | PAG1 (6.6) | Aminel (0.8) | PGMEA (2500) |

The polymer (RP1), acid generator (PAG1), and basic compound (Amine l) are shown below.

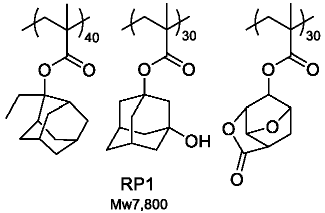

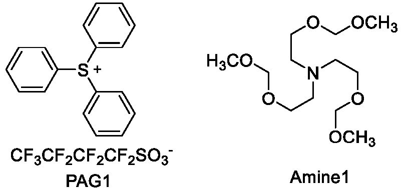

The immersion protective film material (TC-1) was prepared by dissolving the polymer (PP1) in an organic solvent in the ratio shown in Table 13 and filtering through a 0.1 µm fluororesin filter.

**[Table 13]**

| | Polymer (parts by mass) | Organic solvent (parts by mass) |
|---|---|---|
| TC-1 | PP1 (100) | Diisoamyl ether(2700) |
| | | 2-Methyl-1-butanol(270) |

The polymer (PP1) is shown below.

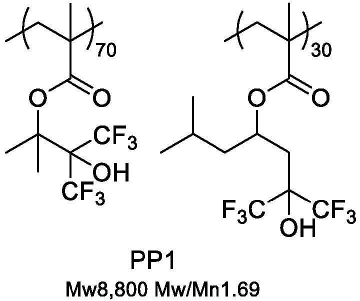

Then, exposure was performed with an ArF immersion exposure device (manufactured by NIKON CORPORATION; NSR-S610C, NA1. 30, σ0.98/0.65, 35-degree dipole s polarized illumination, 6% halftone phase shift mask), baked at 100°C for 60 seconds (PEB), and developed with a 2.38% by mass tetramethylammonium hydroxide (TMAH) aqueous solution for 30 seconds to provide a 55 nm 1:1 positive line-and-space pattern (resist upper layer film pattern).

Then, using the resist upper layer film pattern as a mask, the silicon-containing resist intermediate film was dry etched (pattern transferred) using etching equipment Telius manufactured by Tokyo Electron Ltd., the resist underlayer film was dry etched (pattern transferred) using the obtained silicon-containing resist intermediate film pattern as a mask, and the SiO₂ wafer substrate (SiO₂ film) was dry etched (pattern transferred) using the obtained resist underlayer film pattern as a mask. The etching conditions are as shown below.

### (Conditions for transferring resist upper layer pattern to silicon-containing resist intermediate film)

| | |
|---|---|
| Chamber pressure | 10.0 Pa |
| RF power | 1,500 W |
| CF₄ gas flow rate | 75 mL/min |
| O₂ gas flow rate | 15 mL/min |
| Time | 15 sec |

### (Conditions for transferring silicon-containing resist intermediate film pattern to resist underlayer film)

| | |
|---|---|
| Chamber pressure | 2.0 Pa |
| RF power | 500 W |
| Ar gas flow rate | 75 mL/min |
| O₂ gas flow rate | 45 mL/min |
| Time | 120 sec |

### (Conditions for transferring resist underlayer film pattern to SiO₂ wafer substrate)

| | |
|---|---|
| Chamber pressure | 2.0 Pa |
| RF power | 2,200 W |
| C₅F₁₂ gas flow rate | 20 mL/min |
| C₂F₆ gas flow rate | 10 mL/min |
| Ar gas flow rate | 300 mL/min |
| O₂ gas flow rate | 60 mL/min |
| Time | 90 sec |

The cross section of the obtained pattern was observed using an electron microscope (S-4700) manufactured by Hitachi, Ltd., and the results are shown in Tables 14 and 15.

**[Table 14]**

| | Composition for forming organic film | Shape after transferring by etching to substrate |
|---|---|---|
| Example 3-1 | UDL-1 | Favorable |
| Example 3-2 | UDL-2 | Favorable |
| Example 3-3 | UDL-3 | Favorable |
| Example 3-4 | UDL-4 | Favorable |
| Example 3-5 | UDL-5 | Favorable |
| Example 3-6 | UDL-6 | Favorable |
| Example 3-7 | UDL-7 | Favorable |
| Example 3-8 | UDL-8 | Favorable |
| Example 3-9 | UDL-9 | Favorable |
| Example 3-10 | UDL-10 | Favorable |
| Example 3-11 | UDL-11 | Favorable |
| Example 3-12 | UDL-12 | Favorable |
| Example 3-13 | UDL-13 | Favorable |
| Example 3-14 | UDL-14 | Favorable |
| Example 3-15 | UDL-15 | Favorable |
| Example 3-16 | UDL-16 | Favorable |
| Example 3-17 | UDL-17 | Favorable |
| Example 3-18 | UDL-18 | Favorable |
| Example 3-19 | UDL-19 | Favorable |
| Example 3-20 | UDL-20 | Favorable |
| Example 3-21 | UDL-21 | Favorable |
| Example 3-22 | UDL-22 | Favorable |
| Example 3-23 | UDL-23 | Favorable |
| Example 3-24 | UDL-24 | Favorable |
| Example 3-25 | UDL-25 | Favorable |
| Example 3-26 | UDL-26 | Favorable |
| Example 3-27 | UDL-27 | Favorable |
| Example 3-28 | UDL-28 | Favorable |
| Example 3-29 | UDL-29 | Favorable |
| Example 3-30 | UDL-30 | Favorable |
| Example 3-31 | UDL-31 | Favorable |
| Example 3-32 | UDL-32 | Favorable |
| Example 3-33 | UDL-33 | Favorable |
| Example 3-34 | UDL-34 | Favorable |
| Example 3-35 | UDL-35 | Favorable |
| Example 3-36 | UDL-36 | Favorable |
| Example 3-37 | UDL-37 | Favorable |
| Example 3-38 | UDL-38 | Favorable |
| Example 3-39 | UDL-39 | Favorable |
| Example 3-40 | UDL-40 | Favorable |

**[Table 15]**

| | Composition for forming organic film | Shape after transferring by etching to substrate |
|---|---|---|
| Example 3-41 | UDL-41 | Favorable |
| Example 3-42 | UDL-42 | Favorable |
| Example 3-43 | UDL-43 | Favorable |
| Example 3-44 | UDL-44 | Favorable |
| Example 3-45 | UDL-45 | Favorable |
| Example 3-46 | UDL-46 | Favorable |
| Example 3-47 | UDL-47 | Favorable |
| Example 3-48 | UDL-48 | Favorable |
| Example 3-49 | UDL-49 | Favorable |
| Example 3-50 | UDL-50 | Favorable |
| Example 3-51 | UDL-51 | Favorable |
| Example 3-52 | UDL-52 | Favorable |
| Example 3-53 | UDL-53 | Favorable |
| Example 3-54 | UDL-54 | Favorable |
| Example 3-55 | UDL-55 | Favorable |
| Example 3-56 | UDL-56 | Favorable |
| Example 3-57 | UDL-57 | Favorable |
| Example 3-58 | UDL-58 | Favorable |
| Example 3-59 | UDL-59 | Favorable |
| Example 3-60 | UDL-60 | Favorable |
| Example 3-61 | UDL-61 | Favorable |
| Example 3-62 | UDL-62 | Favorable |
| Example 3-63 | UDL-63 | Favorable |
| Example 3-64 | UDL-64 | Favorable |
| Example 3-65 | UDL-65 | Favorable |
| Example 3-66 | UDL-66 | Favorable |
| Example 3-67 | UDL-67 | Favorable |
| Example 3-68 | UDL-68 | Favorable |
| Example 3-69 | UDL-69 | Favorable |
| Example 3-70 | UDL-70 | Favorable |
| Example 3-71 | UDL-71 | Favorable |
| Example 3-72 | UDL-72 | Favorable |
| Example 3-73 | UDL-73 | Favorable |
| Example 3-74 | UDL-74 | Favorable |

As shown in Table 14 and Table 15, in Examples 3-1 to 3-74 using the composition for forming an organic film according to the present invention (UDL-1 to 74), the resist upper layer film pattern was successfully transferred to the SiO₂ wafer substrate, and it was confirmed that the composition for forming an organic film according to the present invention is suitable for use in microfabrication by the multi-layer resist method.

### [Preparation of resist upper layer film materials (PR1 to 25 and comparative PR)]

As resist upper layer film materials, a polymer (P-1), acid generator (PAG-2), quencher (Q-1), and polymers (A1 to A25) were dissolved in a solvent in the ratios shown in Table 16, and the resist upper layer film materials (PR1 to 25 and comparative PR) were prepared by filtering through a 0.1 µm fluororesin filter, respectively.

**[Table 16]**

| Resist upper layer film material | Polymer (parts by mass)) | Additive (parts by mass) | Polymer (parts by mass) | Solvent (parts by mass) |
|---|---|---|---|---|
| PR1 | P-1 (100) | PAG-1(25.0) | (A1) | PGMEA(1800) |
| | | Q-1(6.6) | (0.1) | EL(1200) |
| PR2 | P-1 (100) | PAG-1(25.0) | (A2) | PGMEA(1800) |
| | | Q-1(6.6) | (0.1) | EL(1200) |
| PR3 | P-1 (100) | PAG-1(25.0) | (A3) | PGMEA(1800) |
| | | Q-1(6.6) | (0.1) | EL(1200) |
| PR4 | P-1 (100) | PAG-1(25.0) | (A4) | PGMEA(1800) |
| | | Q-1(6.6) | (0.1) | EL(1200) |
| PR5 | P-1 (100) | PAG-1(25.0) | (A5) | PGMEA(1800) |
| | | Q-1(6.6) | (0.1) | EL(1200) |
| PR6 | P-1 (100) | PAG-1(25.0) | (A6) | PGMEA(1800) |
| | | Q-1(6.6) | (0.1) | EL(1200) |
| PR7 | P-1 (100) | PAG-1(25.0) | (A7) | PGMEA(1800) |
| | | Q-1(6.6) | (0.1) | EL(1200) |
| PR8 | P-1 (100) | PAG-1(25.0) | (A8) | PGMEA(1800) |
| | | Q-1(6.6) | (0.1) | EL(1200) |
| PR9 | P-1 (100) | PAG-1(25.0) | (A9) | PGMEA(1800) |
| | | Q-1(6.6) | (0.1) | EL(1200) |
| PR10 | P-1 (100) | PAG-1(25.0) | (A10) | PGMEA(1800) |
| | | Q-1(6.6) | (0.1) | EL(1200) |
| PR11 | P-1 (100) | PAG-1(25.0) | (A11) | PGMEA(1800) |
| | | Q-1(6.6) | (0.1) | EL(1200) |
| PR12 | P-1 (100) | PAG-1(25.0) | (A12) | PGMEA(1800) |
| | | Q-1(6.6) | (0.1) | EL(1200) |
| PR13 | P-1 (100) | PAG-1(25.0) | (A13) | PGMEA(1800) |
| | | Q-1(6.6) | (0.1) | EL(1200) |
| PR14 | P-1 (100) | PAG-1(25.0) | (A14) | PGMEA(1800) |
| | | Q-1(6.6) | (0.1) | EL(1200) |
| PR15 | P-1 (100) | PAG-1(25.0) | (A15) | PGMEA(1800) |
| | | Q-1(6.6) | (0.1) | EL(1200) |
| PR16 | P-1 (100) | PAG-1(25.0) | (A16) | PGMEA(1800) |
| | | Q-1(6.6) | (0.1) | EL(1200) |
| PR17 | P-1 (100) | PAG-1(25.0) | (A17) | PGMEA(1800) |
| | | Q-1(6.6) | (0.1) | EL(1200) |
| PR18 | P-1 (100) | PAG-1(25.0) | (A18) | PGMEA(1800) |
| | | Q-1(6.6) | (0.1) | EL(1200) |
| PR19 | P-1 (100) | PAG-1(25.0) | (A19) | PGMEA(1800) |
| | | Q-1(6.6) | (0.1) | EL(1200) |
| PR20 | P-1 (100) | PAG-1(25.0) | (A20) | PGMEA(1800) |
| | | Q-1(6.6) | (0.1) | EL(1200) |
| PR21 | P-1 (100) | PAG-1(25.0) | (A21) | PGMEA(1800) |
| | | Q-1(6.6) | (0.1) | EL(1200) |
| PR22 | P-1 (100) | PAG-1(25.0) | (A22) | PGMEA(1800) |
| | | Q-1(6.6) | (0.1) | EL(1200) |
| PR23 | P-1 (100) | PAG-1(25.0) | (A23) | PGMEA(1800) |
| | | Q-1(6.6) | (0.1) | EL(1200) |
| PR24 | P-1 (100) | PAG-1(25.0) | (A24) | PGMEA(1800) |
| | | Q-1(6.6) | (0.1) | EL(1200) |
| PR25 | P-1 (100) | PAG-1(25.0) | (A25) | PGMEA(1800) |
| | | Q-1(6.6) | (0.1) | EL(1200) |
| Comparative PR | P-1 (100) | PAG-1(25.0) | | PGMEA(1800) |
| | | Q-1(6.6) | | EL(1200) |

The polymer (P-1), acid generator (PAG-2), quencher (Q-1), and solvent are shown below. 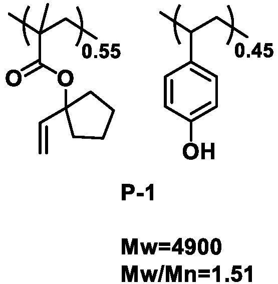 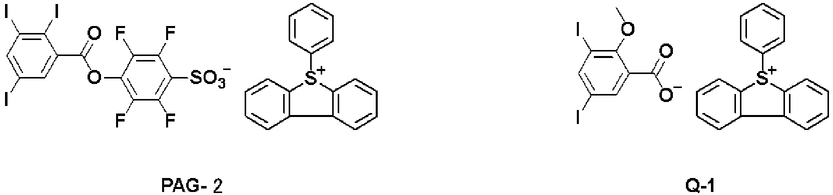
PGMEA: Propylene glycol monomethyl ether acetate
EL: Ethyl lactate

### [Preparation of silicon wafers with resist upper layer films formed using resist upper layer film materials (PR1 to 25 and comparative PR)]

Using the coater/developer "CLEAN TRACK LITHIUS Pro AP" manufactured by Tokyo Electron Ltd., 2 ml of the resist upper layer film materials (PR1 to 25 and comparative PR) prepared above was dispensed onto the center of the silicon wafer, and the wafer was rotated at a rotation speed that resulted in an average film thickness of 45 nm after baking, and spread. Then, the silicon wafer coated with the resist upper layer film was heated at 110°C for 30 seconds to provide a silicon wafer with a resist upper layer film formed thereon.

### [In-plane uniformity evaluation of resist upper layer film: Examples 4-1 to 4-25 and Comparative Example 4-1]

The thickness of the resist upper layer film (PR1 to 25 and Comparative PR) formed on a silicon wafer by the above method was measured at 225 concentric points within a radius of 145 mm from the center of the wafer using an optical thickness meter. When the maximum value of the film thickness was Xₘₐₓ, the minimum value was Xₘᵢₙ, and the average value was X_{average}, a value determined by {(Xₘₐₓ - Xₘᵢₙ)/X_{average}} × 100 was defined as the in-plane uniformity (%). A case of the in-plane uniformity less than 3% was rated as favorable, and a case of 3% or more was rated as poor.

**[Table 17]**

| | Resist upper layer film material | In-plain uniformity |
|---|---|---|
| Example 4-1 | PR1 | Favorable |
| Example 4-2 | PR2 | Favorable |
| Example 4-3 | PR3 | Favorable |
| Example 4-4 | PR4 | Favorable |
| Example 4-5 | PR5 | Favorable |
| Example 4-6 | PR6 | Favorable |
| Example 4-7 | PR7 | Favorable |
| Example 4-8 | PR8 | Favorable |
| Example 4-9 | PR9 | Favorable |
| Example 4-10 | PR10 | Favorable |
| Example 4-11 | PR11 | Favorable |
| Example 4-12 | PR12 | Favorable |
| Example 4-13 | PR13 | Favorable |
| Example 4-14 | PR14 | Favorable |
| Example 4-15 | PR15 | Favorable |
| Example 4-16 | PR16 | Favorable |
| Example 4-17 | PR17 | Favorable |
| Example 4-18 | PR18 | Favorable |
| Example 4-19 | PR19 | Favorable |
| Example 4-20 | PR20 | Favorable |
| Example 4-21 | PR21 | Favorable |
| Example 4-22 | PR22 | Favorable |
| Example 4-23 | PR23 | Favorable |
| Example 4-24 | PR24 | Favorable |
| Example 4-25 | PR25 | Favorable |
| Comparative Example 4-1 | Comparative PR | Poor |

As shown in Table 17, the resist upper layer film materials (PR1 to 25) according to the present invention have excellent in-plane uniformity, and thus the polymers of the present invention function as surfactants that impart excellent leveling performance, and can be used in various compositions for forming organic films regardless of the type of resin to be combined.

### [EUV lithography evaluation: Examples 5-1 to 5-25]

Each resist upper layer film material (PR1 to 25) shown in Table 16 was spin-coated onto a Si substrate on which a silicon-containing spin-on hard mask SHB-A940 (silicon content 43% by mass) manufactured by Shin-Etsu Chemical Co., Ltd. was formed to a thickness of 20 nm, and the substrate was pre-baked at 110°C for 30 seconds using a hot plate to fabricate a resist film with a thickness of 45 nm. The resist film was exposed using an EUV scanner NXE3400 manufactured by ASML (NA0.33, σ0.9/0.7, dipole illumination), and then subjected to PEB on a hot plate at 80°C for 60 seconds. Development was performed with a 2.38% by mass TMAH aqueous solution for 30 seconds to form a line-and-space pattern with a pitch of 40 nm and a line width of 20 nm. The pattern was observed using a CD-SEM (CG6300) manufactured by Hitachi High-Tech Corporation, and a case of formation of a line pattern with dimensions of 20 nm ± 2.0 nm was rated as favorable.

**[Table 18]**

| | Resist upper layer film material | Pattern formation |
|---|---|---|
| Example 5-1 | PR1 | Favorable |
| Example 5-2 | PR2 | Favorable |
| Example 5-3 | PR3 | Favorable |
| Example 5-4 | PR4 | Favorable |
| Example 5-5 | PR5 | Favorable |
| Example 5-6 | PR6 | Favorable |
| Example 5-7 | PR7 | Favorable |
| Example 5-8 | PR8 | Favorable |
| Example 5-9 | PR9 | Favorable |
| Example 5-10 | PR10 | Favorable |
| Example 5-11 | PR11 | Favorable |
| Example 5-12 | PR12 | Favorable |
| Example 5-13 | PR13 | Favorable |
| Example 5-14 | PR14 | Favorable |
| Example 5-15 | PR15 | Favorable |
| Example 5-16 | PR16 | Favorable |
| Example 5-17 | PR17 | Favorable |
| Example 5-18 | PR18 | Favorable |
| Example 5-19 | PR19 | Favorable |
| Example 5-20 | PR20 | Favorable |
| Example 5-21 | PR21 | Favorable |
| Example 5-22 | PR22 | Favorable |
| Example 5-23 | PR23 | Favorable |
| Example 5-24 | PR24 | Favorable |
| Example 5-25 | PR25 | Favorable |

As shown in Table 18, in Examples 5-1 to 5-25, which used the composition for forming an organic film according to the present invention (PR1 to 25), a resist upper layer film pattern of 20 nm was formed, and it was confirmed that the resist upper layer film material, which is the composition for forming an organic film according to the present invention, is suitable for use in microfabrication.

### [Preparation of silicon-containing resist intermediate film material (SOG2 to 26)]

As the silicon-containing resist intermediate film material, the polymer (SP1), a crosslinking catalyst, and an acid were dissolved in an organic solvent and water in the ratio shown in Table 19, and the silicon-containing resist underlayer film material (SOG2 to 26) was prepared by filtering through a 0.1 µm fluororesin filter, respectively.

**[Table 19]**

| Silicon-containing resist intermediate film forming material | Polymer (parts by mass) | Crosslinking catalyst (parts by mass) | Acid (parts by mass) | Compound (parts by mass) | Organic solvent (parts by mass) | Water (parts by mass) |
|---|---|---|---|---|---|---|
| SOG2 | SP1 (100) | TMPANO3 (1.0) | Maleic acid (1.0) | (A1) | PGEE (44100) | Water (4900) |
| | | | | (1.0) | | |
| SOG3 | SP1 (100) | TMPANO3 (1.0) | Maleic acid (1.0) | (A2) | PGEE (44100) | Water (4900) |
| | | | | (1.0) | | |
| SOG4 | SP1 (100) | TMPANO3 (1.0) | Maleic acid (1.0) | (A3) | PGEE (44100) | Water (4900) |
| | | | | (1.0) | | |
| SOG5 | SP1 (100) | TMPANO3 (1.0) | Maleic acid (1.0) | (A4) | PGEE (44100) | Water (4900) |
| | | | | (1.0) | | |
| SOG6 | SP1 (100) | TMPANO3 (1.0) | Maleic acid (1.0) | (A5) | PGEE (44100) | Water (4900) |
| | | | | (1.0) | | |
| SOG7 | SP1 (100) | TMPANO3 (1.0) | Maleic acid (1.0) | (A6) | PGEE (44100) | Water (4900) |
| | | | | (1.0) | | |
| SOG8 | SP1 (100) | TMPANO3 (1.0) | Maleic acid (1.0) | (A7) | PGEE (44100) | Water (4900) |
| | | | | (1.0) | | |
| SOG9 | SP1 (100) | TMPANO3 (1.0) | Maleic acid (1.0) | (A8) | PGEE (44100) | Water (4900) |
| | | | | (1.0) | | |
| SOG10 | SP1 (100) | TMPANO3 (1.0) | Maleic acid (1.0) | (A9) | PGEE (44100) | Water (4900) |
| | | | | (1.0) | | |
| SOG11 | SP1 (100) | TMPANO3 (1.0) | Maleic acid (1.0) | (A10) | PGEE (44100) | Water (4900) |
| | | | | (1.0) | | |
| SOG12 | SP1 (100) | TMPANO3 (1.0) | Maleic acid (1.0) | (A11) | PGEE (44100) | Water (4900) |
| | | | | (1.0) | | |
| SOG13 | SP1 (100) | TMPANO3 (1.0) | Maleic acid (1.0) | (A12) | PGEE (44100) | Water (4900) |
| | | | | (1.0) | | |
| SOG14 | SP1 (100) | TMPANO3 (1.0) | Maleic acid (1.0) | (A13) | PGEE (44100) | Water (4900) |
| | | | | (1.0) | | |
| SOG15 | SP1 (100) | TMPANO3 (1.0) | Maleic acid (1.0) | (A14) | PGEE (44100) | Water (4900) |
| | | | | (1.0) | | |
| SOG16 | SP1 (100) | TMPANO3 (1.0) | Maleic acid (1.0) | (A15) | PGEE (44100) | Water (4900) |
| | | | | (1.0) | | |
| SOG17 | SP1 (100) | TMPANO3 (1.0) | Maleic acid (1.0) | (A16) | PGEE (44100) | Water (4900) |
| | | | | (1.0) | | |
| SOG18 | SP1 (100) | TMPANO3 (1.0) | Maleic acid (1.0) | (A17) | PGEE (44100) | Water (4900) |
| | | | | (1.0) | | |
| SOG19 | SP1 (100) | TMPANO3 (1.0) | Maleic acid (1.0) | (A18) | PGEE (44100) | Water (4900) |
| | | | | (1.0) | | |
| SOG20 | SP1 (100) | TMPANO3 (1.0) | Maleic acid (1.0) | (A19) | PGEE (44100) | Water (4900) |
| | | | | (1.0) | | |
| SOG21 | SP1 (100) | TMPANO3 (1.0) | Maleic acid (1.0) | (A20) | PGEE (44100) | Water (4900) |
| | | | | (1.0) | | |
| SOG22 | SP1 (100) | TMPANO3 (1.0) | Maleic acid (1.0) | (A21) | PGEE (44100) | Water (4900) |
| | | | | (1.0) | | |
| SOG23 | SP1 (100) | TMPANO3 (1.0) | Maleic acid (1.0) | (A22) | PGEE (44100) | Water (4900) |
| | | | | (1.0) | | |
| SOG24 | SP1 (100) | TMPANO3 (1.0) | Maleic acid (1.0) | (A23) | PGEE (44100) | Water (4900) |
| | | | | (1.0) | | |
| SOG25 | SP1 (100) | TMPANO3 (1.0) | Maleic acid (1.0) | (A24) | PGEE (44100) | Water (4900) |
| | | | | (1.0) | | |
| SOG26 | SP1 (100) | TMPANO3 (1.0) | Maleic acid (1.0) | (A25) | PGEE (44100) | Water (4900) |
| | | | | (1.0) | | |
| Comparative SOG1 | SP1 (100) | TMPANO3 (1.0) | Maleic acid (1.0) | - | PGEE (44100) | Water (4900) |

| | | | | | | |
|---|---|---|---|---|---|---|
| PGEE: Propylene glycol monoethyl ether | | | | | | |

### [Silicon-containing resist intermediate film coating evaluation: Examples 6-1 to 6-25 and Comparative Example 6-1]

A resist underlayer film was formed on a silicon wafer substrate using a composition for forming an organic film (Comparative UDL-1) by the above method, and the following silicon-containing resist intermediate film materials (SOG2 to 26 and Comparative SOG1) were coated thereon and baked at 200°C for 60 seconds to form a silicon-containing resist intermediate film. Then, the state of the coating of the silicon-containing resist intermediate film was visually observed and evaluated. A case of a coating state being favorable was rated as favorable, and a case of pinholes was rated as poor. In this evaluation, in order to evaluate the superiority or inferiority of the coating properties of the silicon-containing resist intermediate film, the thickness of the silicon-containing resist intermediate film was set to 5 nm, which was a special and strict evaluation condition.

**[Table 20]**

| | Silicon-containing resist intermediate film forming material | Coating property evaluation of silicon-containing resist intermediate film |
|---|---|---|
| Example 6-1 | SOG2 | Favorable |
| Example 6-2 | SOG3 | Favorable |
| Example 6-3 | SOG4 | Favorable |
| Example 6-4 | SOG5 | Favorable |
| Example 6-5 | SOG6 | Favorable |
| Example 6-6 | SOG7 | Favorable |
| Example 6-7 | SOG8 | Favorable |
| Example 6-8 | SOG9 | Favorable |
| Example 6-9 | SOG10 | Favorable |
| Example 6-10 | SOG11 | Favorable |
| Example 6-11 | SOG12 | Favorable |
| Example 6-12 | SOG13 | Favorable |
| Example 6-13 | SOG14 | Favorable |
| Example 6-14 | SOG15 | Favorable |
| Example 6-15 | SOG16 | Favorable |
| Example 6-16 | SOG17 | Favorable |
| Example 6-17 | SOG18 | Favorable |
| Example 6-18 | SOG19 | Favorable |
| Example 6-19 | SOG20 | Favorable |
| Example 6-20 | SOG21 | Favorable |
| Example 6-21 | SOG22 | Favorable |
| Example 6-22 | SOG23 | Favorable |
| Example 6-23 | SOG24 | Favorable |
| Example 6-24 | SOG25 | Favorable |
| Example 6-25 | SOG26 | Favorable |
| Comparative Example 6-1 | SOG1 | Poor |

As shown in Table 20, silicon-containing resist intermediate film materials (SOG2 to 26) have excellent film-forming properties without pinholes. This shows that the polymer of the present invention can be used as a surfactant that exerts high film-forming properties not only in organic films but also in various compositions for forming films.

As described above, the composition for forming an organic film according to the present invention has excellent film-forming properties, high-level embedding properties, and hump suppression properties, making it extremely useful as an organic film material used in multi-layer resist processes. In addition, the pattern forming method of the present invention using this composition can embed holes and trenches with significantly high aspect ratios without voids, form fine patterns with high precision, and form organic films with suppressed humps, making it possible to efficiently manufacture semiconductor elements and the like. In addition, the polymer of the present invention can be widely used as a surfactant, as the polymer exhibits high film-forming properties.

The present description includes the following embodiments.
[1] A composition for forming an organic film, comprising:
   (A) a resin or compound for forming an organic film;
   (B) a polymer having a repeating unit of a partial structure (a1) represented by the following general formula (1); and
   (C) a solvent, 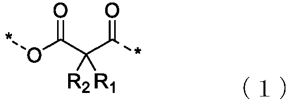
      wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 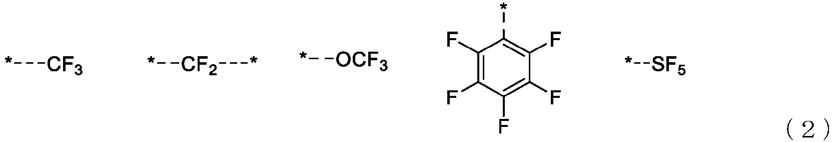
      wherein * represents an attachment point.
[2] The composition for forming an organic film according to [1], wherein the repeating unit (a1) of the polymer (B) is a repeating unit represented by the following general formula (3) or (4): 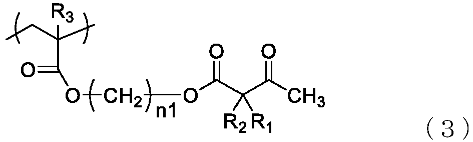
   wherein R₁ and R₂ are as defined above, R₃ represents a hydrogen atom or a methyl group, and n1 represents an integer of 2 to 10, 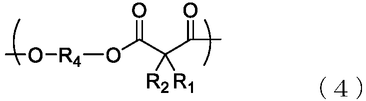
   wherein R₁ and R₂ are as defined above, and R₄ represents a divalent organic group having 2 to 30 carbon atoms and may include an ether bond, an ester bond, an amide bond, or a sulfide bond.
[3] The composition for forming an organic film according to [2], wherein the polymer (B) is a copolymer having repeating units of the general formula (3) and the following general formula (5): 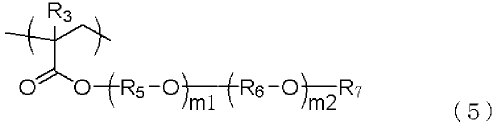 wherein R₃ is as defined as above, R₅ and R₆ are each a linear or branched divalent alkylene group having 1 to 4 carbon atoms, R₇ is a hydrogen atom, or an alkyl group having 1 to 4 carbon atoms, or a phenyl group, m1 is 0 to 23, m2 is 0 to 23, and 23 ≥ m1 + m2 ≥ 2.
[4] The composition for forming an organic film according to any one of [1] to [3], wherein the organic group having fluorine represented by R₁ or R₂ in the polymer (B) has at least one of structures represented by the following general formula (6): 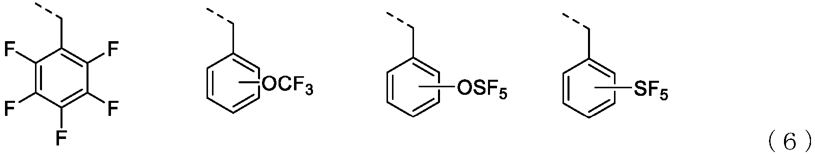
[5] The composition for forming an organic film according to any one of [1] to [4], wherein a weight average molecular weight of the polymer (B) is 1500 to 30000.
[6] The composition for forming an organic film according to any one of [1] to [5], wherein a content of the polymer (B) is 0.01 parts by mass to 5 parts by mass with respect to 100 parts by mass of the resin or compound for forming an organic film (A).
[7] A method for forming an organic film used in a process for manufacturing a semiconductor device, comprising:
   spin-coating a body to be processed with the composition for forming an organic film according to any one of [1] to [6], and
   heat-treating the substrate coated with the composition for forming an organic film at a temperature of 100°C or more and 600°C or less for 10 to 600 seconds, thereby forming a cured film.
[8] A pattern forming method comprising:
   Forming an organic film on a body to be processed using the composition for forming an organic film according to any one of [1] to [6];
   forming a silicon-containing resist intermediate film on the organic film using a silicon-containing resist material containing silicon atoms;
   forming a resist upper layer film on the silicon-containing resist intermediate film using a resist upper layer film material comprising a photoresist composition;
   forming a circuit pattern on the resist upper layer film;
   transferring a pattern by etching to the silicon-containing resist intermediate film using the resist upper layer film on which the circuit pattern is formed as a mask;
   transferring a pattern by etching to the organic film using the silicon-containing resist intermediate film on which the pattern is transferred as a mask; and
   further transferring a pattern by etching to the body to be processed using the organic film on which the pattern is transferred as a mask.
[9] A pattern forming method comprising:
   forming an organic film on a body to be processed using the composition for forming an organic film according to any one of [1] to [6];
   forming a silicon-containing resist intermediate film on the organic film using a silicon-containing resist material containing silicon atoms;
   forming an organic antireflective film or an adhesive film on the silicon-containing resist intermediate film;
   forming a resist upper layer film on the organic antireflective film or the adhesive film using a resist upper layer film material comprising a photoresist composition;
   forming a circuit pattern on the resist upper layer film;
   transferring a pattern by etching to the organic antireflective film or the adhesive film and the silicon-containing resist intermediate film using the resist upper layer film on which the circuit pattern is formed as a mask;
   transferring a pattern by etching to the organic film using the silicon-containing resist intermediate film to which the pattern is transferred as a mask; and
   further transferring a pattern by etching to the body to be processed using the organic film to which the pattern is transferred as a mask.
[10] A pattern forming method comprising:
   forming an organic film on a body to be processed using a composition for forming an organic film according to any one of [1] to [6];
   forming an inorganic hard mask intermediate film selected from a silicon oxide film, a silicon nitride film, and a silicon oxide nitride film on the organic film;
   forming a resist upper layer film on the inorganic hard mask intermediate film using a resist upper layer film material comprising a photoresist composition;
   forming a circuit pattern on the resist upper layer film;
   transferring a pattern by etching to the inorganic hard mask intermediate film using the resist upper layer film on which the circuit pattern is formed as a mask;
   transferring a pattern by etching to the organic film using the inorganic hard mask intermediate film on which the pattern is transferred as a mask; and
   further transferring a pattern by etching to the body to be processed using the organic film on which the pattern is transferred as a mask.
[11] A pattern forming method comprising:
   forming an organic film on a body to be processed using the composition for forming an organic film according to any one of [1] to [6];
   forming an inorganic hard mask intermediate film selected from a silicon oxide film, a silicon nitride film, and a silicon oxide nitride film on the organic film;
   forming an organic antireflective film or an adhesive film on the inorganic hard mask intermediate film;
   forming a resist upper layer film on the organic antireflective film or the adhesive film using a resist upper layer film material comprising a photoresist composition;
   forming a circuit pattern on the resist upper layer film;
   transferring a pattern by etching to the organic antireflective film or the adhesive film and the inorganic hard mask intermediate film using the resist upper layer film on which the circuit pattern is formed as a mask;
   transferring a pattern by etching to the organic film using the inorganic hard mask intermediate film on which the pattern is transferred as a mask; and
   further transferring a pattern by etching to the body to be processed using the organic film on which the pattern is transferred as a mask.
[12] The pattern forming method according to [10] or [11], wherein the inorganic hard mask intermediate film is formed by a CVD method or an ALD method.
[13] The pattern forming method according to any one of [8] to [12], wherein in the formation of the circuit pattern, the circuit pattern is formed by lithography using light having a wavelength of 10 nm or more and 300 nm or less, direct writing with an electron beam, nanoimprinting, or a combination thereof.
[14] The pattern forming method according to any one of [8] to [13], wherein in the formation of the circuit pattern, the circuit pattern is developed with an alkali developer or an organic solvent.
[15] The pattern forming method according to any one of [8] to [14], wherein as the body to be processed, a semiconductor device substrate, or the semiconductor device substrate having any one of a metal film, a metal carbide film, a metal oxide film, a metal nitride film, a metal oxide carbide film, and a metal oxide nitride film formed thereon is used.
[16] The pattern forming method according to [15], wherein as the metal constituting the body to be processed, silicon, titanium, tungsten, hafnium, zirconium, chromium, germanium, copper, silver, gold, aluminum, indium, gallium, arsenic, palladium, iron, tantalum, iridium, molybdenum, or an alloy thereof is used.
[17] A polymer having a repeating unit of a partial structure (a1) represented by the following general formula (1): 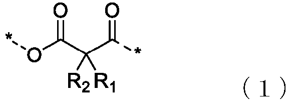
   wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 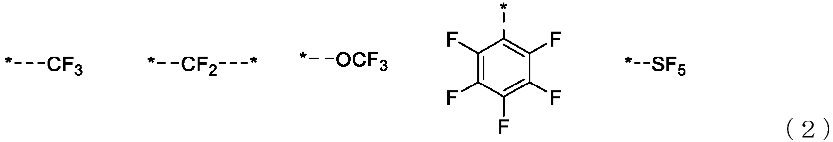
   wherein * represents an attachment point.
[18] The polymer according to [17], wherein the repeating unit (a1) of the polymer is a repeating unit represented by the following general formula (3) or (4): 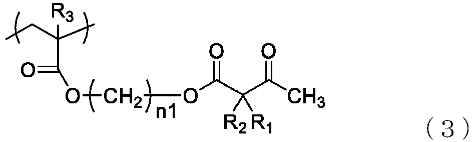
   wherein R₁ and R₂ are as defined above, R₃ represents a hydrogen atom or a methyl group, and n1 represents an integer of 2 to 10, 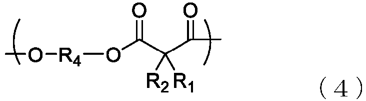
   wherein R₁ and R₂ are as defined above, and R₄ represents a divalent organic group having 2 to 30 carbon atoms and may include an ether bond, an ester bond, an amide bond, or a sulfide bond.
[19] The polymer according to [18], wherein the polymer is a copolymer having repeating units of the general formula (3) and the following general formula (5): 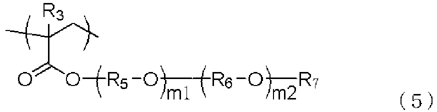 wherein R₃ is as defined above, R₅ and R₆ are each a linear or branched divalent alkylene group having 1 to 4 carbon atoms, R₇ is a hydrogen atom, an alkyl group having 1 to 4 carbon atoms, or a phenyl group, ml is 0 to 23, m2 is 0 to 23, and 23 ≥ ml + m2 ≥ 2.
[20] The polymer according to any one of according to any one of [17] to [19], wherein the structure having fluorine represented by R₁ or R₂ in the polymer has at least one of structures represented by the following general formula (6):

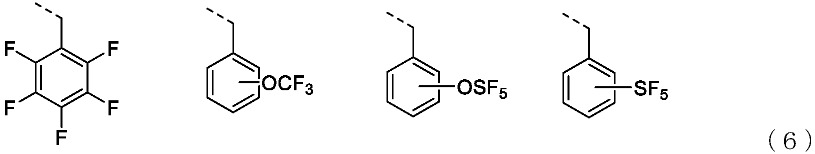

The present invention is not limited to the above-described embodiment. The above-described embodiment is merely an example, and anything that has substantially the same configuration as the technical idea described in the claims of the present invention and exhibits similar effects is included within the technical scope of the present invention.

## Claims

1. A composition for forming an organic film, comprising:
(A) a resin or compound for forming an organic film;
(B) a polymer having a repeating unit of a partial structure (a1) represented by the following general formula (1); and
(C) a solvent, 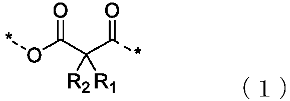
wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 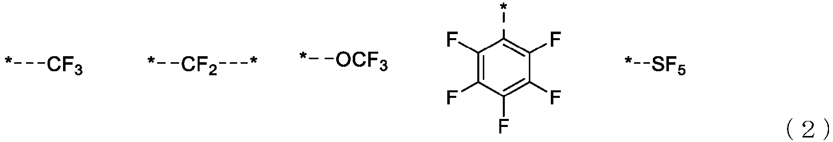
wherein * represents an attachment point.

2. The composition for forming an organic film according to claim 1, wherein the repeating unit (a1) of the polymer (B) is a repeating unit represented by the following general formula (3) or (4): 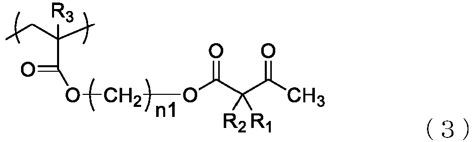
wherein R₁ and R₂ are as defined above, R₃ represents a hydrogen atom or a methyl group, and n1 represents an integer of 2 to 10, 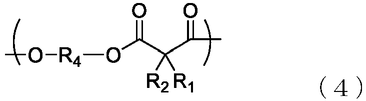
wherein R₁ and R₂ are as defined above, and R₄ represents a divalent organic group having 2 to 30 carbon atoms and may include an ether bond, an ester bond, an amide bond, or a sulfide bond.

3. The composition for forming an organic film according to claim 2, wherein the polymer (B) is a copolymer having repeating units of the general formula (3) and the following general formula (5): 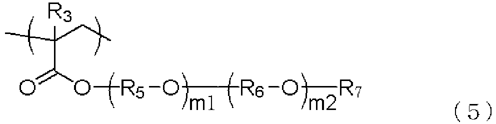 wherein R₃ is as defined as above, R₅ and R₆ are each a linear or branched divalent alkylene group having 1 to 4 carbon atoms, R₇ is a hydrogen atom, or an alkyl group having 1 to 4 carbon atoms, or a phenyl group, m1 is 0 to 23, m2 is 0 to 23, and 23 ≥ m1 + m2 ≥ 2.

4. The composition for forming an organic film according to any one of claims 1 to 3, wherein the organic group having fluorine represented by R₁ or R₂ in the polymer (B) has at least one of structures represented by the following general formula (6):

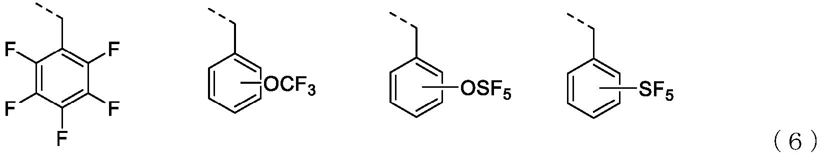

5. The composition for forming an organic film according to any one of claims 1 to 4, wherein a weight average molecular weight of the polymer (B) is 1500 to 30000, or
wherein a content of the polymer (B) is 0.01 parts by mass to 5 parts by mass with respect to 100 parts by mass of the resin or compound for forming an organic film (A).

6. A method for forming an organic film used in a process for manufacturing a semiconductor device, comprising:
spin-coating a body to be processed with the composition for forming an organic film according to any one of claims 1 to 5, and
heat-treating the substrate coated with the composition for forming an organic film at a temperature of 100°C or more and 600°C or less for 10 to 600 seconds, thereby forming a cured film.

7. A pattern forming method comprising:
forming an organic film on a body to be processed using the composition for forming an organic film according to any one of claims 1 to 5;
forming a silicon-containing resist intermediate film on the organic film using a silicon-containing resist material containing silicon atoms;
forming a resist upper layer film on the silicon-containing resist intermediate film using a resist upper layer film material comprising a photoresist composition;
forming a circuit pattern on the resist upper layer film;
transferring a pattern by etching to the silicon-containing resist intermediate film using the resist upper layer film on which the circuit pattern is formed as a mask;
transferring a pattern by etching to the organic film using the silicon-containing resist intermediate film on which the pattern is transferred as a mask; and
further transferring a pattern by etching to the body to be processed using the organic film on which the pattern is transferred as a mask, or
a pattern forming method comprising:
forming an organic film on a body to be processed using the composition for forming an organic film according to any one of claims 1 to 6;
forming a silicon-containing resist intermediate film on the organic film using a silicon-containing resist material containing silicon atoms;
forming an organic antireflective film or an adhesive film on the silicon-containing resist intermediate film;
forming a resist upper layer film on the organic antireflective film or the adhesive film using a resist upper layer film material comprising a photoresist composition;
forming a circuit pattern on the resist upper layer film;
transferring a pattern by etching to the organic antireflective film or the adhesive film and the silicon-containing resist intermediate film using the resist upper layer film on which the circuit pattern is formed as a mask;
transferring a pattern by etching to the organic film using the silicon-containing resist intermediate film to which the pattern is transferred as a mask; and
further transferring a pattern by etching to the body to be processed using the organic film to which the pattern is transferred as a mask.

8. A pattern forming method comprising:
forming an organic film on a body to be processed using a composition for forming an organic film according to any one of claims 1 to 5;
forming an inorganic hard mask intermediate film selected from a silicon oxide film, a silicon nitride film, and a silicon oxide nitride film on the organic film;
forming a resist upper layer film on the inorganic hard mask intermediate film using a resist upper layer film material comprising a photoresist composition;
forming a circuit pattern on the resist upper layer film;
transferring a pattern by etching to the inorganic hard mask intermediate film using the resist upper layer film on which the circuit pattern is formed as a mask;
transferring a pattern by etching to the organic film using the inorganic hard mask intermediate film on which the pattern is transferred as a mask; and
further transferring a pattern by etching to the body to be processed using the organic film on which the pattern is transferred as a mask, or
a pattern forming method comprising:
forming an organic film on a body to be processed using the composition for forming an organic film according to any one of claims 1 to 6;
forming an inorganic hard mask intermediate film selected from a silicon oxide film, a silicon nitride film, and a silicon oxide nitride film on the organic film;
forming an organic antireflective film or an adhesive film on the inorganic hard mask intermediate film;
forming a resist upper layer film on the organic antireflective film or the adhesive film using a resist upper layer film material comprising a photoresist composition;
forming a circuit pattern on the resist upper layer film;
transferring a pattern by etching to the organic antireflective film or the adhesive film and the inorganic hard mask intermediate film using the resist upper layer film on which the circuit pattern is formed as a mask;
transferring a pattern by etching to the organic film using the inorganic hard mask intermediate film on which the pattern is transferred as a mask; and
further transferring a pattern by etching to the body to be processed using the organic film on which the pattern is transferred as a mask.

9. The pattern forming method according to claim 7, wherein the inorganic hard mask intermediate film is formed by a CVD method or an ALD method.

10. The pattern forming method according to any one of claims 7 to 9, wherein in the formation of the circuit pattern, the circuit pattern is formed by lithography using light having a wavelength of 10 nm or more and 300 nm or less, direct writing with an electron beam, nanoimprinting, or a combination thereof, or
wherein in the formation of the circuit pattern, the circuit pattern is developed with an alkali developer or an organic solvent.

11. The pattern forming method according to any one of claims 7 to 10, wherein as the body to be processed, a semiconductor device substrate, or the semiconductor device substrate having any one of a metal film, a metal carbide film, a metal oxide film, a metal nitride film, a metal oxide carbide film, and a metal oxide nitride film formed thereon is used, and
preferably wherein as the metal constituting the body to be processed, silicon, titanium, tungsten, hafnium, zirconium, chromium, germanium, copper, silver, gold, aluminum, indium, gallium, arsenic, palladium, iron, tantalum, iridium, molybdenum, or an alloy thereof is used.

12. A polymer having a repeating unit of a partial structure (a1) represented by the following general formula (1): 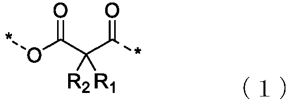
wherein R₁ and R₂ are hydrogen atoms or saturated or unsaturated organic groups having 1 to 20 carbon atoms, and have at least one structure having fluorine represented by the following general formula (2), at least one of R₁ and R₂ represents an organic group that is not a hydrogen atom, and * represents an attachment point, 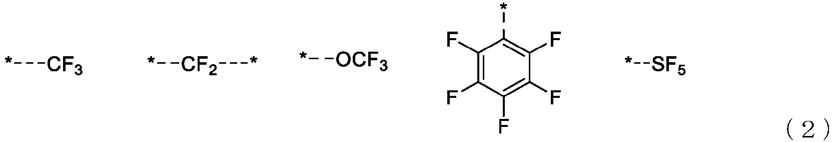
wherein * represents an attachment point.

13. The polymer according to claim 12, wherein the repeating unit (a1) of the polymer is a repeating unit represented by the following general formula (3) or (4): 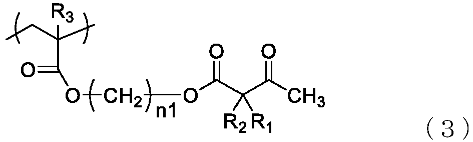
wherein R₁ and R₂ are as defined above, R₃ represents a hydrogen atom or a methyl group, and n1 represents an integer of 2 to 10, 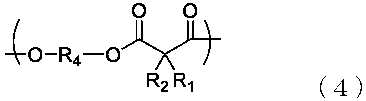
wherein R₁ and R₂ are as defined above, and R₄ represents a divalent organic group having 2 to 30 carbon atoms and may include an ether bond, an ester bond, an amide bond, or a sulfide bond.

14. The polymer according to claim 13, wherein the polymer is a copolymer having repeating units of the general formula (3) and the following general formula (5): 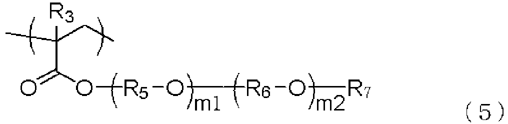 wherein R₃ is as defined above, R₅ and R₆ are each a linear or branched divalent alkylene group having 1 to 4 carbon atoms, R₇ is a hydrogen atom, an alkyl group having 1 to 4 carbon atoms, or a phenyl group, ml is 0 to 23, m2 is 0 to 23, and 23 ≥ ml + m2 ≥ 2.

15. The polymer according to any one of claims 12 to 14, wherein the structure having fluorine represented by R₁ or R₂ in the polymer has at least one of structures represented by the following general formula (6):
